# EUROPEAN PATENT APPLICATION

(11) **EP 1 981 085 A1**
(43) Date of publication of application: **15.10.2008**
(21) Application number: 07706832.8
(22) Date of filing: 16.01.2007
(51) Int. Cl.: H01L 29/786, G02F 1/1368, G09F 9/30, H01L 21/336

(54) **TFT SUBSTRATE, REFLECTIVE TFT SUBSTRATE AND METHOD FOR MANUFACTURING SUCH SUBSTRATES**

(30) Priority: 31.01.2006 JP 2006022332; 21.02.2006 JP 2006043521; 27.12.2006 JP 2006352764; 27.12.2006 JP 2006352765
(71) Applicant: Idemitsu Kosan Co., Ltd., Chiyoda-ku Tokyo 100-8321 (JP)
(72) Inventor: INOUE, Kazuyoshi, Sodegaura-shi Chiba 299-0293 (JP); YANO, Koki, Sodegaura-shi Chiba 299-0293 (JP); TANAKA, Nobuo, Sodegaura-shi Chiba 299-0293 (JP)
(74) Representative: Gille Hrabal Struck Neidlein Prop Roos
(86) International application number: PCT/JP2007/050505
(87) International publication number: WO 2007/088722

(57) **Abstract**

An object of the invention is to propose a TFT substrate and a reflective TFT substrate which can be operated stably for a prolonged period of time, can be prevented from being suffering from crosstalk, and is capable of significantly reducing manufacturing cost by decreasing the number of production steps, as well as to propose the method for producing these substrates.

A TFT substrate 1001 comprises: a glass substrate 1010; a gate electrode 1023 and a gate wire 1024 insulated by having their top surfaces covered with a gate insulating film 1030 and by having their side surfaces covered with an interlayer insulating film 1050; an n-type oxide semiconductor layer 1040 formed on the gate insulating film 1030 above the gate electrode 1023; an oxide transparent conductor layer 1060 formed on the n-type oxide semiconductor layer 1040 with a channel part 1044 interposed therebetween; and a channel guard 1500 for protecting the channel part 1044.

## Description

### TECHNICAL FIELD

The invention relates to a TFT substrate, a reflective TFT substrate and methods for producing the TFT substrate and the reflective TFT substrate. More particularly, the TFT substrate and the reflective TFT substrate of the invention comprises a gate electrode and a gate wire insulated by a gate insulating film and an interlayer insulating film; an n-type oxide semiconductor layer which serves as an active layer for the TFT (Thin Film Transistor) and is formed on the gate electrode; a channel guard which is formed on a channel part and is composed of the interlayer insulating film; and a drain electrode and a source electrode which are formed in a pair of openings in the interlayer insulating film. Due to such a configuration, the TFT substrate and the reflective TFT substrate of the invention can be operated stably for a prolonged period of time. In addition, according to the invention, not only manufacturing cost can be decreased due to the reduction of production steps but also concern for occurrence of interference of gate wires (crosstalk) can be eliminated.

### BACKGROUND

LCD (Liquid Crystal Display) apparatuses or organic EL display apparatuses are widely used due to their display performance, energy saving properties, and other such reasons. These display apparatuses constitute nearly all of the mainstreams of display apparatuses, in particular, display apparatuses in cellular phones, PDAs (personal digital assistants), PCs, laptop PCs, and TVs. Generally, TFT substrates are used in these display apparatuses.

For instance, in liquid crystal display apparatuses, display materials such as a liquid crystal are filled between a TFT substrate and an opposing substrate. In these display materials, a voltage is selectively applied to each pixel. Here, a "TFT substrate" means a substrate on which a TFT (Thin Film Transistor) having a semiconductor thin film (also called "semiconductor film") is arranged. Generally, a TFT substrate is referred to as a "TFT array substrate" since TFTs are arranged in an array.

On a TFT substrate which is used in a liquid crystal display apparatus and so on, "sets" (a set includes a TFT and one pixel of the screen of a liquid crystal display apparatus, called "one unit") are arranged vertically and laterally on a glass substrate. In a TFT substrate, for example, gate wires are arranged at an equal interval in the vertical direction on a glass substrate, and either source wires or drain wires are arranged at an equal interval in the lateral direction. The other of the source wire and the drain wire, a gate electrode, a source electrode and a drain electrode are provided respectively in the above-mentioned unit constituting each pixel.

### <Conventional method for producing TFT substrate>

As the method for producing a TFT substrate, a 5-mask process using five masks, a 4-mask process using four masks by half-tone exposure technology, and other processes are known.
In such a method for producing a TFT substrate, the production process needs many steps since five or four masks are used. For example, the 4-mask process requires 35 steps and the 5-mask process requires steps exceeding 40. So many production steps may decrease production yield. In addition, many steps may make the production process complicated and also increase the manufacturing cost.

### (Method for production using five masks)

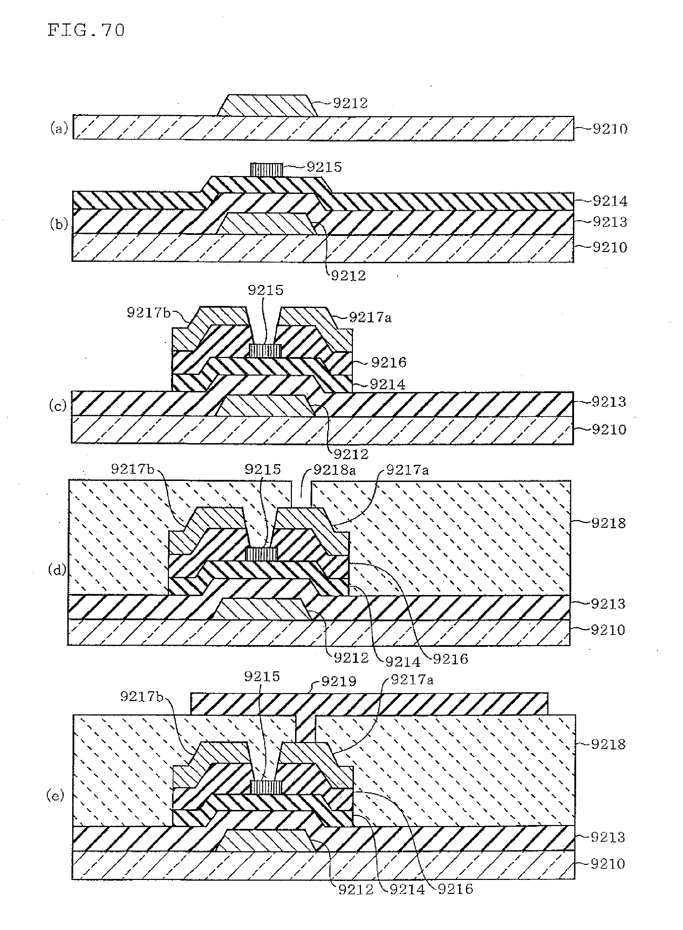

FIG. 70 is schematic views for explaining the conventional method for producing a TFT substrate. (a) is a cross-sectional view after the formation of a gate electrode. (b) is a cross-sectional view after the formation of an etch stopper. (c) is a cross-sectional view after the formation of a source electrode and a drain electrode. (d) is a cross-sectional view after the formation of an interlayer insulating film. (e) is a cross-sectional view after the formation of a pixel electrode.
In FIG. 70(a), a gate electrode 9212 is formed on a glass substrate 9210 by using a first mask (not shown).
That is, first, a metal (such as aluminum (Al)) is deposited on a glass substrate 9210 by sputtering. Then, a resist is formed by photolithography by using the first mask. Subsequently, the gate electrode 9212 is formed into a predetermined shape by etching, and the resist is removed through an ashing process.

Next, as shown in FIG. 70(b), on the glass substrate 9210 and the gate electrode 9212, a gate insulating film 9213 formed of an SiN film (silicon nitride film) and an α-Si:H(i) film 9214 are stacked in this order. Subsequently, an SiN film (silicon nitride film) as a channel protective layer is deposited. Then, a resist is formed by photolithography using a second mask (not shown). Then, the SiN film is patterned into a predetermined shape with a dry etching method using a CHF gas, an etch stopper 9215 is formed, and the resist is removed through an ashing process.

Next, as shown in FIG. 70(c), an α-Si:H(n) film 9216 is deposited on the α-Si:H (i) film 9214 and the etch stopper 9215. Then, a Cr (chromium)/Al double-layer film is deposited thereon by vacuum deposition or sputtering. Subsequently, a resist is formed by photolithography using a third mask (not shown). Then, the Cr/Al double-layer film is patterned with an etching method, whereby a source electrode 9217a and a drain electrode 9217b are formed into a predetermined shape. In this case, Al is patterned with a photo-etching method using H₃PO₄-CH₃COOH-HNO₃ and Cr is patterned with a photo-etching method using an aqueous solution of diammonium cerium nitrate. Subsequently, the α-Si:H films (9216 and 9214) are patterned with a dry etching method using a CHF gas and a wet etching method using an aqueous hydrazine solution (NH₂NH₂·H₂O), whereby the α-Si:H (n)film 9216 and the α-Si:H(i) film 9214 are formed in predetermined shapes, and the resist is removed through an ashing process.

Next, as shown in FIG. 70(d), before forming a transparent electrode 9219, an interlayer insulating film 9218 is deposited on the gate insulating electrode 9213, the etch stopper 9215, the source electrode 9217a and the drain electrode 9217b. Subsequently, a resist is formed by photolithography using a fourth mask (not shown). Then, the interlayer insulating film 9218 is patterned with an etching method, a through hole 9218a for electrically connecting the transparent electrode 9219 with the source electrode 9217a is formed, and the resist is removed through an ashing process.

Next, as shown in FIG. 70(e), on the interlayer insulating film 9218 in a region where patterns of the source electrode 9217a and the drain electrode 9217b are formed, an amorphous transparent conductive film formed mainly of indium oxide and zinc oxide is deposited by sputtering. Subsequently, a resist is formed by photolithography by using a fifth mask (not shown). Then, the amorphous transparent conductive film is patterned by a photo-etching method using an approximately 4 wt% aqueous solution of oxalic acid as an etchant. Then, the amorphous transparent conductive film is formed in such a shape that the film electrically contacts the source electrode 9217a and the resist is removed through an ashing process. As a result, the transparent electrode 9219 is formed.
As mentioned above, five masks are required in the conventional method for producing a TFT substrate.

### (Method for production using three masks)

To improve the above-mentioned conventional technology, various technologies to produce a TFT substrate by a method in which production steps are further reduced by decreasing the number of masks (from five to three, for example) have been proposed. For example, the following patent documents 1 to 7 describe a method of producing a TFT substrate using three masks.
Patent Document 1: JP-A-2004-317685
Patent Document 2: JP-A-2004-319655
Patent Document 3: JP-A-2005-017669
Patent Document 4: JP-A-2005-019664
Patent Document 5: JP-A-2005-049667
Patent Document 6: JP-A-2005-106881
Patent Document 7: JP-A-2005-108912

### DISCLOSURE OF THE INVENTION

### Problem to be Solved by the Invention

However, the methods for producing a TFT substrate using three masks described in patent documents 1 to 7 require an anodic oxidation step or the like of a gate insulating film, and hence, they are very complicated processes. Therefore, there is a problem that the above methods for producing a TFT substrate are difficult to put into practical use.
Furthermore, in the actual production line of a TFT substrate (a reflective TFT substrate and the like are included in the TFT substrate), quality (for example, long-term stable operability or elimination of disadvantages such as interference of gate wires (crosstalk)) is important. That is, a practical technique capable of improving not only quality but also productivity has been desired.
In addition, improvement of quality and productivity has been demanded for a reflective TFT substrate, a semi-transmissive TFT substrate and a semi-reflective TFT substrate.

The invention has been made in view of the above-mentioned problem, and an object thereof is to provide a TFT substrate and a reflective TFT substrate capable of being operated stably for a prolonged period of time due to the presence of a channel guard, free from occurrence of crosstalk, and can be produced at a significantly reduced manufacturing cost due to reduced production steps in the production process, as well as methods for producing these substrates.

### Means for Solving the Problem

To achieve the above-mentioned object, the TFT substrate of the invention comprises:
a substrate;
a gate electrode and a gate wire formed above the substrate and insulated by having their top surfaces covered with a gate insulating film and by having their side surfaces covered with an interlayer insulating film;
an oxide layer formed above the gate electrode and above the gate insulating film;
a conductor layer formed above the oxide layer with a channel part interposed therebetween; and
a channel guard formed above the channel part for protecting the channel part.
Due to such a configuration, the TFT substrate can be operated stably for a prolonged period of time since the upper part of the oxide layer constituting the channel part is protected by a channel guard.

Preferably, the oxide layer is an n-type oxide semiconductor layer.
By using an oxide semiconductor layer as an active layer for a TFT, a TFT remains stable when electric current is flown. The TFT substrate is advantageously used for an organic EL apparatus which is operated under current control mode.

Further, it is preferred that the channel guard be composed of the interlayer insulating film, and that a drain electrode and a source electrode composed of the conductor layer be respectively formed in a pair of openings of the interlayer insulating film.
Due to such a configuration, since the channel guard, the channel part, the drain electrode and the source electrode can be produced readily without fail, not only production yield can be improved but also manufacturing cost can be reduced.

Further, it is preferred that the conductor layer be an oxide conductor layer and/or a metal layer.
Due to such a configuration, the TFT substrate can be operated stably for a prolonged period of time, and production yield can be improved.

Further, it is preferred that the conductor layer function at least as a pixel electrode.
Due to such a configuration, the number of masks used during the production can be decreased, leading to the reduction of production steps. As a result, production efficiency can be improved and manufacturing cost can be reduced.
Usually, the source wire, the drain wire, the source electrode, the drain electrode and the pixel electrode are formed from the conductor layer. By doing this, the source wire, the drain wire, the source electrode, the drain electrode and the pixel electrode can be produced efficiently.

Further, it is preferred that the oxide layer be formed at predetermined positions corresponding to the channel part, a source electrode and a drain electrode.
Due to such a configuration, since the oxide layer is normally formed only at the predetermined positions, concern for occurrence of interference of gate wires (crosstalk) can be eliminated.

Further, it is preferred that the upper of the substrate be covered with a protective insulating film and the protective insulating film have openings at positions corresponding to a pixel electrode, a source/drain wire pad and a gate wire pad.
Due to such a configuration, the TFT substrate is provided with the protective insulating film. As a result, it is possible to provide a TFT substrate capable of producing readily a display means or an emitting means utilizing a liquid crystal, an organic EL material or the like.
Here, the source/drain wire pad means a source wire pad or a drain wire pad.

Further, it is preferred that the TFT substrate comprise at least one of the gate electrode, the gate wire, a source wire, a drain wire, a source electrode, a drain electrode and a pixel electrode, and an auxiliary conductive layer be formed above at least one of the gate electrode, the gate wire, the source wire, the drain wire, the source electrode, the drain electrode and the pixel electrode.
Due to such a configuration, the electric resistance of each wire or each electrode can be decreased, whereby reliability can be improved and a decrease in energy efficiency can be suppressed.

Further, it is preferred that the TFT substrate comprise a metal layer and comprise a metal layer-protecting oxide conductor layer for protecting the metal layer.
Due to such a configuration, not only the metal layer can be prevented from corrosion but also the durability thereof can be improved. For example, if a metal layer is used as the gate wire, the metal surface can be prevented from being exposed when an opening for the gate wire pad is formed, whereby connection reliability can be improved. Further, if the metal layer is a reflective metal layer, discoloration or other problems of the reflective metal layer can be prevented, and disadvantages such as a decrease in reflectance of the reflective metal layer can be prevented.

Further, it is preferred that the TFT substrate comprise at least one of the gate electrode, the gate wire, a source wire, a drain wire, a source electrode, a drain electrode and a pixel electrode, and at least one of the gate electrode, the gate wire, the source wire, the drain wire, the source electrode, the drain electrode and the pixel electrode be composed of an oxide transparent conductor layer.
Due to such a configuration, since the amount of transmitted light is increased, a display apparatus improved in luminance can be provided.

Further, it is preferred that the energy gap of the oxide layer and/or the conductor layer be 3.0 eV or more.
By rendering the energy gap 3.0 eV or more, malfunction caused by light can be prevented. Although an energy gap of 3.0 eV or more is generally sufficient, the energy gap may preferably be 3.2 eV or more, more preferably 3.4 eV or more. By rendering the energy gap large as described above, prevention of malfunction caused by light can be ensured.

Further, it is preferred that the TFT substrate comprise a pixel electrode and part of the pixel electrode be covered with a reflective metal layer.
Due to such a configuration, the TFT substrate can be operated stably for a prolonged period of time and crosstalk can be prevented. It addition, a semi-transmissive TFT substrate or a semi-reflective TFT substrate capable of drastically reducing the manufacturing cost can be provided.

Further, it is preferred that the reflective metal layer function as at least one of the source wire, the drain wire, the source electrode and the drain electrode.
Due to such a configuration, a larger amount of light can be reflected, whereby luminance by the reflected light can be improved.

Further, it is preferred that the reflective metal layer be composed of a thin film of aluminum, silver or gold or an alloy layer containing aluminum, silver or gold.
Due to such a configuration, a larger amount of light can be reflected, whereby luminance by the reflected light can be improved.

The reflective TFT substrate of the invention comprises:
a substrate;
a gate electrode and a gate wire formed above the substrate and insulated by having their top surfaces covered with a gate insulating film and by having their side surfaces covered with an interlayer insulating film;
an oxide layer formed above the gate electrode and above the gate insulating film;
a reflective metal layer formed above the oxide layer with a channel part interposed therebetween; and
a channel guard formed above the channel part for protecting the channel part.
Due to such a configuration, since the oxide layer constituting the channel part is protected by the channel guard, the reflective TFT substrate can be operated stably for a prolong period of time.

Further, it is preferred that the oxide layer be an n-type oxide semiconductor layer.
By using the oxide semiconductor layer as an active layer for a TFT, a TFT remains stable when electric current is flown. This is advantageous for an organic EL apparatus which is operated under current control mode.

Further, it is preferred that the channel guard be composed of the interlayer insulating film and the drain electrode and the source electrode be respectively formed in a pair of openings of the interlayer insulating film.
Due to such a configuration, the channel part, the drain electrode and the source electrode can be produced readily without fail. As a result, not only production yield can be improved but also manufacturing cost can be reduced.

Further, it is preferred that the reflective metal layer function at least as the pixel electrode.
Due to such a configuration, the number of masks used in the production can be decreased, leading to the reduction of production steps. As a result, production efficiency can be improved and manufacturing cost can be reduced.
Usually, the source wire, the drain wire, the source electrode, the drain electrode and the pixel electrode are formed from the reflective metal layer. By doing this, the source wire, the drain wire, the source electrode, the drain electrode and the pixel electrode can be produced efficiently.

It is further preferred that the oxide layer be formed at predetermined positions corresponding to the channel part, a source electrode and a drain electrode.
Due to such a configuration, since the oxide layer is normally formed only at the predetermined positions, concern for occurrence of interference of gate wires (crosstalk) can be eliminated.

Further, it is preferred that the upper part of the substrate be covered with a protective insulating film and that the protective insulating film have openings at positions corresponding to a pixel electrode, a source/drain wire pad and a gate wire pad.
Due to such a configuration, the reflective TFT substrate is provided with the protective insulating film. As a result, it is possible to provide a reflective TFT substrate capable of producing readily a display means or an emitting means utilizing a liquid crystal, an organic EL material or the like.

Further, it is preferred that the reflective TFT substrate comprise a reflective metal layer and/or a metal thin film and comprise a metal layer-protecting oxide conductor layer for protecting the reflective metal layer and/or the metal thin film.
Due to such a configuration, not only the reflective metal layer and/or the metal thin film can be prevented from corrosion but also the durability thereof can be improved. For example, if the metal thin film is used as the gate wire, the metal surface can be prevented from being exposed when an opening for the gate wire pad is formed, whereby connection reliability can be improved. Further, as for the reflective metal layer, discoloration or other problems of the reflective metal layer can be prevented, and disadvantages such as a decrease in reflectance of the reflective metal layer can be prevented. Further, due to transparency, the amount of transmitted light is not decreased. As a result, a display apparatus improved in luminance can be provided.

Further, it is preferred that the energy gap of the oxide layer be 3.0 eV or more.
By rendering the energy gap 3.0 eV or more, malfunction caused by light can be prevented. Although an energy gap of 3.0 eV or more is generally sufficient, the energy gap may preferably be 3.2 eV or more, more preferably 3.4 eV or more. By rendering the energy gap large as described above, prevention of malfunction caused by light can be ensured.

Further, it is preferred that the reflective TFT substrate be formed of a thin film of aluminum, silver or gold or an alloy layer containing aluminum, silver or gold.
Due to such a configuration, a larger amount of light can be reflected, whereby luminance by the reflected light can be improved.

To achieve the above-mentioned object, the method for producing the TFT substrate of the invention comprises the steps of:
stacking a thin film for a gate electrode/gate wire from which a gate electrode and a gate wire are formed, a gate insulating film, a first oxide layer and a first resist above a substrate;
forming the first resist into a predetermined shape by half-tone exposure by using a first half-tone mask;
patterning the thin film for a gate electrode/gate wire, the gate insulating film and the first oxide layer with an etching method to form the gate electrode and the gate wire;
reforming the first resist into a predetermined shape;
patterning the first oxide layer with an etching method to form a channel part;
stacking an interlayer insulating film and a second resist;
forming the second resist into a predetermined shape by using a second mask;
patterning the interlayer insulating film with an etching method to form openings at positions where a source electrode and a drain electrode are formed and patterning the interlayer insulating film and the gate insulting film with an etching method to form an opening for a gate wire pad at a position where a gate wire pad is formed;
stacking a second oxide layer and a third resist;
forming the third resist into a predetermined shape by using a third mask; and
patterning the second oxide layer with an etching method to form the source electrode, the drain electrode, a source wire, a drain wire, a pixel electrode and the gate wire pad.
As is apparent from the above, the invention is advantageous also as a method for producing a TFT substrate, and a TFT substrate with via hole channels can be produced by using three masks. In addition, since the number of masks is decreased and production steps are reduced, production efficiency can be improved and manufacturing cost can be decreased. Moreover, on the upper part of the oxide layer constituting the channel part, a channel guard composed of an interlayer insulating film which has a pair of openings in which the drain electrode and the source electrode are respectively formed. Since the channel part is protected by this channel guard, a TFT substrate can be operated stably for a prolonged period of time. Furthermore, since the oxide layer is usually provided only at predetermined positions (predetermined positions corresponding to the channel part, the source electrode, the drain electrode), concern for occurrence of interference between the gate wires (crosstalk) can be eliminated.

Further, the method for producing the TFT substrate of the invention comprises the steps of:
stacking a thin film for a gate electrode/gate wire from which a gate electrode and a gate wire are formed, a gate insulating film, a first oxide layer and a first resist above a substrate;
forming the first resist into a predetermined shape by half-tone exposure by using a first half-tone mask;
patterning the thin film for a gate electrode/gate wire, the gate insulating film and the first oxide layer with an etching method to form the gate electrode and the gate wire;
reforming the first resist into a predetermined shape;
patterning the first oxide layer with an etching method to form a channel part;
stacking an interlayer insulating film and a second resist;
forming the second resist into a predetermined shape by using a second mask;
patterning the interlayer insulating film with an etching method to form openings at positions where a source electrode and a drain electrode are formed and patterning the interlayer insulating film and the gate insulting film with an etching method to form an opening for a gate wire pad at a position where a gate wire pad is formed;
stacking a second oxide layer, a protective insulating film and a third resist;
forming the third resist into a predetermined shape by half-tone exposure by using a third mask;
patterning the second oxide layer and the protective insulating film with an etching method to form the source electrode, the drain electrode, a source wire, a drain wire, a pixel electrode and the gate wire pad;
reforming the third resist into a predetermined shape; and
patterning the protective insulating film with an etching method to expose a source/drain wire pad, the pixel electrode and the gate wire pad.
By doing this, operation stability can be improved since the upper parts of the source electrode, the drain electrode, the source wire and the drain wire are covered with the protective insulating film.
Here, the source/drain wire pad means a source wire pad or a drain wire pad.

Further, the method for producing the TFT substrate of the invention comprises the steps of:
stacking a thin film for a gate electrode/gate wire from which a gate electrode and a gate wire are formed, a gate insulating film, a first oxide layer and a first resist above a substrate;
forming the first resist into a predetermined shape by half-tone exposure by using a first half-tone mask;
patterning the thin film for a gate electrode/gate wire, the gate insulating film and the first oxide layer with an etching method to form the gate electrode and the gate wire;
reforming the first resist into a predetermined shape;
patterning the first oxide layer with an etching method to form a channel part;
stacking an interlayer insulating film and a second resist;
forming the second resist into a predetermined shape by using a second mask;
patterning the interlayer insulating film with an etching method to form openings at positions where a source electrode and a drain electrode are formed and patterning the interlayer insulating film and the gate insulting film with an etching method to form an opening for a gate wire pad at a position where a gate wire pad is formed;
stacking a second oxide layer and a third resist;
forming the third resist into a predetermined shape by using a third mask;
patterning the second oxide layer with an etching method to form the source electrode, the drain electrode, a source wire, a drain wire, a pixel electrode and the gate wire pad;
stacking a protective insulating film and a fourth resist;
forming the fourth resist into a predetermined shape; and
patterning the protective insulating film with an etching method to expose a source/drain wire pad, the pixel electrode and the gate wire pad.
By doing this, the source electrode, the drain electrode, the source wire and the drain wire are covered with the protective insulating film so as not to be exposed. As a result, it is possible to provide a TFT substrate capable of producing readily a display means or an emitting means utilizing a liquid crystal, an organic EL material or the like.

Further, the method for producing the TFT substrate of the invention comprises the steps of:
stacking a thin film for a gate electrode/gate wire from which a gate electrode and a gate wire are formed, a gate insulating film, a first oxide layer and a first resist above a substrate;
forming the first resist into a predetermined shape by half-tone exposure by using a first half-tone mask;
patterning with an etching method the thin film for a gate electrode/gate wire, the gate insulating film and the first oxide layer to form the gate electrode and the gate wire;
reforming the first resist into a predetermined shape;
patterning the first oxide layer with an etching method to form a channel part;
stacking an interlayer insulating film and a second resist;
forming the second resist into a predetermined shape by using a second mask;
patterning the interlayer insulating film with an etching method to form openings at positions where a source electrode and a drain electrode are formed and patterning the interlayer insulating film and the gate insulting film with an etching method to form an opening for a gate wire pad at a position where a gate wire pad is formed;
stacking a second oxide layer, an auxiliary conductive layer, a protective insulating film and a third resist;
forming the third resist into a predetermined shape by half-tone exposure by using a third half-tone mask;
patterning the second oxide layer, the auxiliary conductive layer and the protective insulating film with an etching method to form the source electrode, the drain electrode, a source wire, a drain wire, a pixel electrode and the gate wire pad;
reforming the third resist into a predetermined shape; and
patterning the auxiliary conductive layer and the protective insulating film with an etching method to expose a source/drain wire pad, the pixel electrode and the gate wire pad.
By doing this, the electric resistance of each wire and electrode can be reduced. As a result, not only reliability can be improved but also a decrease in energy efficiency can be suppressed. In addition, operation stability can be improved since the upper part of each of the source electrode, the drain electrode, the source wire and the drain wire is covered with the protective insulating film.

Further, the method for producing the TFT substrate of the invention comprises the steps of:
stacking a thin film for a gate electrode/gate wire from which a gate electrode and gate wire are formed, a gate insulating film, a first oxide layer and a first resist above a substrate;
forming the first resist into a predetermined shape by half-tone exposure by using a first half-tone mask;
patterning the thin film for a gate electrode/gate wire, the gate insulating film and the first oxide layer with an etching method to form the gate electrode and the gate wire;
reforming the first resist into a predetermined shape;
patterning the first oxide layer with an etching method to form a channel part;
stacking an interlayer insulating film and a second resist;
forming the second resist into a predetermined shape by using a second mask;
patterning the interlayer insulating film with an etching method to form openings at positions where a source electrode and a drain electrode are formed and patterning the interlayer insulating film and the gate insulting film with an etching method to form an opening for a gate wire pad at a position where a gate wire pad is formed;
stacking a second oxide layer, an auxiliary conductive layer and a third resist;
forming the third resist into a predetermined shape by using a third mask;
patterning the second oxide layer and the auxiliary conductive layer with an etching method to form the source electrode, the drain electrode, a source wire, a drain wire, a pixel electrode and the gate wire pad;
stacking a protective insulating film and a fourth resist;
forming the fourth resist into a predetermined shape; and
patterning the protective insulating film with an etching method to expose a source/drain wire pad, the pixel electrode and the gate wire pad.
By doing this, the electric resistance of each wire or each electrode can be decreased. As a result, not only reliability can be improved but also a decrease in energy efficiency can be suppressed. In addition, the source electrode, the drain electrode, the source wire and the drain wire are covered with the protective insulating film so as not to be exposed and the TFT substrate is provided with the protective insulating film. As a result, it is possible to provide a TFT substrate capable of producing easily a display means or an emitting means utilizing a liquid crystal, an organic EL material or the like.

Further, the method for producing a TFT substrate of the invention comprises the steps of:
stacking a thin film for a gate electrode/gate wire from which a gate electrode and a gate wire are formed, a gate insulating film, a first oxide layer and a first resist above a substrate;
forming the first resist into a predetermined shape by half-tone exposure by using a first half-tone mask;
patterning the thin film for a gate electrode/gate wire, the gate insulating film and the first oxide layer with an etching method to form the gate electrode and the gate wire;
reforming the first resist into a predetermined shape;
patterning the first oxide layer with an etching method to form a channel part;
stacking an interlayer insulating film and a second resist;
forming the second resist into a predetermined shape by using a second mask;
patterning the interlayer insulting film with an etching method to form openings at positions where a source electrode and a drain electrode are formed and patterning the interlayer insulating film and the gate insulting film with an etching method to form an opening for a gate wire pad at a position where a gate wire pad is formed;
stacking a second oxide layer, a reflective metal layer and a third resist;
forming the third resist into a predetermined shape by half-tone exposure by using a third half-tone mask;
patterning the second oxide layer and the reflective metal layer with an etching method to form the source electrode, the drain electrode, a source wire, a drain wire, a pixel electrode and the gate wire pad;
reforming the third resist into a predetermined shape; and
patterning the reflective metal layer with an etching method to expose a source/drain wire pad, part of the pixel electrode and the gate wire pad and form a reflective metal part composed of the reflective metal layer.
By doing this, a semi-transmissive TFT substrate or a semi-reflective TFT substrate having via hole channels can be produced by using three masks. In addition, since the number of masks is decreased and production steps are reduced, production efficiency can be improved and manufacturing cost can be decreased. Further, the TFT substrate can be operated stably for a prolonged period of time and crosstalk can be prevented.

Further, the method for producing the TFT substrate of the invention comprises the steps of:
stacking a thin film for a gate electrode/gate wire from which a gate electrode and a gate wire are formed, a gate insulating film, a first oxide layer and a first resist above a substrate;
forming the first resist into a predetermined shape by half-tone exposure by using a first half-tone mask;
patterning the thin film for a gate electrode/gate wire, the gate insulating film and the first oxide layer with an etching method to form the gate electrode and the gate wire;
reforming the first resist into a predetermined shape;
patterning the first oxide layer with an etching method to form a channel part;
stacking an interlayer insulating film and a second resist;
forming the second resist into a predetermined shape by using a second mask;
patterning the interlayer insulating film with an etching method to form openings at positions where a source electrode and a drain electrode are formed and patterning the interlayer insulating film and the gate insulting film with an etching method to form an opening for a gate wire pad at a position where a gate wire pad is formed;
stacking a second oxide layer, a reflective metal layer, a protective insulating film and a third resist;
forming the third resist into a predetermined shape by half-tone exposure by using a third half-tone mask;
patterning the second oxide layer, the reflective metal layer and the protective insulating layer with an etching method to form the source electrode, the drain electrode, a source wire, a drain wire, a pixel electrode and the gate wire pad;
reforming the third resist into a predetermined shape; and
patterning the reflective metal layer and the protective insulating film with an etching method to expose a source/drain wire pad, part of the pixel electrode and the gate wire pad and form a reflective metal part composed of the reflective metal layer.
By doing this, in a semi-transmissive TFT substrate or a semi-reflective TFT substrate having via hole channels, the upper part of each of the drain electrode, the source electrode, the source wire, the reflective metal part and the drain wire is covered with the protective insulating film. As a result, operation stability can be improved.

Further, the method for producing a TFT substrate of the invention comprises the steps of:
stacking a thin film for a gate electrode/gate wire from which a gate electrode and a gate wire are formed, a gate insulating film, a first oxide layer and a first resist above a substrate;
forming the first resist into a predetermined shape by half-tone exposure by using a first half-tone mask;
patterning the thin film for a gate electrode/gate wire, the gate insulating film and the first oxide layer with an etching method to form the gate electrode and the gate wire;
reforming the first resist into a predetermined shape;
patterning the first oxide layer with an etching method to form a channel part;
stacking an interlayer insulating film and a second resist;
forming the second resist into a predetermined shape by using a second mask;
patterning the interlayer insulating film with an etching method to form openings at positions where a source electrode and a drain electrode are formed and patterning the interlayer insulating film and the gate insulting film with an etching method to form an opening for a gate wire pad at a position where a gate wire pad is formed;
stacking a second oxide layer, a reflective metal layer and a third resist;
forming the third resist into a predetermined shape by half-tone exposure by using a third half-tone mask;
patterning the second oxide layer and the reflective metal layer with an etching method to form the source electrode, the drain electrode, a source wire, a drain wire, a pixel electrode and the gate wire pad;
reforming the third resist into a predetermined shape;
patterning the reflective metal layer with an etching method to expose a source/drain wire pad, part of the pixel electrode and the gate wire pad and form a reflective metal part composed of the reflective metal layer;
stacking a protective insulating film and a fourth resist;
reforming the fourth resist into a predetermined shape; and
patterning the protective insulating film with an etching method to expose the source/drain wire pad, part of the pixel electrode and the gate wire pad.
By doing this, the source electrode, the drain electrode, the source wire and the drain wire are covered with the protective insulating film so as not to be exposed, and the TFT substrate is provided with the protective insulating film. As a result, it is possible to provide a semi-transmissive TFT substrate or a semi-reflective TFT substrate having via hole channels, which is capable of producing readily a display means or an emitting means utilizing a liquid crystal, an organic EL material or the like.

In addition, it is preferred that a metal layer-protecting oxide conductor layer for protecting the reflective metal layer be formed above the reflective metal layer.
By doing this, discoloration or other problems of the reflective metal layer can be prevented, and as a result, disadvantages such as a decrease in reflectance of the reflective metal layer can be prevented.

In addition, it is preferred that a thin film for a gate electrode/gate wire-protecting conductive layer for protecting the thin film for a gate electrode/gate wire be formed above the thin film for a gate electrode/gate wire.
By doing this, the surface of a metal used in the gate wire is prevented from being exposed when forming the opening for the gate wire pad, leading to improved connection reliability.

Further, the method for producing a TFT substrate of the present invention comprises the steps of:
stacking a thin film for a gate electrode/gate wire from which a gate electrode and a gate wire are formed, a gate insulating film, an oxide layer and a first resist above a substrate;
forming the first resist into a predetermined shape by half-tone exposure by using a first half-tone mask;
patterning the thin film for a gate electrode/gate wire, the gate insulating film and the oxide layer with an etching method to form the gate electrode and the gate wire;
reforming the first resist into a predetermined shape;
patterning the oxide layer with an etching method to form a channel part;
stacking an interlayer insulating film and a second resist;
forming the second resist into a predetermined shape by using a second mask;
patterning the interlayer insulating film with an etching method to form an opening for a source electrode and an opening for a drain electrode at positions where a source electrode and a drain electrode are formed and patterning the interlayer insulating film and the gate insulting film with an etching method to form an opening for a gate wire pad at a position where a gate wire pad is formed;
stacking a conductor layer and a third resist;
forming the third resist into a predetermined shape by using a third mask; and
patterning the conductor layer with an etching method to form the source electrode, the drain electrode, a source wire, a drain wire, a pixel electrode and the gate wire pad.
As is apparent from the above, the invention is advantageous also as a method for producing a TFT substrate, and a TFT substrate with via hole channels can be produced by using three masks. Since the number of masks is decreased and production steps are reduced, production efficiency can be improved and manufacturing cost can be decreased. Moreover, a channel guard is formed on the upper part of the oxide layer constituting the channel part. This channel guard is formed of an interlayer insulating film having a pair of openings in which the drain electrode and the source electrode are respectively formed. Since the channel part is protected by this channel guard, a TFT substrate can be operated stably for a prolonged period of time. Furthermore, since the oxide layer is normally provided only at predetermined positions (predetermined positions corresponding to the channel part, the source electrode and the drain electrode), concern for occurrence of interference between the gate wires (crosstalk) can be eliminated.

Further, the method for producing a TFT substrate of the present invention comprises the steps of:
stacking a thin film for a gate electrode/gate wire from which a gate electrode and a gate wire are formed, a gate insulating film, an oxide layer and a first resist above a substrate;
forming the first resist into a predetermined shape by half-tone exposure by using a first half-tone mask;
patterning the thin film for a gate electrode/gate wire, the gate insulating film and the oxide layer with an etching method to form the gate electrode and the gate wire;
reforming the first resist into a predetermined shape;
patterning the oxide layer with an etching method to form a channel part;
stacking an interlayer insulating film and a second resist;
forming the second resist into a predetermined shape by using a second mask;
patterning the interlayer insulating film with an etching method to form an opening for a source electrode and an opening for a drain electrode at positions where a source electrode and a drain electrode are formed and patterning the interlayer insulating film and the gate insulting film with an etching method to form an opening for a gate wire pad at a position where a gate wire pad is formed;
stacking a conductor layer and a third resist;
forming the third resist into a predetermined shape by using a third mask;
patterning the conductor layer with an etching method to form the source electrode, the drain electrode, a source wire, a drain wire, a pixel electrode and the gate wire pad;
stacking a protective insulating film and a fourth resist;
forming the fourth resist into a predetermined shape; and
patterning the protective insulating film with an etching method to expose a source/drain wire pad, the pixel electrode and the gate wire pad.
By doing this, the source electrode, the drain electrode, the source wire and the drain wire are covered with the protective insulating film so as not to be exposed, and the TFT substrate is provided with the protective insulating film. As a result, it is possible to provide a TFT substrate capable of producing readily a display means or an emitting means utilizing a liquid crystal, an organic EL material or the like.

Further, the method for producing a reflective TFT substrate of the present invention comprises the steps of:
stacking a thin film for a gate electrode/gate wire from which a gate electrode and a gate wire are formed, a gate insulating film, an oxide layer and a first resist above a substrate;
forming the first resist into a predetermined shape by half-tone exposure by using a first half-tone mask;
patterning the thin film for a gate electrode/gate wire, the gate insulating film and the oxide layer with an etching method to form the gate electrode and the gate wire;
reforming the first resist into a predetermined shape;
patterning the oxide layer with an etching method to form a channel part;
stacking an interlayer insulating film and a second resist;
forming the second resist into a predetermined shape by using a second mask;
patterning the interlayer insulating film with an etching method to form an opening for a source electrode and an opening for a drain electrode at positions where a source electrode and a drain electrode are formed and patterning the interlayer insulating film and the gate insulting film with an etching method to form an opening for a gate wire pad at a position where a gate wire pad is formed;
stacking a reflective metal layer and a third resist;
forming the third resist into a predetermined shape by using a third mask; and
patterning the reflective metal layer with an etching method to form the source electrode, the drain electrode, a source wire, a drain wire, a pixel electrode and the gate wire pad.
As is apparent from the above, the invention is advantageous also as a method for producing a reflective TFT substrate, and a reflective TFT substrate with via hole channels can be produced by using three masks. Since the number of masks is decreased and production steps are reduced, production efficiency can be improved and manufacturing cost can be decreased. Moreover, a channel guard is formed on the upper part of the oxide layer constituting the channel part. This channel guard is composed of an interlayer insulating film having a pair of openings in which the drain electrode and the source electrode are formed. Since the channel part is protected by this channel guard, a reflective TFT substrate can be operated stably for a prolonged period of time. Further, since the oxide layer is normally provided only at predetermined positions (predetermined positions corresponding to the channel part, the source electrode and the drain electrode), concern for occurrence of interference between the gate wires (crosstalk) can be eliminated.

Further, the method for producing a reflective TFT substrate of the invention comprises the steps of:
stacking a thin film for a gate electrode/gate wire from which a gate electrode and a gate wire are formed, a gate insulating film, an oxide layer and a first resist above a substrate;
forming the first resist into a predetermined shape by half-tone exposure by using a first half-tone mask;
patterning the thin film for a gate electrode/gate wire, the gate insulating film and the oxide layer with an etching method to form the gate electrode and the gate wire;
reforming the first resist into a predetermined shape;
patterning the oxide layer with an etching method to form a channel part;
stacking an interlayer insulating film and a second resist;
forming the second resist into a predetermined shape by using a second mask;
patterning the interlayer insulating film with an etching method to form an opening for a source electrode and an opening for a drain electrode at positions where a source electrode and a drain electrode are formed and patterning the interlayer insulating film and the gate insulting film with an etching method to form an opening for a gate wire pad at a position where a gate wire pad is formed;
stacking a reflective metal layer, a protective insulating layer and a third resist;
forming the third resist into a predetermined shape by half-tone exposure by using a third half-tone mask;
patterning the reflective metal layer and the protective insulating film with an etching method to form the source electrode, the drain electrode, a source wire, a drain wire, a pixel electrode and the gate wire pad;
reforming the third resist into a predetermined shape; and
patterning the protective insulating film with an etching method to expose a source/drain wire pad, the pixel electrode and the gate wire pad.
By doing this, operation stability can be improved since the upper part of each of the source electrode, the drain electrode, the source wire and the drain wire is covered with the protective insulating film.

Further, the method for producing a reflective TFT substrate of the invention comprises the steps of:
stacking a thin film for a gate electrode/gate wire from which a gate electrode and a gate wire are formed, a gate insulating film, an oxide layer and a first resist above a substrate;
forming the first resist into a predetermined shape by half-tone exposure by using a first half-tone mask;
patterning the thin film for a gate electrode/gate wire, the gate insulating film and the oxide layer with an etching method to form the gate electrode and the gate wire;
reforming the first resist into a predetermined shape;
patterning the oxide layer with an etching method to form a channel part;
stacking an interlayer insulating film and a second resist;
forming the second resist into a predetermined shape by using a second mask;
patterning the interlayer insulating film with an etching method to form an opening for a source electrode and an opening for a drain electrode at positions where a source electrode and a drain electrode are formed and patterning the interlayer insulating film and the gate insulting film with an etching method to form an opening for a gate wire pad at a position where a gate wire pad is formed;
stacking a reflective metal layer and a third resist;
forming the third resist into a predetermined shape by using a third mask;
patterning the reflective metal layer with an etching method to form the source electrode, the drain electrode, a source wire, a drain wire, a pixel electrode and the gate wire pad;
stacking the protective insulting film and a fourth resist;
forming the fourth resist into a predetermined shape; and
patterning the protective insulating film with an etching method to expose a source/drain wire pad, the pixel electrode and the gate wire pad.
By doing this, the source electrode, the drain electrode, the source wire and the drain wire are covered with the protective insulating film so as not to be exposed, and the TFT substrate is provided with the protective insulating film. As a result, it is possible to provide a reflective TFT substrate capable of producing readily a display means or an emitting means utilizing a liquid crystal, an organic EL material or the like.

In addition, it is preferred that an oxide conductor layer be stacked between the oxide layer and the reflective metal layer.
By doing this, switching speed of a TFT can be increased, and durability of a TFT can be improved.

Further, it is preferred that a metal layer-protecting oxide transparent conductor layer be stacked above the reflective metal layer.
By doing this, not only the reflective metal layer can be prevented from corrosion but also the durability thereof can be improved. In addition, discoloration or other problems of the reflective metal layer can be prevented, and disadvantages such as a decrease in reflectance of the reflective metal layer can be prevented.

Further, it is preferred that the thin film for a gate electrode/gate wire comprise a metal layer and a metal layer-protecting transparent conductor layer be stacked above the metal layer.
By doing this, the surface of a metal used in the gate wire is prevented from being exposed when forming the opening for the gate wire pad, leading to improved connection reliability.

### BRIEF DESCRIPTION OF THE DRAWINGS

FIG. 1 is a schematic flow chart for explaining the method for producing a TFT substrate according to a first embodiment of the invention;

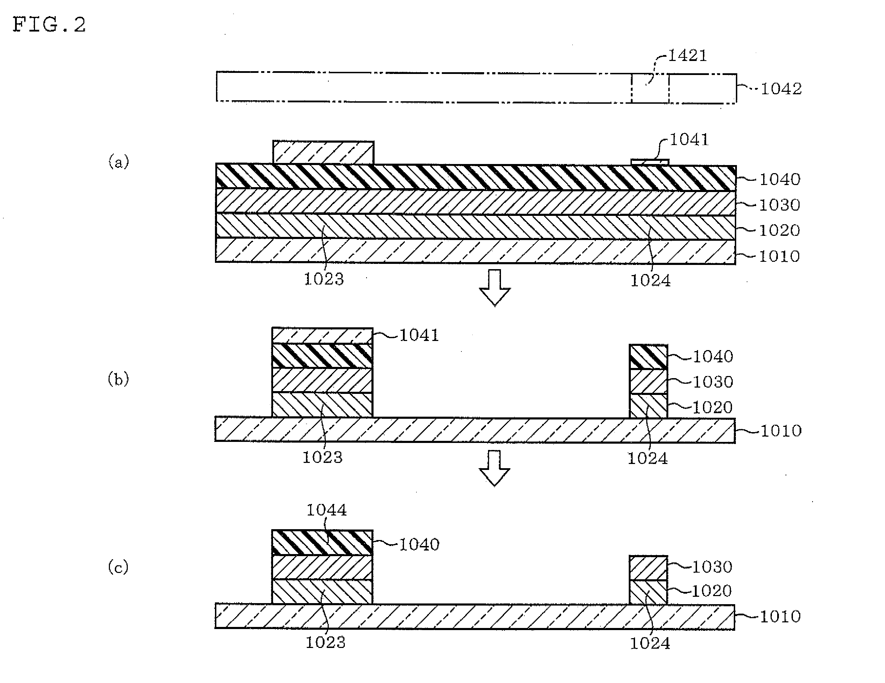

FIG. 2 is a schematic view for explaining treatment using a first half-tone mask in the method for producing a TFT substrate according to the first embodiment of the invention, in which (a) is a cross-sectional view after the formation of a metal layer/after the formation of a gate insulating film/after the formation of an n-type oxide semiconductor layer/after the application of a first resist/after half-tone exposure/after development; (b) is a cross-sectional view after first etching/after reformation of the first resist; and (c) is a cross-sectional view after second etching/after peeling off the first resist;
FIG. 3 is a schematic plan view of an essential part of a TFT substrate after peeling off the first resist in the method for producing a TFT substrate according to the first embodiment of the invention;
FIG. 4 is a schematic view for explaining treatment using a second mask in the method for producing a TFT substrate according to the first embodiment of the invention, in which (a) is a cross-sectional view after the formation of an interlayer insulating film/after the application of a second resist/after exposure/after development; (b) is a cross-sectional view after third etching; and (c) is a cross-sectional view after peeling off the second resist;
FIG. 5 is a schematic plan view of an essential part of a TFT substrate after peeling off the second resist in the method for producing a TFT substrate according to the first embodiment of the invention;
FIG. 6 is a schematic view for explaining treatment using a third mask in the method for producing a TFT substrate according to the first embodiment of the invention, in which (a) is a cross-sectional view after the formation of an oxide transparent conductor layer/after the application of a third resist/after exposure/after development; and (b) is a cross-sectional view after fourth etching/after peeling off the third resist;
FIG. 7 is a schematic plan view of an essential part of a TFT substrate after peeling off the third resist in the method for producing a TFT substrate according to the first embodiment of the invention;
FIG. 8 is a schematic flow chart for explaining the method for producing a TFT substrate according to a second embodiment of the invention;
FIG. 9 is a schematic view for explaining treatment using a third half-tone mask in the method for producing a TFT substrate according to the second embodiment of the invention, in which (a) is a cross-sectional view after the formation of an oxide transparent conductor layer/after the formation of a protective insulating film/after the application of a third resist/after half-tone exposure/after development; and (b) is a cross-sectional view after fourth etching;
FIG. 10 is a schematic view for explaining treatment using a third half-tone mask in the method for producing a TFT substrate according to the second embodiment of the invention, in which (a) is a cross-sectional view after the reformation of the third resist; and (b) is a cross-sectional view after fifth etching/after peeling off the third resist;
FIG. 11 is a schematic plan view of an essential part of a TFT substrate after peeling off the third resist in the method for producing a TFT substrate according to the second embodiment of the invention;
FIG. 12 is a schematic flow chart for explaining an application example in the method for producing a TFT substrate according to the second embodiment of the invention;
FIG. 13 is a schematic view for explaining treatment using a third mask in the application example of the method for producing a TFT substrate according to the second embodiment of the invention, in which (a) is a cross-sectional view after the formation of an oxide transparent conductor layer/after the application of a third resist/after exposure/after development; and (b) is a cross-sectional view after fourth etching/after peeling off the third resist;
FIG. 14 is a schematic view for explaining treatment using a fourth mask in the application example of the method for producing a TFT substrate according to the second embodiment of the invention, in which (a) is a cross-sectional view after the formation of a protective insulating film/after the application of a fourth resist/after exposure/after development; and (b) is a cross-sectional view after fifth etching/after peeling off the fourth resist;
FIG. 15 is a schematic plan view of an essential part of a TFT substrate after peeling off the fourth resist in the application example of the method for producing a TFT substrate according to the second embodiment of the invention;
FIG. 16 is a schematic flow chart for explaining the method for producing a TFT substrate according to a third embodiment of the invention;
FIG. 17 is a schematic view for explaining treatment using a third half-tone mask in the method for producing a TFT substrate according to the third embodiment of the invention, in which (a) is a cross-sectional view after the formation of an oxide transparent conductor layer/after the formation of an auxiliary conductor layer/after the formation of a protective insulating film/after the application of a third resist/after half-tone exposure/after development; and (b) is a cross-sectional view after fourth etching;
FIG. 18 is a schematic view for explaining treatment using a third half-tone mask in the method for producing a TFT substrate according to the third embodiment of the invention, in which (a) is a cross-sectional view after the reformation of the third resist; and (b) is a cross-sectional view after fifth etching /after peeling off the third resist;
FIG. 19 is a schematic plan view of an essential part of a TFT substrate after peeling off the third resist in the method for producing a TFT substrate according to the third embodiment of the invention;
FIG. 20 is a schematic flow chart for explaining the application example of the method for producing a TFT substrate according to the third embodiment of the invention;
FIG. 21 is a schematic view for explaining treatment using a third mask in the application example of the method for producing a TFT substrate according to the third embodiment of the invention, in which (a) is a cross-sectional view after the formation of an oxide transparent conductor layer/after the formation of an auxiliary conductor layer/after the application of a third resist/after exposure/after development; and (b) is a cross-sectional view after fourth etching/after peeling off the third resist;
FIG. 22 is a schematic view for explaining treatment using a fourth mask in the application example of the method for producing a TFT substrate according to the third embodiment of the invention, in which (a) is a cross-sectional view after the formation of a protective insulating film/after the application of a fourth resist/after exposure/after development; and (b) is a cross-sectional view after fifth etching/after peeling off the fourth resist;
FIG. 23 is a schematic plan view of an essential part of a TFT substrate after peeling off the fourth resist in the application example of the method for producing a TFT substrate according to the third embodiment of the invention;
FIG. 24 is a schematic flow chart for explaining the method for producing a TFT substrate according to a fourth embodiment of the invention;
FIG. 25 is a schematic view for explaining treatment using a third half-tone mask in the application example of the method for producing a TFT substrate according to the fourth embodiment of the invention, in which (a) is a cross-sectional view after the formation of an oxide transparent conductor layer/after the formation of a reflective metal layer/after the application of a third resist/after half-tone exposure/after development; and (b) is a cross-sectional view after fourth etching;
FIG. 26 is a schematic view for explaining treatment using a third half-tone mask in the method for producing a TFT substrate according to the fourth embodiment of the invention, in which (a) is a cross-sectional view after the reformation of a third resist; and (b) is a cross-sectional view after fifth etching/after peeling off the third resist;
FIG. 27 is a schematic plan view of an essential part of a TFT substrate after peeling off the third resist in the method for producing a TFT substrate according to the fourth embodiment of the invention;
FIG. 28 is a schematic flow chart for explaining the method for producing a TFT substrate according to a fifth embodiment of the invention;
FIG. 29 is a schematic view for explaining treatment using a third half-tone mask of the method for producing a TFT substrate according to the fifth embodiment of the invention, in which (a) is a cross-sectional view after the formation of an oxide transparent conductor layer/after the formation of a reflective metal layer/after the formation of a protective insulating layer/after the application of a third resist/after half-tone exposure/after development; and (b) is a cross-sectional view after fourth etching;
FIG. 30 is a schematic view for explaining treatment using a third-half mask in the method for producing a TFT substrate according to the fifth embodiment of the invention, in which (a) is a cross-sectional view after the reformation of a third resist; and (b) is a cross-sectional view after fifth etching/after peeling off the third resist;
FIG. 31 is a schematic plan view of an essential part of a TFT substrate after peeling off the third resist in the method for producing a TFT substrate according to the fifth embodiment of the invention;
FIG. 32 is a schematic flow chart for explaining an application example of the method for producing a TFT substrate according to the fifth embodiment of the invention;
FIG. 33 is a schematic view for explaining treatment using a fourth mask in the application example of the method for producing a TFT substrate according to the fifth embodiment of the invention, in which (a) is a cross-sectional view after the formation of a protective insulating film/after the application of a fourth resist/after exposure/after development; and (b) is a cross-sectional view after a sixth etching/after peeling off the fourth resist;
FIG. 34 is a schematic plan view of an essential part of a TFT substrate after peeling off the fourth resist in the method for producing a TFT substrate according to the fifth embodiment of the invention;
FIG. 35 is a schematic flow chart for explaining the method for producing a TFT substrate according to a sixth embodiment of the invention;
FIG. 36 is a schematic view for explaining treatment using a third half-tone mask of the method for producing a TFT substrate according to the fifth embodiment of the invention, in which (a) is a cross-sectional view after the formation of an oxide transparent conductor layer/after the formation of a reflective metal layer/after the formation of a metal layer-protecting oxide conductor layer/after the formation of a protective insulating layer/after the application of a third resist/after half-tone exposure/after development; and (b) is a cross-sectional view after fourth etching;
FIG. 37 is a schematic view for explaining treatment using a third half-tone mask of the method for producing a TFT substrate according to the sixth embodiment of the invention, in which (a) is a cross-sectional view after the reformation of a third resist; and (b) is a cross-sectional view after fifth etching/after peeling off the third resist;
FIG. 38 is a schematic plan view of an essential part of a TFT substrate after peeling off the third resist in the method for producing a TFT substrate according to the sixth embodiment of the invention;
FIG. 39 is a schematic flow chart for explaining an application example of the method for producing a TFT substrate according to the sixth embodiment of the invention;
FIG. 40 is a schematic view for explaining treatment using a fourth mask in the application example of the method for producing a TFT substrate according to the sixth embodiment of the invention, in which (a) is a cross-sectional view after the formation of a protective insulating film/after the application of a fourth resist/after exposure/after development; and (b) is a cross-sectional view after sixth etching/after peeling off the fourth resist;
FIG. 41 is a schematic plan view of an essential part of a TFT substrate after peeling off the fourth resist in the method for producing a TFT substrate according to the seventh embodiment of the invention;
FIG. 42 is a schematic flow chart for explaining the method for producing a TFT substrate according to a seventh embodiment of the invention;

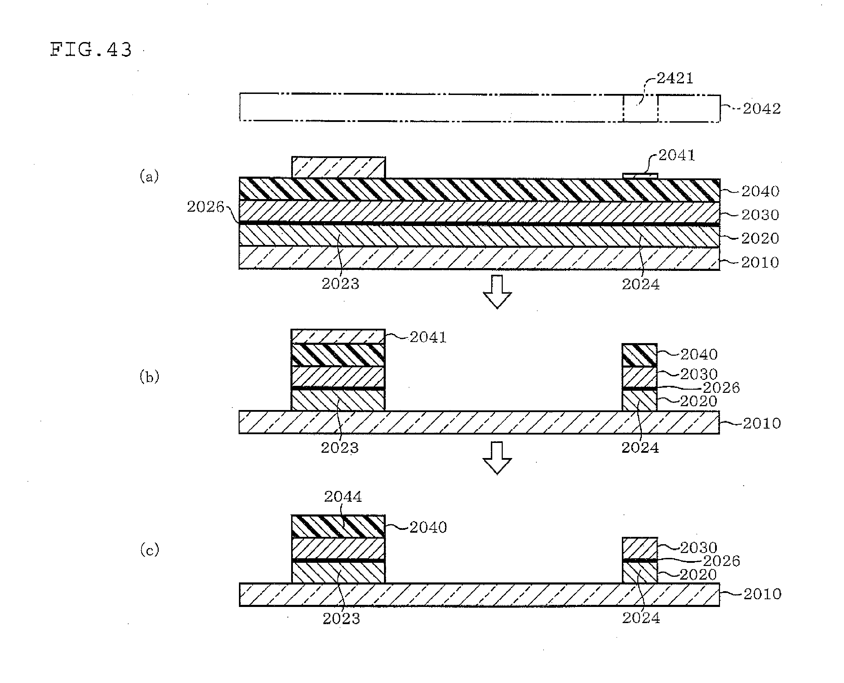

FIG. 43 is a schematic view for explaining treatment using a first half-tone mask in the method for producing a TFT substrate according to the seventh embodiment of the invention, in which (a) is a cross-sectional view after the formation of a metal layer/after the formation of a metal layer-protecting oxide transparent conductor layer/after the formation of a gate insulating film/after the formation of an n-type oxide semiconductor layer/after the application of a first resist/after half-tone exposure/after development; (b) is a cross-sectional view after a first etching/after reformation of the first resist; and (c) is a cross-sectional view after second etching/after peeling off the first resist;
FIG. 44 is a schematic plan view of an essential part of a TFT substrate after peeling off the first resist in the method for producing a TFT substrate according to the seventh embodiment of the invention;
FIG. 45 is a schematic view for explaining treatment using a second mask in the method for producing a TFT substrate according to the seventh embodiment of the invention, in which (a) is a cross-sectional view after the formation of an interlayer insulating film/after the application of a second resist/after exposure/after development; (b) is a cross-sectional view after third etching; (c) is a cross-sectional view after peeling off the second resist;
FIG. 46 is a schematic plan view of an essential part of a TFT substrate after peeling off the second resist in the method for producing a TFT substrate according to the seventh embodiment of the invention;
FIG. 47 is a schematic view for explaining treatment using a third mask in the method for producing a TFT substrate according to the seventh embodiment of the invention, in which (a) is a cross-sectional view after the formation of an oxide transparent conductor layer/after the application of a third resist/after exposure/after development; and (b) is a cross-sectional view after fourth etching/after peeling off the third resist;
FIG. 48 is a schematic plan view of an essential part of a TFT substrate after peeling off the third resist in the method for producing a TFT substrate according to the seventh embodiment of the invention;
FIG. 49 is a schematic flow chart for explaining an application example of the method for producing a TFT substrate according to the seventh embodiment of the invention;
FIG. 50 is a schematic view for explaining treatment using a fourth mask in the application example of the method for producing a TFT substrate according to the seventh embodiment of the invention, in which (a) is a cross-sectional view after the formation of a protective insulating film/after the application of a fourth resist/after exposure/after development; and (b) is a cross-sectional view after fifth etching/after peeling off the fourth resist;
FIG. 51 is a schematic plan view of an essential part of a TFT substrate after peeling off the fourth resist in the application example of the method for producing a TFT substrate according to the seventh embodiment of the invention;
FIG. 52 is a schematic flow chart for explaining the method for producing a reflective TFT substrate according to a first embodiment of the invention;
FIG. 53 is a schematic view for explaining treatment using a third mask of the method for producing a reflective TFT substrate according to the first embodiment of the invention, in which (a) is a cross-sectional view after the formation of a reflective metal layer/after the application of a third resist/after exposure/after development; and (b) is a cross-sectional view after fourth etching/after peeling off the third resist;
FIG. 54 is a schematic plan view of an essential part of a TFT substrate after peeling off the third resist in the method for producing a reflective TFT substrate according to the first embodiment of the invention;
FIG. 55 is a schematic flow chart for explaining the method for producing a reflective TFT substrate according to a second embodiment of the invention;
FIG. 56 is a schematic view for explaining treatment using a third half-tone mask in the method for producing a reflective TFT substrate according to the second embodiment of the invention, in which (a) is a cross-sectional view after the formation of a reflective metal layer/after the formation of a protective insulating film/after the application of a third resist/after half-tone exposure/after development; and (b) is a cross-sectional view after fourth etching;
FIG. 57 is a schematic view for explaining treatment using a third half-tone mask in the method for producing a reflective TFT substrate according to the second embodiment of the invention, in which (a) is a cross-sectional view after the reformation of the third resist; and (b) is a cross-sectional view after fifth etching/after peeling off the third resist;
FIG. 58 is a schematic plan view of an essential part of a reflective TFT substrate after peeling off the third resist in the method for producing a reflective TFT substrate according to the second embodiment of the invention;
FIG. 59 is a schematic flow chart for explaining the method for producing a reflective TFT substrate according to a third embodiment of the invention;
FIG. 60 is a schematic view for explaining treatment using a fourth mask in the method for producing a reflective TFT substrate according to the third embodiment of the invention, in which (a) is a cross-sectional view after the formation of a protective insulating film/after the application of a fourth resist/after exposure/after development; and (b) is a cross-sectional view after fifth etching/after peeling off the fourth resist;
FIG. 61 is a schematic plan view of an essential part of a reflective TFT substrate after peeling off the fourth resist in the method for producing a reflective TFT substrate according to the third embodiment of the invention;
FIG. 62 is a schematic flow chart for explaining the method for producing a reflective TFT substrate according to a fourth embodiment of the invention;
FIG. 63 is a schematic view for explaining treatment using a third half-tone mask in the method for producing a reflective TFT substrate according to the fourth embodiment of the invention, in which (a) is a cross-sectional view after the formation of a reflective metal layer/after the formation of a metal layer-protecting oxide transparent conductor layer/after the formation of a protective insulating film/after the application of a third resist/after half-tone exposure/after development; (b) is a cross-sectional view after fourth etching;
FIG. 64 is a schematic view for explaining treatment using a third half-tone mask in the method for producing a reflective TFT substrate according to the fourth embodiment of the invention, in which (a) is a cross-sectional view after the reformation of a third resist; and (b) is a cross-sectional view after fifth etching/after peeling off the third resist;
FIG. 65 is a schematic plan view of an essential part of a reflective TFT substrate after peeling off the third resist in the method for producing a reflective TFT substrate according to the fourth embodiment of the invention;
FIG. 66 is a schematic flow chart for explaining the method for producing a reflective TFT substrate according to a fifth embodiment of the invention;

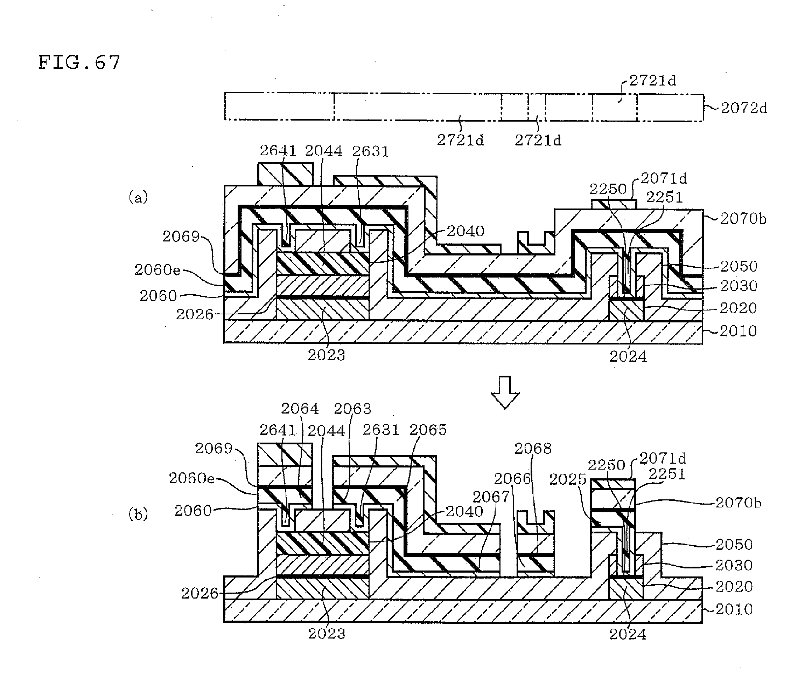

FIG. 67 is a schematic view for explaining treatment using a third half-tone mask in the method for producing a reflective TFT substrate according to the fifth embodiment of the invention, in which (a) is a cross-sectional view after the formation of an oxide transparent conductor layer/after the formation of a reflective metal layer/after the formation of a metal layer-protecting oxide transparent conductor layer/after the formation of a protective insulating film/after the application of a third resist/after half-tone exposure/after development; (b) is a cross-sectional view after fourth etching;
FIG. 68 is a schematic view for explaining treatment using a third half-tone mask in the method for producing a reflective TFT substrate according to the fifth embodiment of the invention, in which (a) is a cross-sectional view after the reformation of the third resist; and (b) is a cross-sectional view after fifth etching/after peeling off the third resist;
FIG. 69 is a schematic plan view of an essential part of a reflective TFT substrate after peeling off the third resist in the method for producing a TFT substrate according to the fifth embodiment of the invention;
FIG. 70 is a schematic cross-sectional view for explaining the conventional method for producing a TFT substrate, in which (a) is a cross-sectional view after formation of a gate electrode; (b) is a cross-sectional view after the formation of an etch stopper; (c) is a cross-sectional view after the formation of a source electrode and a drain electrode; (d) is a cross-sectional view after the formation of an interlayer insulating film; and (e) is a cross-sectional view after the formation of a pixel electrode.

### BEST MODE FOR CARRYING OUT THE INVENTION

### [Method for producing a TFT substrate according to a first embodiment]

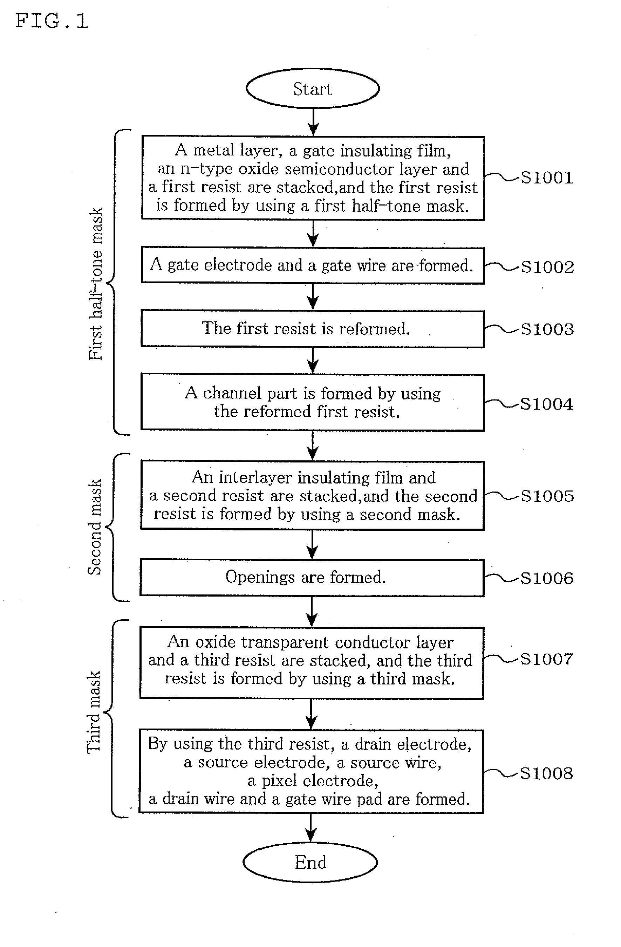

FIG. 1 is a schematic flow chart for explaining the method for producing a TFT substrate according to a first embodiment of the invention. The method for producing a TFT substrate in this embodiment corresponds to claim 24.
In FIG. 1, first, a metal layer 1020 as a thin film for a gate electrode/gate wire, a gate insulating film 1030, an n-type oxide semiconductor layer 1040 as a first oxide layer, and a first resist 1041 are stacked in this order on a glass substrate 1010, and the first resist 1041 is formed into a predetermined shape with a first half-tone mask 1042 by half-tone exposure (Step S1001).
Next, treatment using the first half-tone mask 1042 will be explained below referring to the drawing.

### (Treatment using a first half-tone mask)

FIG. 2 is a schematic view for explaining treatment using a first half-tone mask in the method for producing a TFT substrate according to the first embodiment of the invention, in which (a) is a cross-sectional view after the formation of a metal layer/after the formation of a gate insulating film/after the formation of an n-type oxide semiconductor layer/after the application of a first resist/after half-tone exposure/after development; (b) is a cross-sectional view after first etching/after reformation of the first resist; and (c) is a cross-sectional view after second etching/after peeling off the first resist.
In FIG. 2(a), a light-transmissive glass substrate 1010 is provided at first.
A plate-like element as the base material of the TFT substrate 1001 is not limited to the above-mentioned glass substrate 1010. For example, a plate- or sheet-like element made of a resin may be used.

Next, by using the high-frequency sputtering method, Al is stacked on the glass substrate 1010 in a thickness of about 250 nm. Subsequently, by using the high-frequency sputtering method, Mo (molybdenum) is stacked in a thickness of about 50 nm. As a result, the metal layer 1020 for forming a gate electrode 1023 and a gate wire 1024 is formed. That is, though not shown, the metal layer 1020 is formed of an Al thin film layer and a Mo thin film layer. First, the A1 thin film layer is formed by the high-frequency sputtering method using an Al target in an atmosphere of argon 100%. Then, the Mo thin film layer is formed by the high-frequency sputtering method using a Mo target in an atmosphere of argon 100%.

Meanwhile, instead of the above-mentioned Mo, Ti (titanium), Cr (chromium) or the like may be used. As the gate wire 1024, a thin film of a metal such as Ag (silver), Cu (copper) or the like or a thin film of an alloy of these metals may be used. Although Al may be pure Al (A1 with a purity of almost 100%), a metal such as Nd (neodymium), Ce (cerium), Mo, W (tungsten) and Nb (niobium) may be added. Of these, a metal such as Ce, W and Nb is preferable to suppress a cell reaction with an oxide transparent conductor layer 1060. The added amount can be appropriately selected, but preferably about 0.1 to 2 wt%.
In this embodiment, the metal layer 1020 is used as the thin film for a gate electrode/gate wire. However, the thin film for a gate electrode/gate wire is not limited to the metal layer 1020. For example, an oxide transparent conductor layer composed of indium oxide-tin oxide (In₂O₃: SnO=about 90:10 wt%) or the like may be used as the thin film for a gate electrode/gate wire.

Next, the gate insulating film 1030, which is a silicon nitride (SiNx) film, is deposited in a thickness of about 300 nm by the glow discharge CVD (Chemical Vapor Deposition) method on the metal layer 1020. In this embodiment, an SiH₄-NH₃-N₂-based mixed gas is used as a discharge gas.

In this embodiment, a silicon nitride film composed of SiNₓ or the like is used as the gate insulating film 1030. However, an oxide insulator may also be used as the insulating film. In this case, a higher dielectric ratio of the oxide insulating film is advantageous for the operation of a thin film transistor. In addition, a higher degree of insulating properties is preferable. As examples of insulating films satisfying these requirements, an oxide insulating film composed of an oxide having a superlattice structure is preferable. Furthermore, it is possible to use an amorphous oxide insulating film. The amorphous oxide insulating film can be advantageously used in combination with a substrate having a low thermal resistance, such as a plastic substrate, since film formation temperature can be kept low.
For example, ScAlMgO₄, ScAlZnO₉, ScAlCoO₄, ScAlMnO₄, ScGaZnO₄, ScGaMgO₄, or ScAlZn₃O₆, ScAlZn₄O₇, ScAlZn₇O₁₀, or ScGaZn₃O₆, ScGaZn₅O₈, ScGaZn₇O₁₀, or ScFeZn₂O₅, ScFeZn₃O₆, ScFeZn₆O₉ may also be used.
Furthermore, oxides such as aluminum oxide, titanium oxide, hafnium oxide and lanthanoide oxide, and a composite oxide having a superlattice structure may also be used.

Next, the n-type oxide semiconductor layer 1040 with a thickness of about 150 nm is formed on the gate insulating film 1030 by using an indium oxide-zinc oxide (In₂O₃:ZnO=about 97:3 wt%) target. This layer formation is conducted under the condition of an oxygen-to-argon ratio of about 10:90 (vol%) and a substrate temperature of about 150°C. Under this condition, the n-type oxide conductor layer 1040 is obtained as an amorphous film. Meanwhile, the n-type oxide semiconductor layer 1040 is obtained as an amorphous film when formed at a low temperature of about 200°C or lower, and is obtained as a crystallized film when formed at a high temperature exceeding about 200°C. The above-mentioned amorphous film can be crystallized by heat treatment. In this embodiment, the n-type oxide semiconductor layer 1040 is formed as an amorphous film, and the amorphous film is then crystallized.
The n-type oxide semiconductor layer 1040 is not limited to the oxide semiconductor layer formed of the above-mentioned indium oxide-zinc oxide, for example, an oxide semiconductor layer based on indium oxide-gallium oxide-zinc oxide or an oxide semiconductor layer formed of indium oxide-samarium oxide, zinc oxide-magnesium oxide or the like may also be used.

The carrier density of the above-mentioned indium oxide-zinc oxide thin film was 10⁺¹⁶ cm⁻³ or less, which was in a range allowing the film to function satisfactorily as a semiconductor. In addition, the hole mobility was 25 cm²/V·sec. Usually, as long as the carrier density is less than about 10⁺¹⁷ cm⁻³, the film functions satisfactorily as a semiconductor. In addition, the mobility is approximately 10 times as large as that of amorphous silicon. In view of the above, the n-type oxide semiconductor layer 1040 is a satisfactorily effective semiconductor thin film.

In addition, since the n-type oxide semiconductor layer 1040 is required to be transparent, an oxide, whose energy gap is about 3.0 eV or more, may be used. The energy gap may preferably be about 3.2 eV or more, more preferably about 3.4 eV or more. The energy gap of the above-mentioned n-type oxide semiconductor layer based on indium oxide-zinc oxide, the n-type oxide semiconductor layer based on indium oxide-gallium oxide-zinc oxide or the n-type oxide semiconductor layer formed of indium oxide-samarium oxide, zinc oxide-magnesium oxide or the like is about 3.2 eV or more, and therefore, these n-type oxide semiconductor layers may be used preferably. Although these thin films (n-type oxide semiconductor layer) can be dissolved in an aqueous oxalic acid solution or an acid mixture composed of phosphoric acid, acetic acid and nitric acid (often abbreviated as an "acid mixture") when it is amorphous, they become insoluble in and resistant to an aqueous oxalic acid solution or an acid mixture when crystallized by heating. The crystallization temperature can be controlled according to the amount of zinc oxide to be added.

Next, as shown in FIG. 2(a), the first resist 1041 is applied on the n-type oxide semiconductor layer 1040, and the first resist 1041 is formed into a predetermined shape with the first half-tone mask 1042 by half-tone exposure (Step S1001). That is, the first resist 1041 covers the gate electrode 1023 and the gate wire 1024, and part of the first resist 1041 covering the gate wire 1024 is rendered thinner than other parts due to a half-tone mask part 1421.

Next, as shown in FIG. 2(b), as a first etching, the n-type oxide semiconductor layer 1040 is patterned with an etching method at first with the first resist 1041 and an etching solution (an aqueous oxalic acid solution). Subsequently, the gate insulating film 1030 is patterned with a dry etching method by using the first resist 1041 and an etching gas (CHF (CF₄, CHF₃ gas, or the like). Further, the metal layer 1020 is patterned with an etching method by using the first resist 1041 and an etching solution (an acid mixture), whereby the gate electrode 1023 and the gate wire 1024 are formed (Step S1002).
Then, the above-mentioned first resist 1041 is removed through an ashing process. As a result, the n-type oxide semiconductor layer 1040 above the gate wire 1024 is exposed, and the first resist 1041 is reformed in such a shape that the n-type oxide semiconductor layer 1040 above the gate electrode 1023 is covered (Step S1003).

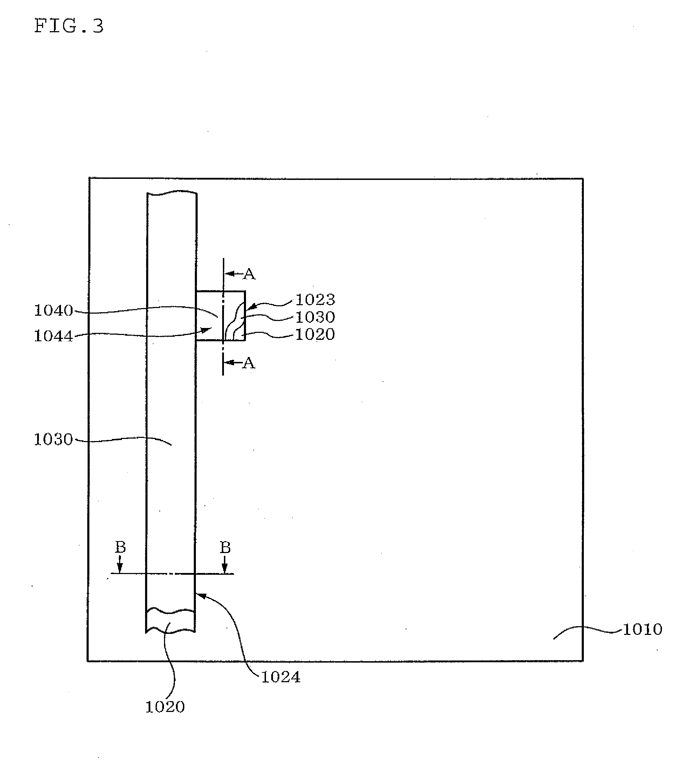

Next, as shown in FIG. 2(c), as a second etching, the exposed n-type oxide semiconductor conductor layer 1040 on the gate wire 1024 is removed by an etching method by using the reformed first resist 1041 and an etching solution (an aqueous oxalic acid solution), whereby a channel part 1044 composed of the n-type oxide semiconductor layer 1040 is formed (Step S1004).
Next, the reformed first resist 1040 is removed through an ashing process, whereby, as shown in FIG. 3, the gate insulating film 1030 and the channel part 1044 are exposed on the glass substrate 1010. The gate insulating film 1030 is stacked on the gate wire 1024. The channel part 1044 is formed on the gate insulating film 1030 above the gate electrode 1023. The gate electrode 1023 and the channel part 1044 shown in FIG. 2(c) are cross-sectional view taken along line A-A in FIG. 3. The gate wire 1024 shown in FIG. 2(c) is a cross-sectional view taken along line B-B in FIG. 3.

As is apparent from the above, by using the n-type oxide semiconductor layer 1040 as an active layer for a TFT, a TFT remains stable when electric current is flown. Therefore, the TFT substrate is advantageously used for an organic EL apparatus which is operated under current control mode.
Further, in the invention, since the n-type oxide semiconductor layer 1040 is formed only at the predetermined positions corresponding to the channel part 1044, a source electrode 1063 and a drain electrode 1064, concern for occurrence of interference of the gate wire 1024 (crosstalk) can be eliminated.

Next, as shown in FIG. 1, an interlayer insulating film 1050 and a second resist 1051 are stacked in this order on the glass substrate 1010, the gate insulting film 1030 and the n-type oxide semiconductor layer 1040, and the second resist 1051 is formed into a predetermined shape by using a second mask 1052 (Step S1005).
Next, treatment using the second mask 1052 will be explained below referring to the drawing.

### (Treatment using a second mask)

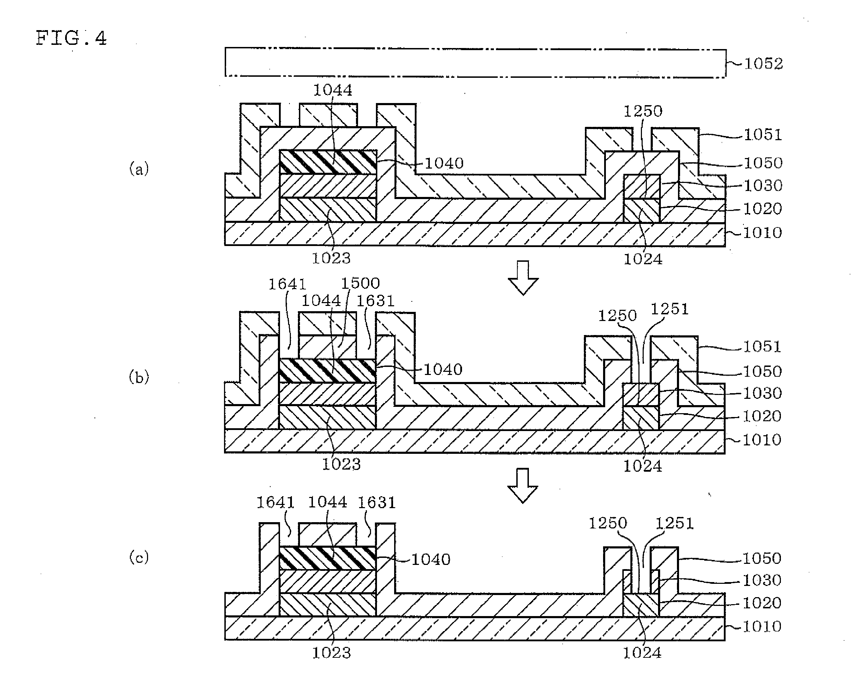

FIG. 4 is a schematic view for explaining treatment using a second mask in the method for producing a TFT substrate according to the first embodiment of the invention, in which (a) is a cross-sectional view after the formation of an interlayer insulating film/after the application of a second resist/after exposure/after development; (b) is a cross-sectional view after third etching; and (c) is a cross-sectional view after peeling off the second resist.
In FIG. 4(a), the interlayer insulating film 1050, which is a silicon nitride (SiNₓ) film, is deposited in a thickness of about 200 nm by the glow discharge CVD (Chemical Vapor Deposition) method on the glass substrate 1010, the gate insulating film 1030 and the n-type oxide semiconductor layer 1040, which are exposed. In this embodiment, an SiH₄-NH₃-N₂-based mixed gas is used as a discharge gas.

Next, as shown in FIG. 4(a), the second resist 1051 is applied on the interlayer insulating film 1050, and the second resist 1051 is formed into a predetermined shape by using the second mask 1052 (Step S1005). That is, the second resist 1051 is formed on the interlayer insulating film 1050 except for the parts above the source electrode 1063 and the drain electrode 1064 which are formed in the later process, as well as the part above a gate wire pad part 1250. The gate wire 1024 and the gate electrode 1023 are insulated with the gate insulating film 1030, which covers their top surfaces, and the interlayer insulating film 1050, which covers their side surfaces.

Subsequently, by using the second resist 1051 and an etching gas (CHF (CF₄, CHF₃ gas, or the like), the interlayer insulating film 1050 above the parts corresponding to the source electrode 1063 and the drain electrode 1064 is patterned with an etching method, and the gate insulating film 1030 and the interlayer insulating film 1050 above the gate wire pad part 1250 are patterned with an etching method. Therefore, a pair of openings 1631 and 1641 for the source electrode 1063 and the drain electrode 1064, as well as an opening 1251 for the gate wire pad 1025 are formed (Step S1006). In this case, since the etching rate of the n-type oxide semiconductor layer 1040 in CHF is significantly low, the n-type oxide semiconductor layer 1040 is not damaged. Further, since the channel part 1044 is protected by a channel guard 1500 formed on the channel part 1044 and composed of the interlayer insulating film 1050, operation stability of the TFT substrate 1001 can be improved.

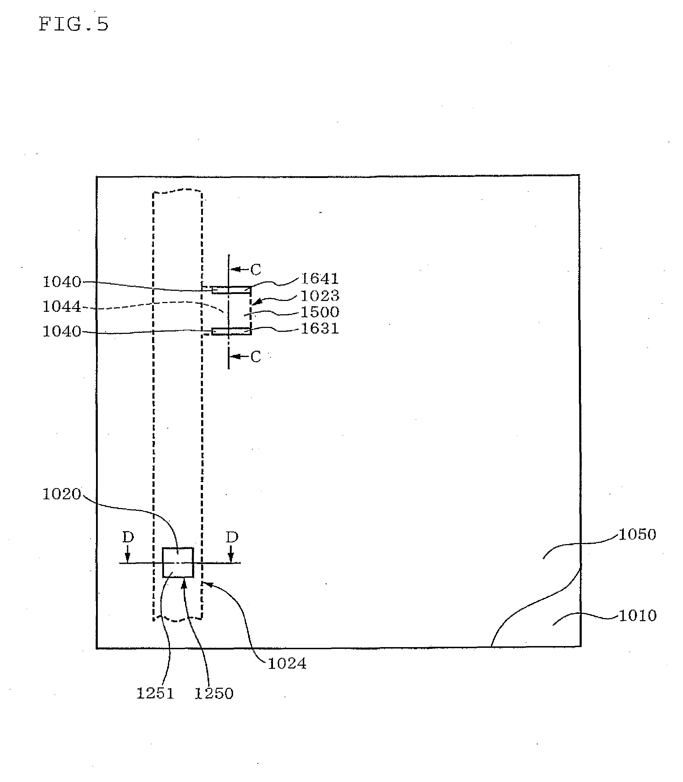

Next, after removing the second resist 1051 through an ashing process, as shown in FIG. 4(c), the interlayer insulating film 1050, the n-type oxide semiconductor layer 1040 and the metal layer 1020 are exposed above the glass substrate 1010 (see FIG. 5). The n-type oxide semiconductor layer 1040 is exposed through the openings 1631 and 1641, and the metal layer 1020 is exposed through the opening 1251. The gate electrode 1023, the channel part 1044 and the openings 1631 and 1641 shown in FIG. 4(c) are cross-sectional views taken along line C-C in FIG. 5. The gate wire pad portion 1250 and the opening 1251 are cross-sectional views taken along line D-D in FIG. 5.
The shape or size of the openings 1631, 1641 and 1251 are not particularly restricted.

Meanwhile, when the gate insulating film 1030 and the interlayer insulating film 1050 above the gate wire pad part 1250 are patterned with an etching method by using the second resist 1051 and an etching gas (CHF (CF₄, CHF₃ gas, or the like), the exposed metal layer 1020 constituting the gate wire pad part 1250 may be damaged. In such a case, a metal layer-protecting oxide conductor layer (not shown) may be provided on the metal layer 1020 as a conductive protecting film. By doing this, not only damage to the metal layer 1020 by an etching gas (CHF (CF₄, CHF₃ gas, or the like) can be minimized, but the metal layer 1020 can be prevented from corrosion and can have improved durability. As a result, operation stability of the TFT substrate 1001 can be improved, and a liquid crystal display apparatus, an organic EL apparatus or the like (not shown) using the TFT substrate 1001 can be operated stably.

As the above-mentioned metal layer-protecting oxide conductor layer (hereinafter often abbreviated as a conducting protective film), for example, a transparent conductive film composed of indium oxide-zinc oxide can be used. In this case, the conducting protective film may be composed of a conducting metal oxide which can be simultaneously etched with an acid mixture (generally called PAN), which is an etching solution for the Al thin film layer. The material for the conducting protective film is not limited to the above-mentioned indium oxide-zinc oxide. That is, as for the composition of the indium oxide-zinc oxide, any composition may be used insofar as it allows the indium oxide-zinc oxide to be etched simultaneously with Al using PAN. In/(In + Zn) may be about 0.5 to 0.95 (weight ratio), preferably about 0.7 to 0.9 (weight ratio). The reason therefor is as follows. If In/(In + Zn) is less than about 0.5 (weight ratio), durability of the conducting metal oxide itself may be decreased. If In/(In + Zn) exceeds approximately 0.95 (weight ratio), it may be difficult to be etched simultaneously with Al. In addition, in the case where the conducting metal oxide is etched simultaneously with Al, it is desirable for the conducting metal oxide to be amorphous. The reason therefor is that a crystallized film may be hard to be etched simultaneously with Al.
In addition, the thickness of the above-mentioned conducting protective films may be about 10 to 200 nm, preferably about 15 to 150 nm, more preferably about 20 to 100 nm. The reason therefor is as follow. If the thickness is less than about 10 nm, the conducting protective film may not be very effective as a protective film. A thickness exceeding about 200 nm may result in an economical disadvantage.

Further, as the metal layer-protecting oxide conductor layer, the same material as that for the oxide transparent conductor layer 1060 is generally used. By doing this, the kind of materials used can be decreased, and the desired TFT substrate 1001 can be effectively obtained. The material for the metal layer-protecting oxide conductor layer can be selected based on etching properties, protective film properties or the like.
Meanwhile, the metal layer-protecting oxide conductor layer is not necessarily formed above the metal layer 1020 as the thin film for a gate electrode/gate wire. For example, if an auxiliary conductive layer 1080 is formed of a metal layer, the metal layer-protecting oxide conductor layer may be formed above the auxiliary conductive layer 1080.

If the contact resistance between the Al thin film layer and the conducting protective film is high, a metal thin film composed of Mo, Ti, Cr or the like may be formed between the Al thin film layer and the conducting protective film. In this embodiment, a Mo thin film layer is formed. Especially, if Mo is used, the Mo thin film layer can be etched with PAN as in the case of the Al thin film layer and the conducting protective film. This is preferable since patterning can be conducted without increasing steps. The thickness of the above-mentioned metal thin film composed of Mo, Ti, Cr or the like may be about 10 to 200 nm, preferably about 15 to 100 nm, more preferably about 20 to 50 nm. The reason therefor is as follow. If the thickness is less than about 10 nm, contact resistance may not be effectively decreased. A thickness exceeding about 200 nm may result in an economical disadvantage.

Next, as shown in FIG. 1, above the glass substrate 1010 on which the openings 1631, 1641 and 1251 are formed, an oxide transparent conductor layer 1060 as a second oxide layer and a third resist 1061 are stacked in this order.
By using a third mask 1062, the third resist 1061 is formed into a predetermined shape (Step S1007).
In this embodiment, the oxide transparent conductor layer 1060 is used as the second oxide layer. However, the second oxide layer is not limited to the oxide transparent conductor layer 1060. For example, a semitransparent or nontransparent oxide conductor layer may be used as the second oxide layer.
Next, treatment using the third mask 1062 will be explained below referring to the drawing.

### (Treatment using a third mask)

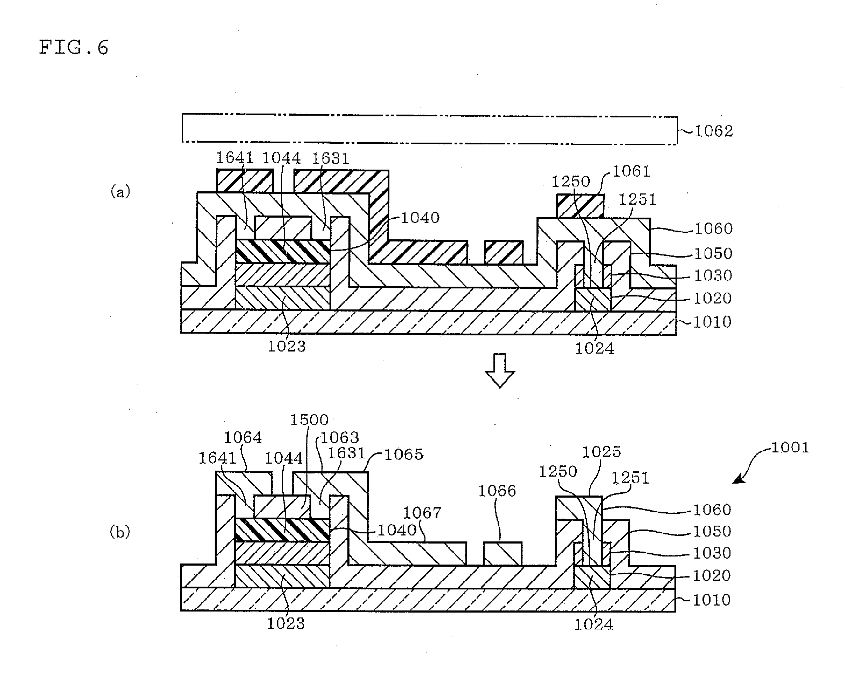

FIG. 6 is a schematic view for explaining treatment using a third mask in the method for producing a TFT substrate according to the first embodiment of the invention; in which (a) is a cross-sectional view after the formation of an oxide transparent conductor layer/after the application of a third resist/after exposure/after development; and (b) is a cross-sectional view after fourth etching/after peeling off the third resist.
In FIG. 6(a), on the interlayer insulating film 1050, the n-type oxide semiconductor layer 1040 and the metal layer 1020, which are exposed, the oxide transparent conductor layer 1060 is formed in a thickness of about 120 nm by using an indium oxide-zinc oxide (In₂O₃:ZnO=about 90:10 wt%) target. This layer formation is conducted under the condition of an oxygen-to-argon ratio of about 10:90 (vol%) and a substrate temperature of about 150°C. Under this condition, the oxide transparent conductor layer 1060 is obtained as an amorphous film. An amorphous indium oxide-zinc oxide thin film can be etched with an aqueous oxalic acid solution, but is resistant to and cannot be etched with an acid mixture. Further, an amorphous indium oxide-zinc oxide thin film is not crystallized by heat treatment at a temperature of about 300°C or lower. As a result, selective etching properties can be controlled when necessary.

The oxide transparent conductor layer 1060 is not limited to the above-mentioned oxide conductor layer composed of indium oxide-tin oxide-zinc oxide. For example, the oxide transparent conductor layer 1060 may be an oxide conductor layer composed of indium oxide-tin oxide, indium oxide-tin oxide-zinc oxide, indium oxide-tin oxide-samarium oxide or the like or an oxide conductor layer obtained by incorporating a lanthanoide-based element into indium oxide-zinc oxide, indium oxide-tin oxide, indium oxide-tin oxide-zinc oxide, indium oxide-tin oxide-samarium oxide or the like.
In this embodiment, a pixel electrode 1067 is formed from the oxide transparent conductor layer 1060. Therefore, it is preferred that the oxide transparent conductor layer 1060 be improved in conductivity.

In addition, since the oxide transparent oxide layer 1060 is required to be transparent, an oxide, whose energy gap is about 3.0 eV or more, may be used. The energy gap may preferably be about 3.2 eV or more, more preferably about 3.4 eV or more. The energy gap of an oxide conductor layer composed of indium oxide-zinc oxide, indium oxide-tin oxide, indium oxide-tin oxide-zinc oxide, indium oxide-tin oxide-samarium oxide or the like or an oxide conductor layer obtained by incorporating a lanthanoide-based element into indium oxide-zinc oxide, indium oxide-tin oxide, indium oxide-tin oxide-zinc oxide, indium oxide-tin oxide-samarium oxide or the like is about 3.2 eV or more, and therefore, these oxide conductor layers may be used preferably.

Next, as shown in FIG. 6(a), the third resist 1061 is applied on the oxide transparent conductor layer 1060, and the third resist 1061 is formed into a predetermined shape by using the third mask 1062 (Step S1007). That is, the third resist 1061 is formed in such a shape that it covers the drain electrode 1064, the source electrode 1063, the source wire 1065, the drain wire 1066, the pixel electrode 1067 and the gate wire pad 1025 (see FIG. 6(b)). In this embodiment, the pixel electrode 1067 and the source electrode 1063 are connected through the source wire 1065. However, a configuration in which the pixel electrode 1067 and the drain electrode 1064 are connected through the drain wire 1066 may be adopted.

Subsequently, as shown in FIG. 6(b), as a fourth etching, the oxide transparent conductor layer 1060 is patterned with an etching method by using the third resist 1061 and an aqueous oxalic acid solution, whereby the drain electrode 1064, the source electrode 1063, the source wire 1065, the pixel electrode 1067, the drain wire 1066 and the gate wire pad 1025 are formed (Step S1008).
By doing this, the source electrode 1063 and the drain electrode 1064 composed of the oxide transparent conductor layer 1060 are respectively formed in the pair of openings 1631 and 1641 of the interlayer insulating film 1050. As a result, it can be ensured that the source electrode 1063 and the drain electrode 1064 are formed with the channel guard 1500 and the channel part 1044 interposed therebetween. That is, the channel guard 1500, the channel part 1044, the source electrode 1063 and the drain electrode 1064 can be formed easily without fail, not only manufacturing yield is improved but also manufacturing cost can be reduced. The TFT substrate 1001 with such a structure is referred to as a TFT substrate with via hole channels.

Further, the drain electrode 1064, the source electrode 1063, the source wire 1065, the pixel electrode 1067 and the drain wire 1066, each composed of the oxide transparent conductor layer 1060, can be formed efficiently by the fourth etching. That is, the number of masks used in the production can be decreased, leading to the reduction of production steps. As a result, production efficiency can be improved and manufacturing cost can be reduced.
In addition, since each of the drain electrode 1064, the source electrode 1063, the source wire 1065, the pixel electrode 1067 and the drain wire 1066 is composed of the oxide transparent conductor layer 1060, the amount of transmitted light is increased, whereby a display apparatus improved in luminance can be provided.

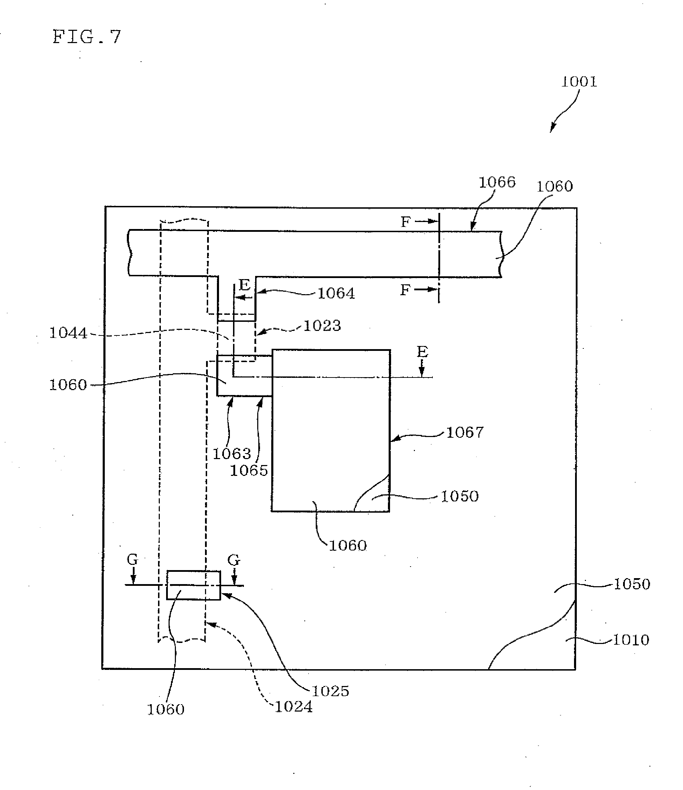

Next, the third resist 1061 is removed through an ashing process. As a result, the drain electrode 1064, the source electrode 1063, the source wire 1065, the pixel electrode 1067, the drain wire 1066 and the gate wire pad 1025, each composed of the oxide transparent conductor layer 1060, are exposed. The drain electrode 1064, the gate electrode 1023, the channel part 1044, the source electrode 1063, the source wire 1065 and the pixel electrode 1067 shown in FIG. 6(b) are cross-sectional views taken along line E-E in FIG. 7. The drain wire 1066 shown in FIG. 6(b) is a cross-sectional view taken along line F-F in FIG. 7. The gate wire pad 1025 shown in FIG. 6(b) is a cross-sectional view taken along line G-G in FIG. 7.

As mentioned above, according to the method for the TFT substrate 1001 in this embodiment, by using three masks 1042, 1052 and 1062, it is possible to produce the TFT substrate 1001 with via channel holes in which an oxide semiconductor layer (the n-type oxide semiconductor layer 1040) is used as an active semiconductor layer. Further, since production steps are reduced, manufacturing cost can be decreased. In addition, since the channel part 1044 is protected by the channel guard 1500, the TFT substrate 1001 can be operated stably for a prolonged period of time. Further, since the n-type semiconductor layer 1040 is formed only at predetermined positions (positions corresponding to the channel part 1044, the source electrode 1063 and the drain electrode 1064), concern for occurrence of interference of the gate wires 1024 (crosstalk) can be eliminated.
Meanwhile, in this embodiment, on the glass substrate 1010, the metal layer 1020, the gate insulating film 1030, the n-type oxide semiconductor layer 1040 and the first resist 1041 are stacked, then the interlayer insulating film 1050 and the second resist 1051 are stacked, and further, the oxide transparent conductor layer 1060 and the third resist 1061 are stacked. The stacking configuration is, however, not limited thereto. For example, these layers may be stacked with other layers being interposed therebetween. Here, "other layers" mean, for example, layers which do not impair the functions or the effects of this embodiment or layers which allow other functions or effects to be exhibited. The same applies to the embodiments given later.

### [Method for producing a TFT substrate according to a second embodiment]

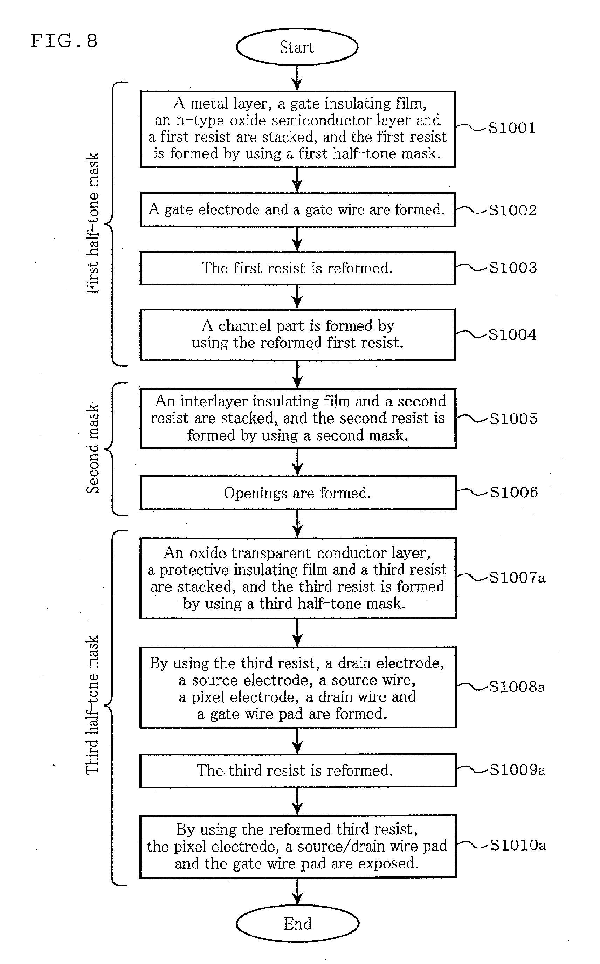

FIG. 8 is a schematic flow chart for explaining the method for producing a TFT substrate according to a second embodiment of the invention. The method for producing a TFT substrate in this embodiment corresponds to claim 25.
The method for producing the TFT substrate 1001a according to this embodiment shown in FIG. 8 differs from the above-mentioned method according to the first embodiment in the following points. Specifically, steps S1007 and S1008 of the first embodiment are changed as follows. That is, the oxide transparent conductor layer 1060, the protective insulating film 1070 and the third resist 1071 are stacked, and the third resist 1071 are formed by using a third half-tone mask 1072 (Step S1007a). Further, by using the third resist 1071, the drain electrode 1064, the source electrode 1063, the source wire 1065, the pixel electrode 1067, the drain wire 1066 and the gate wire pad 1025 are formed (Step S1008a). Then, the third resist 1071 is reformed (Step S1009a). Further, by using the reformed third resist 1071, the pixel electrode 1067, the drain wire pad 1068 and the gate wire pad 1025 are exposed (Step S1010a). That is, the method shown in FIG. 8 differs from the above-mentioned first embodiment in these points.
Other steps are almost the same as those in the first embodiment. Therefore, in the drawing, the same steps are indicated by the same numerals as used in the first embodiment, and detailed explanation is omitted.

The treatment by using the first half-tone mask and the treatment by using the second mask shown in FIG. 8 are almost the same as those in the first embodiment.
After these treatments, as shown in FIG. 8, the oxide transparent conductor layer 1060, the protective insulating film 1070 and the third resist 1071 are stacked, and the third resist 1071 is formed into a predetermined shape by using the third half-tone mask 1072 by half-tone exposure (Step S1007a).
Next, treatment using the third half-tone mask 1072 will be explained below referring to the drawing.

### (Treatment using a third half-tone mask)

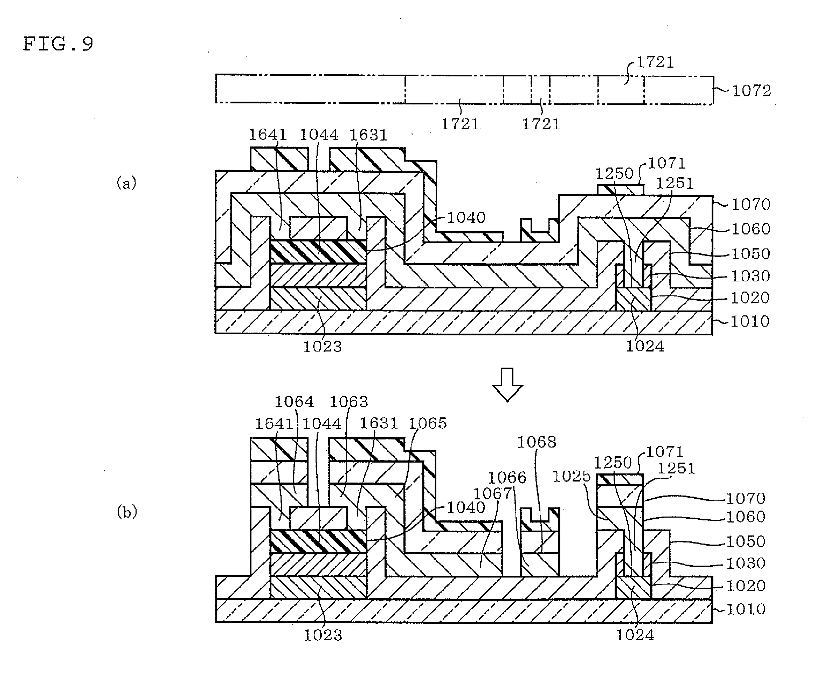

FIG. 9 is a schematic view for explaining treatment using a third half-tone mask in the method for producing a TFT substrate according to the second embodiment of the invention, in which (a) is a cross-sectional view after the formation of an oxide transparent conductor layer/after the formation of a protective insulating film/after the application of a third resist/after half-tone exposure/after development; and (b) is a cross-sectional view after fourth etching.
In FIG. 9(a), first, as in the case of the first embodiment, the oxide transparent conductor layer 1060 is formed in a thickness of about 120 nm on the interlayer insulating film 1050, the n-type oxide semiconductor layer 1040 and the metal layer 1020, which are exposed, by using an indium oxide-zinc oxide (In₂O₃:ZnO=about 90:10 wt%) target. This layer formation is conducted under the condition of an oxygen-to-argon ratio of about 10:90 (vol%) and a substrate temperature of about 150°C.

Next, the protective insulating film 1070, which is a silicon nitride (SiNₓ) film, is deposited in a thickness of about 200 nm by the glow discharge CVD (Chemical Vapor Deposition) method on the oxide transparent conductor layer 1060. In this embodiment, an SiH₄-NH₃-N₂-based mixed gas is used as a discharge gas.

Next, as shown in FIG. 9(a), the third resist 1071 is applied on the protective insulating film 1070, and the third resist 1071 is formed into a predetermined shape with the third half-tone mask 1072 by half-tone exposure (Step S1007a). That is, the third resist 1071 is formed in such a shape that it covers the drain electrode 1064, the source electrode 1063, the source wire 1065, the drain wire 1066, the pixel electrode 1067 and the gate wire pad 1025. In addition, the third resist 1071 is formed in such a shape that parts of the third resist 1071 covering the pixel electrode 1067, the drain wire pad 1068 and the gate wire pad 1025 are rendered thinner than other parts due to a half-tone mask part 1721 (see FIG 9(b)).

Next, as shown in FIG. 9(b), as a fourth etching, the exposed protective insulating film 1070 is patterned with a dry etching method at first by using the third resist 1071 and an etching gas (CHF (CF₄, CHF₃ gas, or the like). Further, the oxide transparent conductor layer 1060 is patterned with an etching method by using the third resist 1071 and an etching solution (an aqueous oxalic acid solution), whereby the drain electrode 1064, the source electrode 1063, the source wire 1065, the pixel electrode 1067, the drain wire 1066 and the gate wire pad 1025 are formed (Step S1008a).

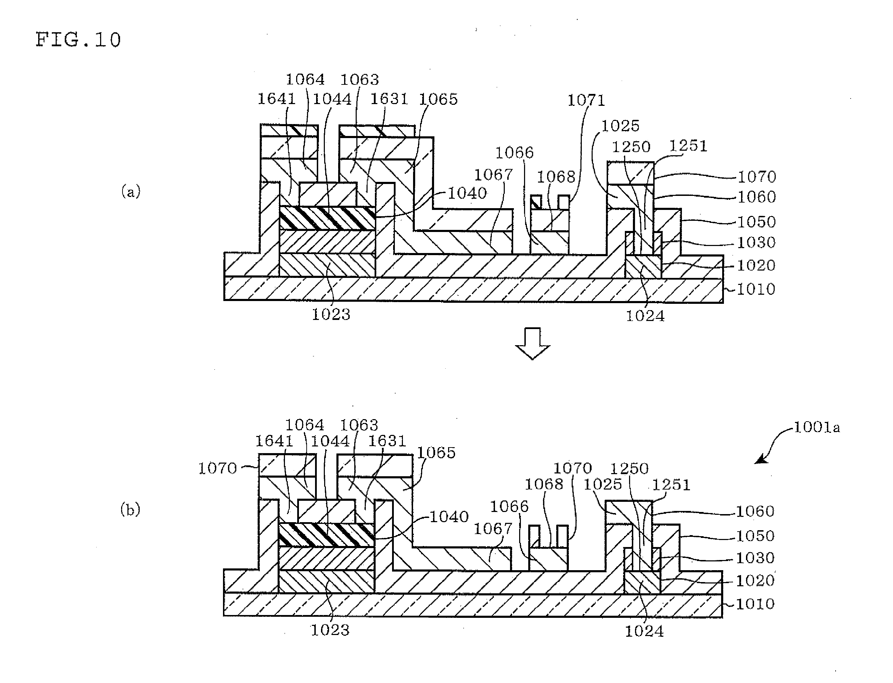

FIG. 10 is a schematic view for explaining treatment using a third half-tone mask in the method for producing a TFT substrate according to the second embodiment of the invention, in which (a) is a cross-sectional view after the reformation of the third resist; and (b) is a cross-sectional view after fifth etching/after peeling off the third resist.
In FIG. 10(a), the above-mentioned third resist 1071 is removed through an ashing process, whereby the third resist 1071 is reformed in such a shape that the protective insulating film 1070 above the pixel electrode 1067, the drain wire pad 1068 and the gate wire pad 1025 is exposed (Step S1009a).

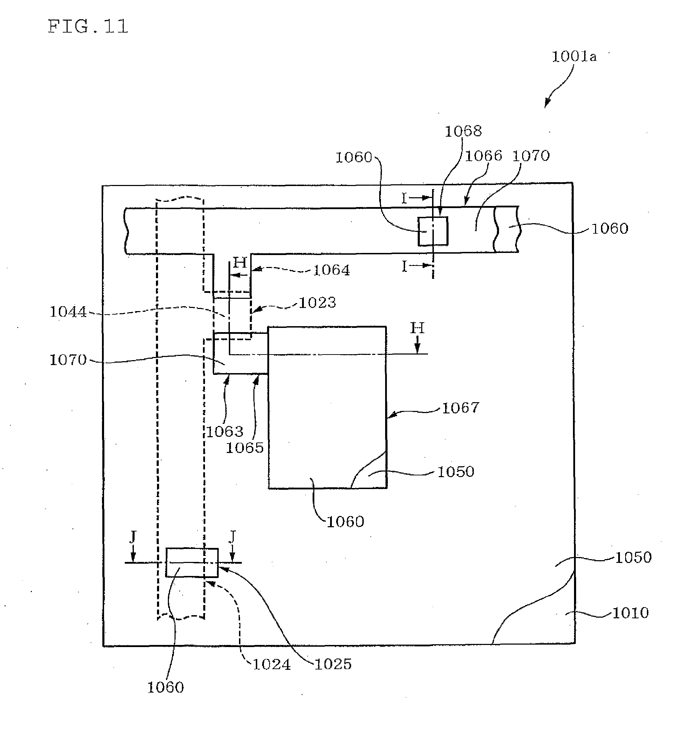

Next, as shown in FIG. 10(b), as a fifth etching, the exposed protective insulating film 1070 is patterned with a dry etching method by using the reformed third resist 1071 and an etching gas (CHF (CF₄, CHF₃ gas, or the like), whereby the pixel electrode 1067, the drain wire pad 1068 and the gate wire pad 1025 are exposed (Step S1010a). Next, the reformed third resist 1071 is removed through an ashing process, whereby, as shown in FIG. 11, the protective insulating film 1070 stacked above the drain electrode 1064, the source electrode 1063, the source wire 1065 and the drain wire 1066 is exposed on the glass substrate 1010.
The drain electrode 1064, the gate electrode 1023, the channel part 1044, the source electrode 1063, the source wire 1065 and the pixel electrode 1067 shown in FIG. 10(b) are cross-sectional views taken along line H-H in FIG. 11. The drain wire pad 1068 shown in FIG. 10(b) is a cross-sectional view taken along line I-I in FIG. 11. The gate wire pad 1025 is a cross-sectional view taken along line J-J in FIG. 11.

As is apparent from the above, according to the method for producing the TFT substrate 1001a in this embodiment, not only advantageous effects almost similar to those attained in the first embodiment are attained but also operation stability of a TFT can be improved by covering the upper parts of the source electrode 1063, the drain electrode 1064, the source wire 1065 and the drain wire 1066 with the protective insulating film 1070.
In this embodiment, the side part of each of the source electrode 1063, the drain electrode 1064, the source wire 1065 and the drain wire 1066 is exposed. It is possible to cover these side parts with the protective insulating film 1070.
Then, the method for covering the side part of each of the source electrode 1063, the drain electrode 1064, the source wire 1065 and the drain wire 1066 with the protective insulating film 1070 will be explained with referring to the drawing.

### [Application example of the second embodiment of the method for producing a TFT substrate]

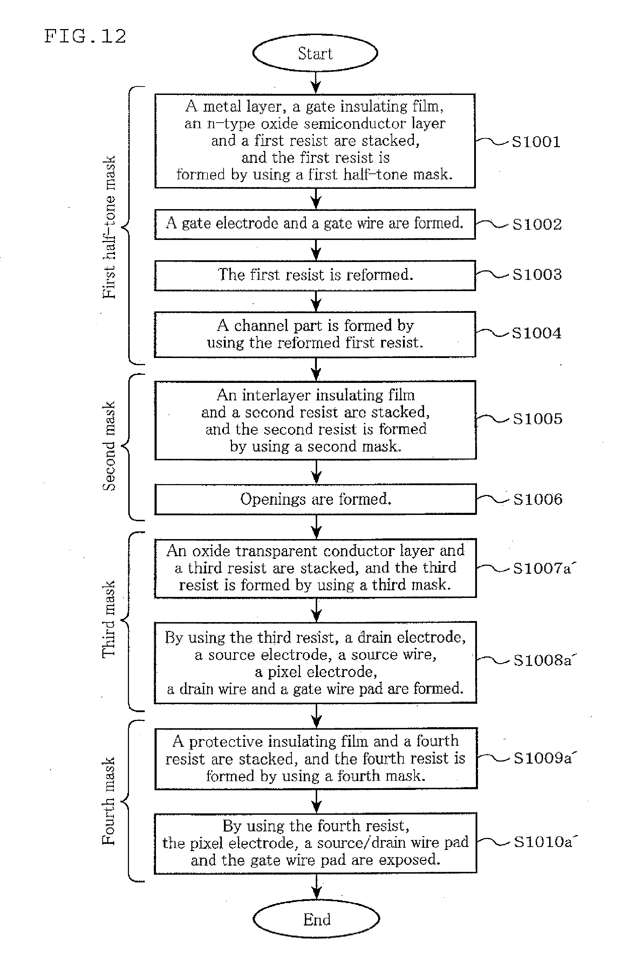

FIG. 12 is a schematic flow chart for explaining an application example in the method for producing a TFT substrate according to the second embodiment of the invention. The method for producing in this application example corresponds to claim 26.
The method for producing the TFT substrate 1001a' according to this application example shown in FIG. 12 differs from the above-mentioned method according to the second embodiment in the following points. Specifically, steps S1007a, S1008a, S1009a and S1010a of the second embodiment are changed as follows. That is, the oxide transparent conductor layer 1060 and a third resist 1061a'are stacked, and the third resist 1061a'is formed by using a third mask 1062a' (Step S1007a'). Further, by using the third resist 1061a', the drain electrode 1064, the source electrode 1063, the source wire 1065, the pixel electrode 1067, the drain wire 1066 and the gate wire pad 1025 are formed (Step S1008a'). Then, the protective insulating film 1070 and a fourth resist 1071a' are stacked (Step S1009a'). Further, by using the fourth resist 1071a', the pixel electrode 1067, the drain wire pad 1068 and the gate wire pad 1025 are exposed (Step S1010a'). That is, the method shown in FIG. 12 differs from the above-mentioned second embodiment in these points.
Other steps are almost the same as those in the second embodiment. Therefore, in the drawing, the same steps are indicated by the same numerals as used in the second embodiment, and detailed explanation is omitted.

The treatment by using the first half-tone mask and the treatment by using the second mask shown in FIG. 12 are almost the same as those in the first embodiment.
After these treatments, as shown in FIG. 12, the oxide transparent conductor layer 1060 and the third resist 1061a' are stacked, and the third resist 1061a' is formed into a predetermined shape by using a third mask 1062a' (Step S1007a').
Next, treatment using the third mask 1062a' will be explained below referring to the drawing.

### (Treatment using a third mask)

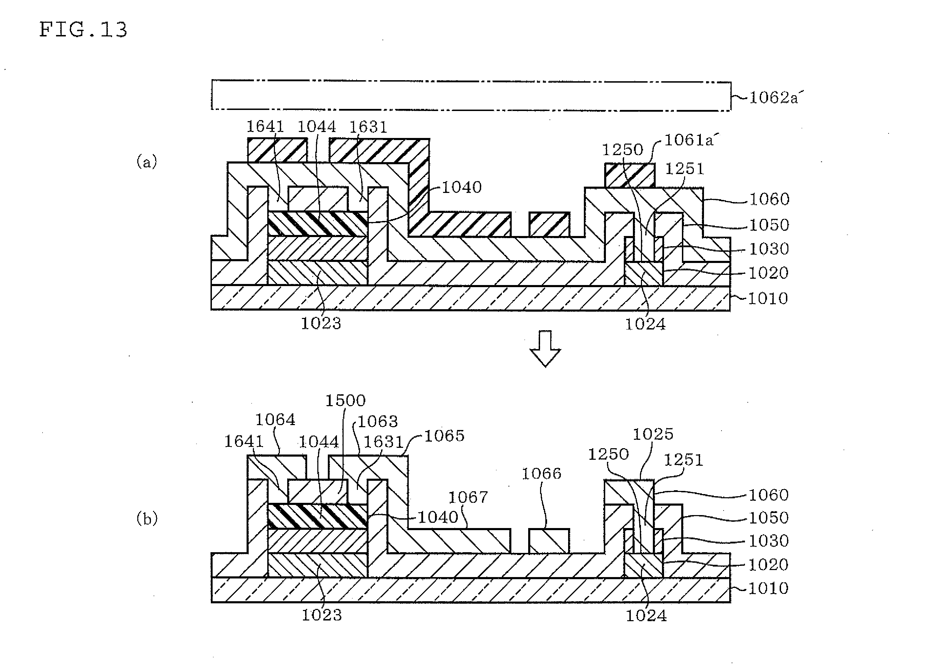

FIG. 13 is a schematic view for explaining treatment using a third mask in the application example of the method for producing a TFT substrate according to the second embodiment of the invention, in which (a) is a cross-sectional view after the formation of an oxide transparent conductor layer/after the application of a third resist/after exposure/after development; and (b) is a cross-sectional view after fourth etching/after peeling off the third resist.
In FIG. 13(a), first, as in the case of the second embodiment, the oxide transparent conductor layer 1060 is formed in a thickness of about 120 nm on the interlayer insulating film 1050, the n-type oxide semiconductor layer 1040 and the metal layer 1020, which are exposed, by using an indium oxide-zinc oxide (In₂O₃:ZnO=about 90:10 wt%) target. This layer formation is conducted under the condition of an oxygen-to-argon ratio of about 10:90 (vol%) and a substrate temperature of about 150°C.

Next, the third resist 1061a' is applied on the oxide transparent conductor layer 1060, and the third resist 1061a' is formed into a predetermined shape by using the third mask 1062a' (Step S1007a'). That is, the third mask 1062a' is formed in such a shape that it covers the drain electrode 1064, the source electrode 1063, the source wire 1065, the drain wire 1066, the pixel electrode 1067 and the gate wire pad 1025 (see FIG. 13(b)).

Subsequently, as shown in FIG. 13(b), as a fourth etching, the oxide transparent conductor layer 1060 is patterned with an etching method by using the third resist 1061a' and an etching solution (an aqueous oxalic acid solution), whereby the drain electrode 1064, the source electrode 1063, the source wire 1065, the pixel electrode 1067, the drain wire 1066 and the gate wire pad 1025 are formed (Step S1008a').

Next, as shown in FIG. 12, the protective insulating film 1070 and the fourth resist 1071a' are stacked, and the fourth resist 1071a' is formed into a predetermined shape by using a fourth mask 1072a' (Step S1009a').
Next, treatment using the fourth mask 1072a' will be explained below referring to the drawing.

### (Treatment using a fourth mask)

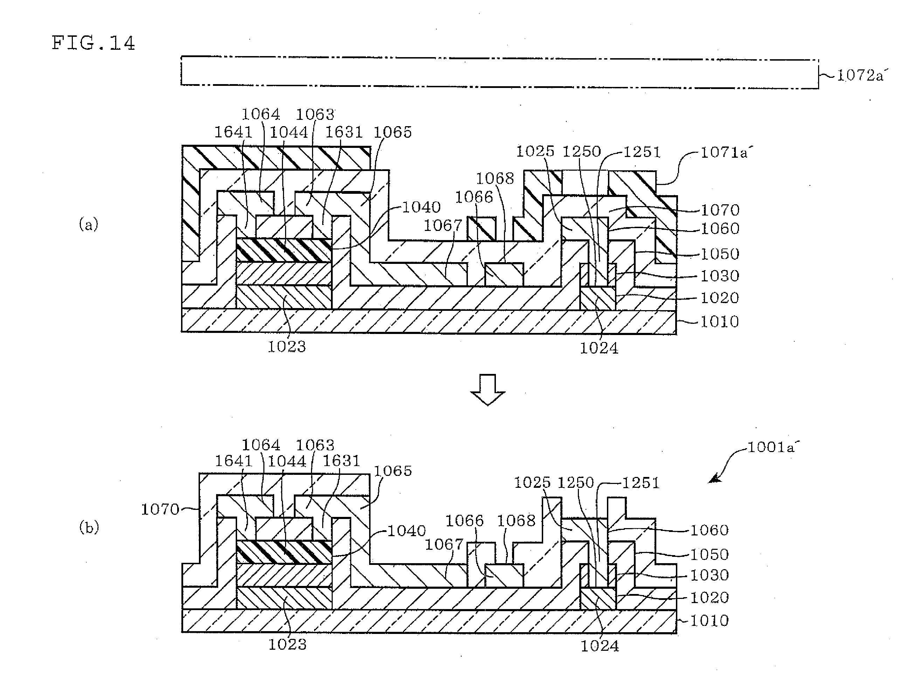

FIG. 14 is a schematic view for explaining treatment using a fourth mask in the application example of the method for producing a TFT substrate according to the second embodiment of the invention, in which (a) is a cross-sectional view after the formation of a protective insulating film/after the application of a fourth resist/after exposure/after development; and (b) is a cross-sectional view after fifth etching/after peeling off the fourth resist.
In FIG. 14(a), first, the protective insulating film 1070, which is a silicon nitride (SiNₓ) film, is deposited in a thickness of about 200 nm by the glow discharge CVD (Chemical Vapor Deposition) method on the interlayer insulating film 1050 and the oxide transparent conductor layer 1060. In this embodiment, an SiH₄-NH₃-N₂-based mixed gas is used as a discharge gas.
Next, the fourth resist 1071a' is applied on the protective insulating film 1070, and the fourth resist 1071a' is formed into a predetermined shape by using the fourth mask 1072a' (Step S1009a'). That is, the fourth resist 1071a' is formed in such a shape that protective insulating film 1070 above the pixel electrode 1067, the drain wire pad 1068 and the gate wire pad 1025 is exposed (Step S1009a').

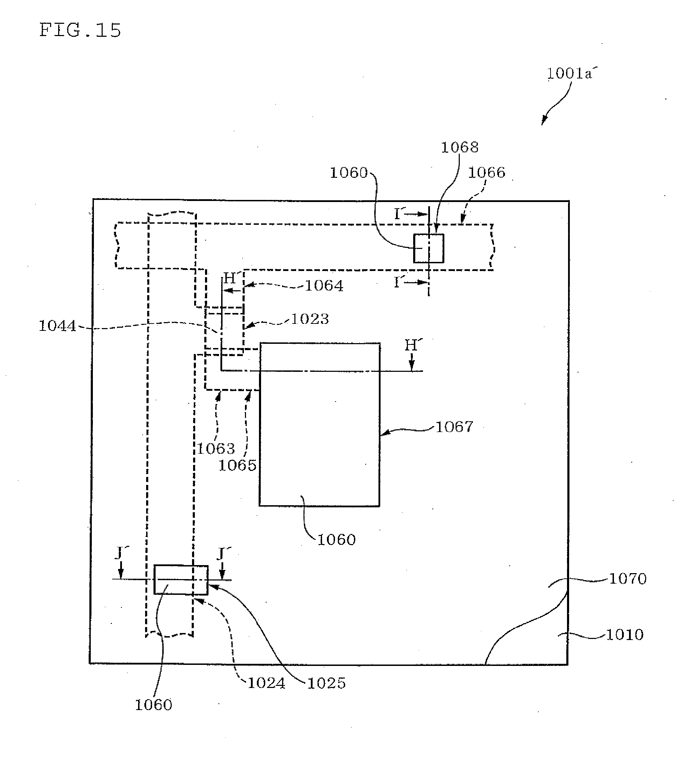

Next, as shown in FIG. 14(b), as a fifth etching, the exposed protective insulating film 1070 is patterned with a dry etching method by using the fourth resist 1071a' and an etching gas (CHF (CF₄, CHF₃ gas, or the like), whereby the pixel electrode 1067, the drain wire pad 1068 and the gate wire pad 1025 are exposed (Step S1010a'). Next, the fourth resist 1071a' is removed through an ashing process. As a result, as shown in FIG. 15, the protective insulating film 1070 is exposed on the glass substrate 1010. The drain electrode 1064, the gate electrode 1023, the channel part 1044, the source electrode 1063, the source wire 1065 and the pixel electrode 1067 shown in FIG. 14(b) are cross-sectional views taken along line H'-H' in FIG. 15. The drain wire pad 1068 shown in FIG. 14(b) is a cross-sectional view taken along line I'-I' in FIG. 15. The gate wire pad 1025 shown in FIG. 14(b) is a cross-sectional view taken along line J'-J' in FIG. 15.

As is apparent from the above, according to the method for producing the TFT substrate 1001a' in this application example, advantageous effects almost similar to those attained in the second embodiment can be attained. Further, the source electrode 1063, the drain electrode 1064, the source wire 1065 and the drain wire 1066 are covered with the protective insulating film 1070 so as not to be exposed. In addition, the TFT substrate 1001a' is provided with the protective insulating film 1070. As a result, it is possible to provide the TFT substrate 1001a' capable of producing readily a display means or an emitting means utilizing a liquid crystal, an organic EL material or the like.

### [Method for producing a TFT substrate according to a third embodiment]

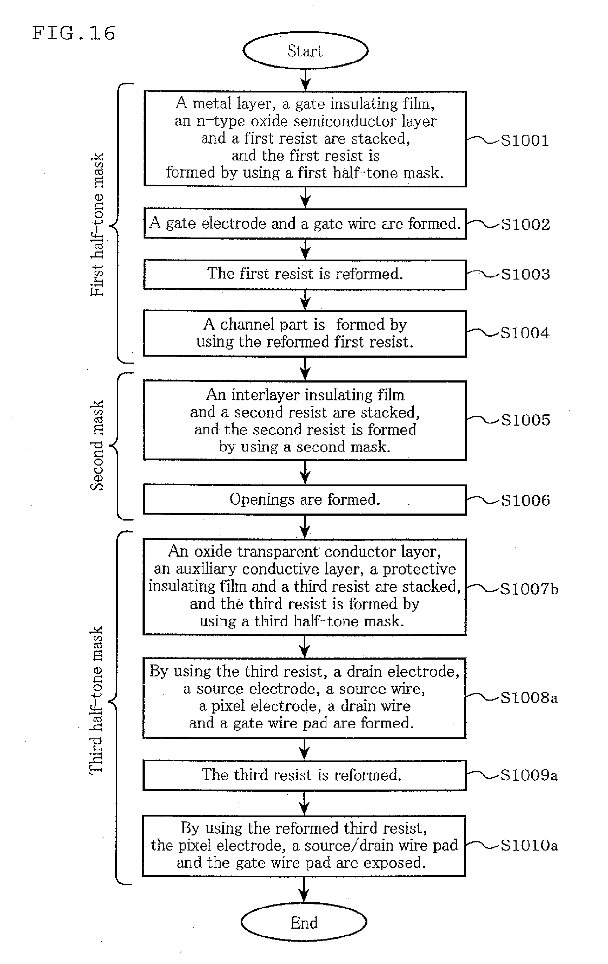

FIG. 16 is a schematic flow chart for explaining the method for producing a TFT substrate according to a third embodiment of the invention. The method for producing a TFT substrate in this embodiment corresponds to claim 27.
The method for producing the TFT substrate 1001b according to this embodiment shown in FIG. 16 differs from the above-mentioned method according to the second embodiment in the following point. Specifically, step S1007a of the second embodiment is changed as follows. That is, the oxide transparent conductor layer 1060, an auxiliary conductive layer 1080, the protective insulating film 1070 and the third resist 1071 are stacked, and the third resist 1071 is formed by using the third half-tone mask 1072 (Step S1007b). That is, the method shown in FIG. 16 differs from the above-mentioned second embodiment in this point.
Other steps are almost the same as those in the second embodiment. Therefore, in the drawing, the same steps are indicated by the same numerals as used in the second embodiment, and detailed explanation is omitted.

The treatment by using the first half-tone mask and the treatment by using the second mask shown in FIG. 16 are almost the same as those in the first embodiment.
After these treatments, as shown in FIG. 16, the oxide transparent conductor layer 1060, the auxiliary conductive layer 1080, the protective insulating film 1070 and the third resist 1071 are stacked, and the third resist 1071 is formed into a predetermined shape by using a third half-tone mask 1072 by half-tone exposure (Step S1007b).
Next, treatment using the third half-tone mask 1072 will be explained below referring to the drawing.

### (Treatment using a third half-tone mask)

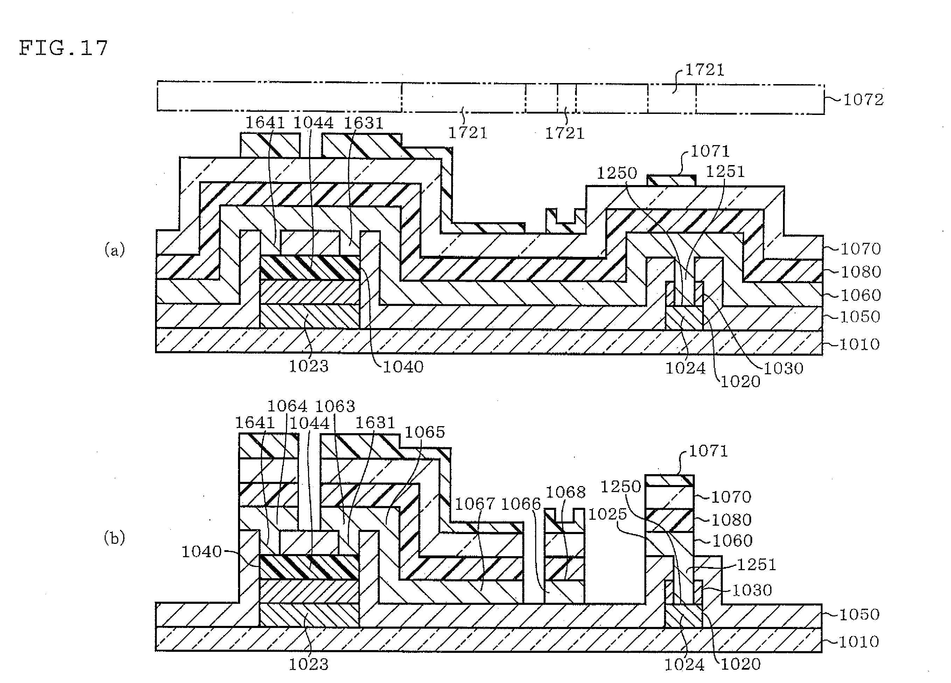

FIG. 17 is a schematic view for explaining treatment using a third half-tone mask in the method for producing a TFT substrate according to the third embodiment of the invention, in which (a) is a cross-sectional view after the formation of an oxide transparent conductor layer/after the formation of an auxiliary conductor layer/after the formation of a protective insulating film/after the application of a third resist/after half-tone exposure/after development; and (b) is a cross-sectional view after fourth etching.
In FIG. 17(a), first, almost as in the case of the second embodiment, the oxide transparent conductor layer 1060 is formed in a thickness of about 120 nm on the interlayer insulating film 1050, the n-type oxide semiconductor layer 1040 and the metal layer 1020, which are exposed, by using an indium oxide-zinc oxide-tin oxide (In₂O₃:ZnO:SnO₂=about 60:20:20 wt%) target. This layer formation is conducted under the condition of an oxygen-to-argon ratio of about 99:1 (vol%) and a substrate temperature of about 150°C.

The oxide transparent conductor layer 1060 composed of indium oxide-zinc oxide-tin oxide is advantageous since it is dissolved in an aqueous oxalic acid solution but is not dissolved in an acid mixture, though it is amorphous.
In this case, the oxide transparent conductor layer 1060 may contain tin oxide in an amount of about 10 to 40 wt%, zinc oxide in an amount of 10 to 40 wt% and indium oxide in an amount that makes up the remainder. If each of tin oxide and zinc oxide is contained in an amount of less than about 10 wt%, the oxide transparent conductor layer 1060 may lose resistance to an acid mixture, and as a result, it may be dissolved in an acid mixture. If the amount of tin oxide exceeds approximately 40 wt%, the oxide transparent conductor layer 1060 may not be dissolved in an aqueous oxalic acid solution or may have a high specific resistance. Further, if the amount of zinc oxide exceeds approximately 40 wt%, the oxide transparent conductor layer 1060 may lose resistance to an acid mixture. The amount ratio of tin oxide and zinc oxide may be selected appropriately.

The oxide transparent conductor layer 1060 is not limited to an oxide transparent conductor layer based on indium oxide-zinc oxide-tin oxide. Usable oxide transparent conductor layers include those which can be patterned with an etching method with an aqueous oxalic acid solution and are not dissolved in an acid mixture. In this case, even though an oxide transparent conductor layer is dissolved in an aqueous oxalic acid solution or in an acid mixture in the amorphous state, it becomes usable if the film condition is changed from the amorphous state to the crystallized state by heating or other methods so as to be insoluble in an acid mixture.
Examples of such an oxide transparent conductor layer include those obtained by incorporating tin oxide, germanium oxide, zirconium oxide, tungsten oxide, molybdenum oxide or an oxide containing a lanthanoide-based element such as cerium oxide, into indium oxide. Of these, combination of indium oxide and tin oxide, combination of indium oxide and tungsten oxide or combination of indium oxide and an oxide containing a lanthanoide-based element such as cerium oxide may preferably be used. The amount of the metal to be added as against indium oxide is about 1 to 20 wt%, preferably about 3 to 15 wt%. The reason therefor is as follows. If the amount of the metal added is less than about 1 wt%, the oxide transparent conductor layer may not be used preferably since it is crystallized during film formation, and as a result, is not dissolved in an aqueous oxalic acid solution or has a large specific resistance.
If the amount exceeds approximately 20 wt%, when an attempt is made to change the film condition, such as crystallization by heating or the like, the film condition is not changed, and as a result, the oxide transparent conductor layer is dissolved in an acid mixture, leading to difficulty in formation of the pixel electrode or other problems.
In addition, the oxide transparent conductor layer composed of an oxide containing a lanthanoide-based element such as indium oxide-tin oxide-samarium oxide is amorphous when formed at room temperature and can be dissolved in an aqueous oxalic acid solution or an acid mixture. However, if crystallized by heating or the like, the oxide transparent conductor layer becomes insoluble in an aqueous oxalic acid solution or an acid mixture, and can be used preferably.

Subsequently, the auxiliary conductive layer 1080 is formed on the oxide transparent conductor layer 1060. First, by using the high-frequency sputtering method, Mo is formed on the oxide transparent conductor layer 1060 in a thickness of about 50 nm. Subsequently, by using the high-frequency sputtering method, Al is formed in a thickness of about 250 nm. That is, though not shown, the auxiliary conductive layer 1080 is formed of a Mo thin film layer and an Al thin film layer. First, the Mo thin film layer is formed by the high-frequency sputtering method using a Mo target in an atmosphere of argon 100%. Then, the Al thin film layer is formed by the high-frequency sputtering method using an Al target in an atmosphere of argon 100%.
Meanwhile, instead of the above-mentioned Mo, Ti, Cr or the like may be used. Although Al may be pure Al (Al with a purity of almost 100%), a metal such as Nd (neodymium), Ce (cerium), Mo, W (tungsten) and Nb (niobium) may be added. A metal such as Ce, W and Nb is preferable to suppress a cell reaction with the oxide transparent conductor layer 1060. The added amount can be appropriately selected, but preferably about 0.1 to 2 wt%. If the contact resistance between the Al and the oxide transparent conductor layer 1060 is negligibly low, it is not required to use a metal such as Mo in an intermediate layer.
In this embodiment, the Mo thin film layer and the Al thin film layer are used as the auxiliary conductive layer 1080. However, the thin films for the auxiliary conductive layer 1080 are not limited to these. For example, an oxide transparent conductor layer composed of indium oxide-tin oxide (In₂O₃:SnO=about 90:10 wt%) or the like may be used as the auxiliary conductive layer 1080.

Next, the protective insulating film 1070, which is a silicon nitride (SiNₓ) film, is deposited in a thickness of about 200 nm by the glow discharge CVD (Chemical Vapor Deposition) method on the auxiliary conductive layer 1080. In this embodiment, an SiH₄-NH₃-N₂-based mixed gas is used as a discharge gas.

Next, as shown in FIG. 17(a), the third resist 1071 is applied on the protective insulating film 1070, and the third resist 1071 is formed into a predetermined shape with the third half-tone mask 1072 by half-tone exposure (Step S1007b). That is, the third resist 1071 is formed in such a shape that it covers the drain electrode 1064, the source electrode 1063, the source wire 1065, the drain wire 1066, the pixel electrode 1067 and the gate wire pad 1025. In addition, the third resist 1071 is formed in such a shape that parts of the third resist 1071 covering the pixel electrode 1067, the drain wire pad 1068 and the gate wire pad 1025 are rendered thinner than other parts due to the half-tone mask part 1721 (see FIG 17(b)).

Next, as shown in FIG. 17(b), as a fourth etching, the exposed protective insulating film 1070 is patterned with a dry etching method at first by using the third resist 1071 and an etching gas (CHF (CF₄, CHF₃ gas, or the like). Subsequently, the exposed auxiliary conductive layer 1080 is patterned with an etching method by using the third resist 1071 and an etching solution (an acid mixture). Further, the oxide transparent conductor layer 1060 is patterned with an etching method by using the third resist 1071 and an etching solution (an aqueous oxalic acid solution), whereby the drain electrode 1064, the source electrode 1063, the source wire 1065, the pixel electrode 1067, the drain wire 1066 and the gate wire pad 1025 are formed (Step S1008a).

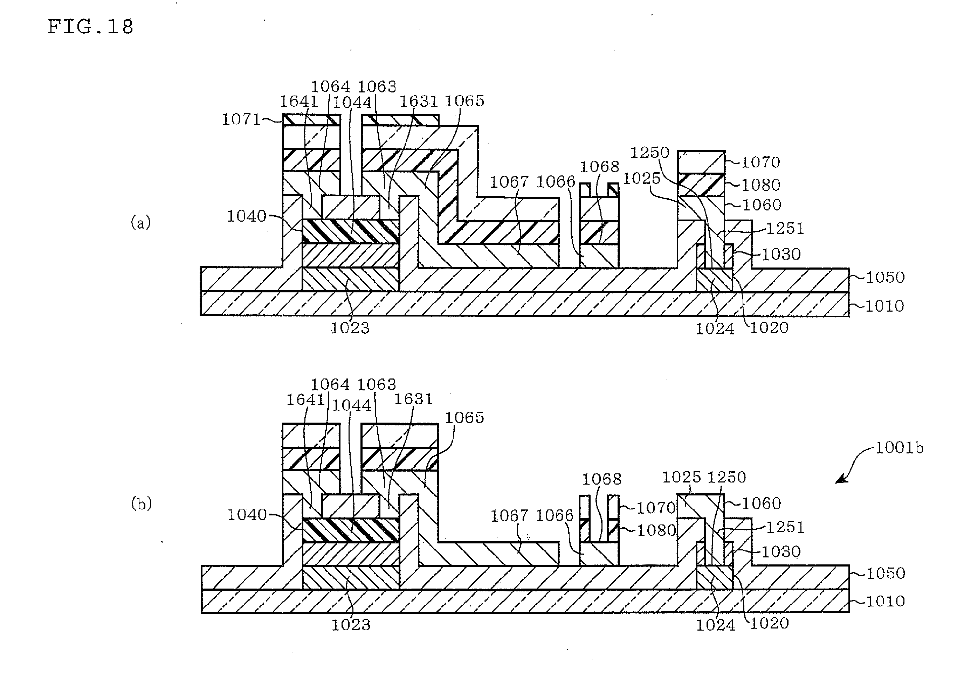

FIG. 18 is a schematic view for explaining treatment using a third half-tone mask in the method for producing a TFT substrate according to the third embodiment of the invention, in which (a) is a cross-sectional view after the reformation of the third resist; and (b) is a cross-sectional view after fifth etching/after peeling off the third resist.
In FIG. 18(a), the above-mentioned third resist 1071 is removed through an ashing process, whereby the third resist 1071 is reformed in such a shape that the protective insulating film 1070 above the pixel electrode 1067, the drain wire pad 1068 and the gate wire pad 1025 is exposed (Step S1009a).

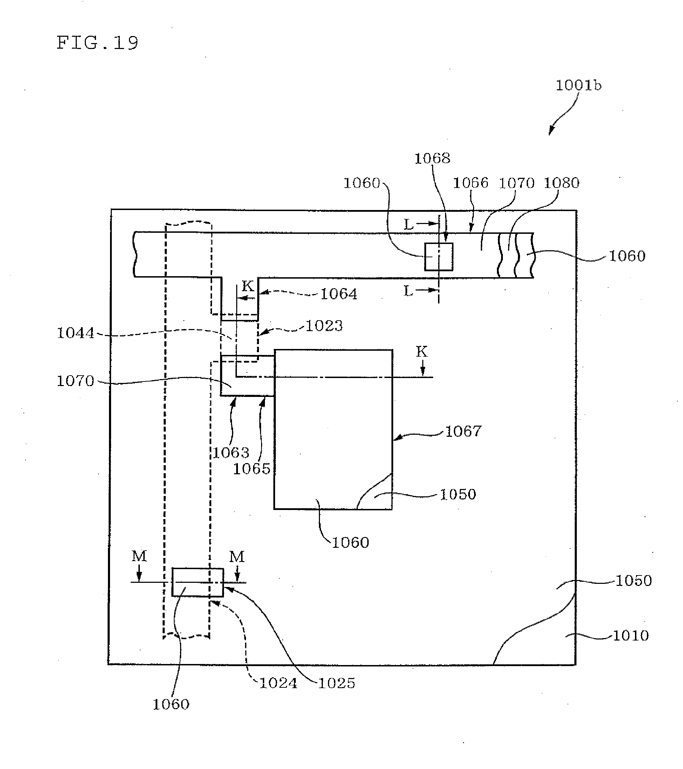

Next, as shown in FIG. 18(b), as a fifth etching, the exposed protective insulating film 1070 is patterned with a dry etching method at first by using the reformed third resist 1071 and an etching gas (CHF (CF₄, CHF₃ gas, or the like). Subsequently, the exposed auxiliary conductive layer 1080 is patterned with an etching method by using the reformed third resist 1071 and an etching solution (an acid mixture), whereby the pixel electrode 1067, the drain wire pad 1068 and the gate wire pad 1025 are exposed (Step S1010a). Then, the reformed third resist 1071 is removed through an ashing process, whereby the protective insulating film 1070 stacked above the drain electrode 1064, the source electrode 1063, the source wire 1065 and the drain wire 1066 is exposed above the glass substrate 1010, as shown in FIG. 19. The drain electrode 1064, the gate electrode 1023, the channel part 1044, the source electrode 1063, the source wire 1065 and the pixel electrode 1067 in FIG. 18(b) are cross-sectional views taken along line K-K in FIG. 19. The drain wire pad 1068 in FIG. 18(b) is a cross-sectional view taken along line L-L in FIG. 19. The gate wire pad 1025 in FIG. 18(b) is a cross-sectional view taken along line M-M in FIG. 19.

As is apparent from the above, according to the method for producing the TFT substrate 1001b in this embodiment, not only advantageous effects almost similar to those attained in the second embodiment are attained but also the auxiliary conductive layer 1080 is formed above the source electrode 1063, the drain electrode 1064, the source wire 1065 and the drain wire 1066. Due to such a configuration, the electric resistance of the source electrode 1063, the drain electrode 1064, the source wire 1065 and the drain wire 1066 can be decreased. As a result, not only reliability can be improved but also a decrease in energy efficiency can be suppressed.
In this embodiment, the side part of each of the source electrode 1063, the drain electrode 1064, the source wire 1065 and the drain wire 1066 is exposed. It is possible to cover these side parts with the protective insulating film 1070.
Then, the method for covering the side part of each of the source electrode 1063, the drain electrode 1064, the source wire 1065 and the drain wire 1066 with the protective insulating film 1070 will be explained with referring to the drawing.

### [Application example of the third embodiment of the method for producing a TFT substrate]

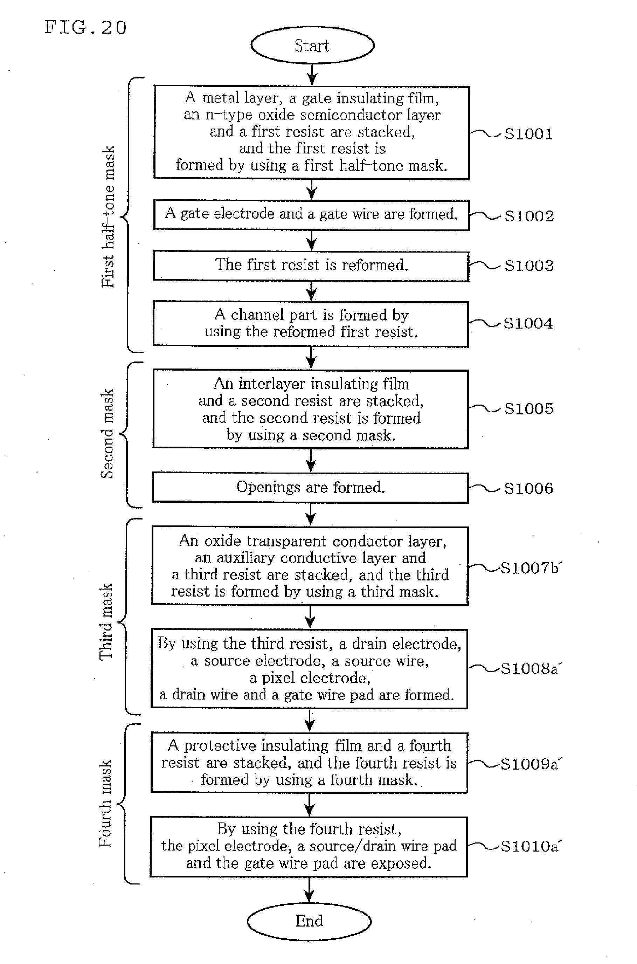

FIG. 20 is a schematic flow chart for explaining an application example in the method for producing a TFT substrate according to the third embodiment of the invention. The method for producing in this application example corresponds to claim 28.
The method for producing the TFT substrate 1001b' according to this application example shown in FIG. 20 differs from the above-mentioned application example of the second embodiment in the following point. Specifically, steps S1007a' in the application example of the second embodiment is changed as follows. That is, the oxide transparent conductor layer 1060, the auxiliary conductive layer 1080 and a third resist 1081b'are stacked (Step S1007b'). The method shown in FIG. 20 differs from the above-mentioned application example of second embodiment in this point.
Other steps are almost the same as those in the application example of the second embodiment. Therefore, in the drawing, the same steps are indicated by the same numerals as used in the application example of the second embodiment, and detailed explanation is omitted.

The treatment by using the first half-tone mask and the treatment by using the second mask shown in FIG. 20 are almost the same as those in the first embodiment.
After these treatments, as shown in FIG. 20, the oxide transparent conductor layer 1060, the auxiliary conductive layer 1080 and the third resist 1081b' are stacked, and the third resist 1081b' is formed into a predetermined shape by using a third mask 1082b' (Step S1007b').
Next, treatment using the third mask 1082b' will be explained below referring to the drawing.

### (Treatment using a third mask)

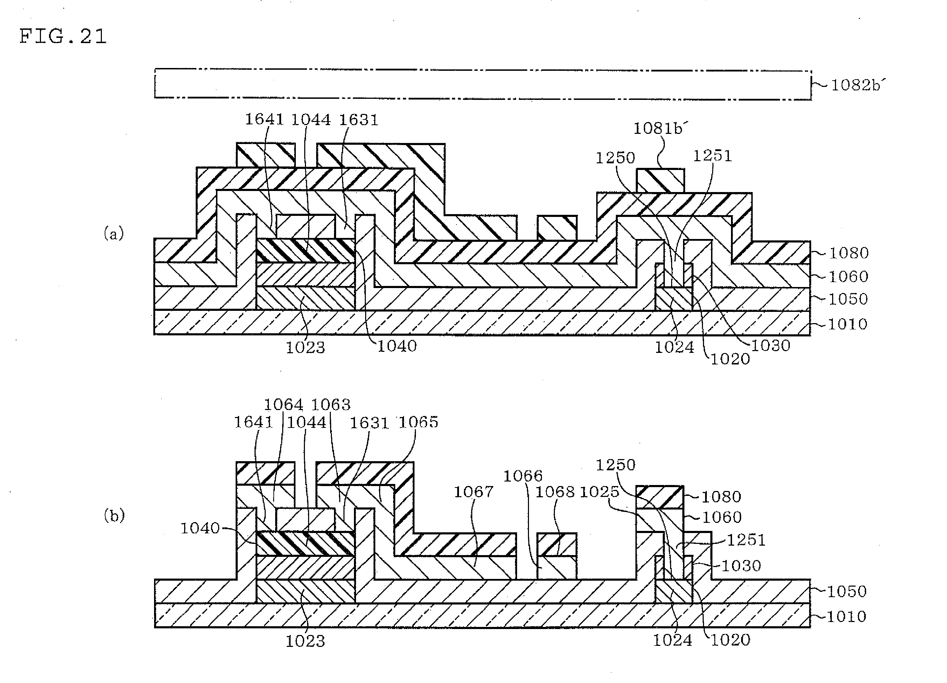

FIG. 21 is a schematic view for explaining treatment using a third mask in the application example of the method for producing a TFT substrate according to the third embodiment of the invention, in which (a) is a cross-sectional view after the formation of an oxide transparent conductor layer/after the formation of an auxiliary conductor layer/after the application of a third resist/after exposure/after development; and (b) is a cross-sectional view after fourth etching/after peeling off the third resist.
In FIG. 21(a), first, almost as in the case of the third embodiment, the oxide transparent conductor layer 1060 is formed in a thickness of about 120 nm on the interlayer insulating film 1050, the n-type oxide semiconductor layer 1040 and the metal layer 1020, which are exposed, by using an indium oxide-zinc oxide-tin oxide (In₂O₃:ZnO:SnO₂=about 60:20:20 wt%) target. This layer formation is conducted under the condition of an oxygen-to-argon ratio of about 99:1 (vol%) and a substrate temperature of about 150°C.
Subsequently, the auxiliary conductive layer 1080 is formed on the oxide transparent conductor layer 1060. Specifically, Mo is deposited at first in a thickness of about 50 nm by using the high-frequency sputtering method. Subsequently, Al is deposited in a thickness of about 250 nm by using the high-frequency sputtering method.

Next, the third resist 1081b' is applied on the auxiliary conductor layer 1080, and the third resist 1081b' is formed into a predetermined shape by using the third mask 1082b' (Step S1007b'). That is, the third mask 1082b' is formed in such a shape that it covers the drain electrode 1064, the source electrode 1063, the source wire 1065, the drain wire 1066, the pixel electrode 1067 and the gate wire pad 1025 (see FIG. 21(b)).

Subsequently, as shown in FIG. 21(b), as a fourth etching, the auxiliary conductor layer 1080 and the oxide transparent conductor layer 1060 are patterned with an etching method by using the third resist 1081b' and an etching solution (an acid mixture), whereby the drain electrode 1064, the source electrode 1063, the source wire 1065, the pixel electrode 1067, the drain wire 1066 and the gate wire pad 1025 are formed (Step S1008a').

Next, as shown in FIG. 20, the protective insulating film 1070 and a fourth resist 1071a' are stacked, and the fourth resist 1071a' is formed into a predetermined shape by using a fourth mask 1072a' (Step S1009a').
Next, treatment using the fourth mask 1072a' will be explained below referring to the drawing.

### (Treatment using a fourth mask)

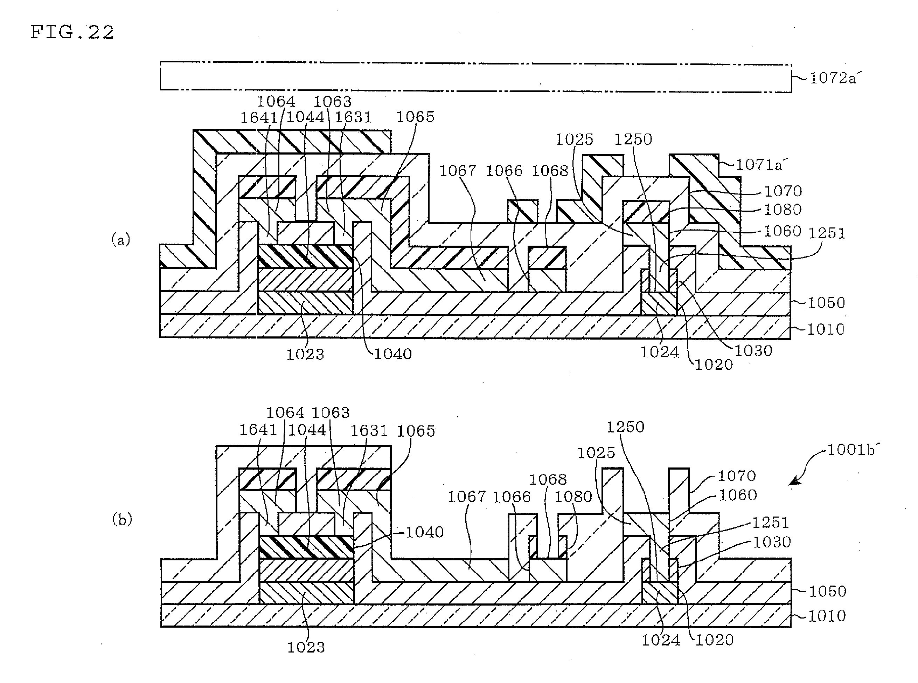

FIG. 22 is a schematic view for explaining treatment using a fourth mask in the application example of the method for producing a TFT substrate according to the third embodiment of the invention, in which (a) is a cross-sectional view after the formation of a protective insulating film/after the application of a fourth resist/after exposure/after development; and (b) is a cross-sectional view after fifth etching/after peeling off the fourth resist.
In FIG. 22 (a), almost as in the case of the application example of the second embodiment, first, the protective insulating film 1070, which is a silicon nitride (SiNₓ) film, is deposited in a thickness of about 200 nm by the glow discharge CVD (Chemical Vapor Deposition) method on the interlayer insulating film 1050 and the auxiliary conductive layer 1080. In this embodiment, an SiH₄-NH₃-N₂-based mixed gas is used as a discharge gas.
Subsequently, the fourth resist 1071a' is applied on the protective insulating film 1070, and the fourth resist 1071a' is formed into a predetermined shape by using the fourth mask 1072a' (Step S1009a'). That is, the fourth resist 1071a' is formed in such a shape that the protective insulating film 1070 above the pixel electrode 1067, the drain wire pad 1068 and the gate wire pad 1025 is exposed (Step S1009a').

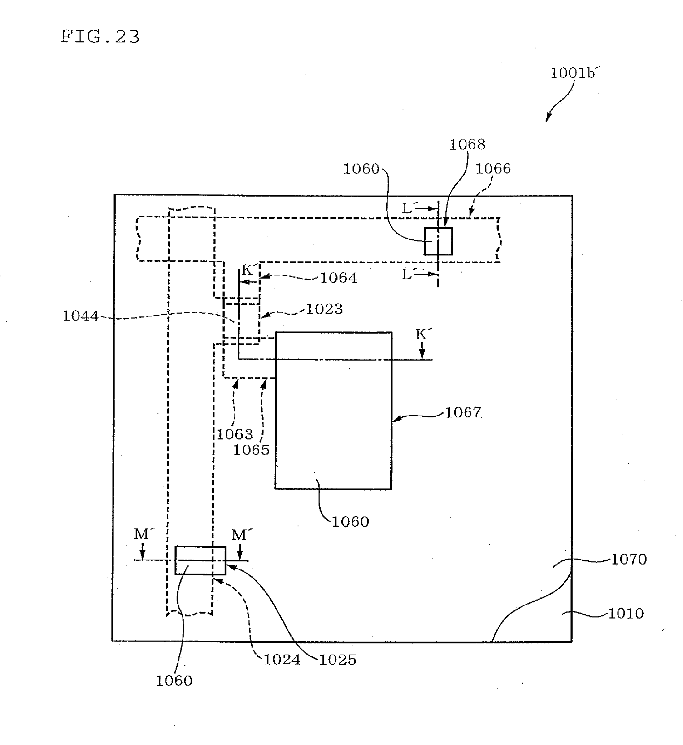

Next, as shown in FIG. 22(b), as a fifth etching, the exposed protective insulating film 1070 is patterned with a dry etching method by using the fourth resist 1071a' and an etching gas (CHF (CF₄, (CHF₃ gas, or the like). Subsequently, the exposed auxiliary conductive layer 1080 is patterned with an etching method by using the fourth resist 1071a' and an etching solution (an acid mixture), whereby the pixel electrode 1067, the drain wire pad 1068 and the gate wire pad 1025 are exposed (Step S1010a'). Then, the fourth resist 1071a'is removed through an ashing process. As a result, as shown in FIG. 23, the protective insulating film 1070 is exposed above the glass substrate 1010. The drain electrode 1064, the gate electrode 1023, the channel part 1044, the source electrode 1063, the source wire 1065 and the pixel electrode 1067 shown in FIG. 22(b) are cross-sectional views taken along line K'-K' in FIG. 23. The drain wire pad 1068 shown in FIG. 22(b) is a cross-sectional view taken along line L'-L' in FIG. 23. The gate wire pad 1025 shown in FIG. 22(b) is a cross-sectional view taken along line M'-M' in FIG. 23.

As is apparent from the above, according to the method for producing the TFT substrate 1001b' in this application example, advantageous effects almost similar to those attained in the third embodiment can be attained. Further, the source electrode 1063, the drain electrode 1064, the source wire 1065 and the drain 1066 are covered with the protective insulating film 1070 so as not to be exposed. In addition, the TFT substrate 1001b' is provided with the protective insulating film 1070. As a result, it is possible to provide the TFT substrate 1001b' capable of producing readily a display means or an emitting means utilizing a liquid crystal, an organic EL material or the like.

### [Method for producing a TFT substrate according to a fourth embodiment]

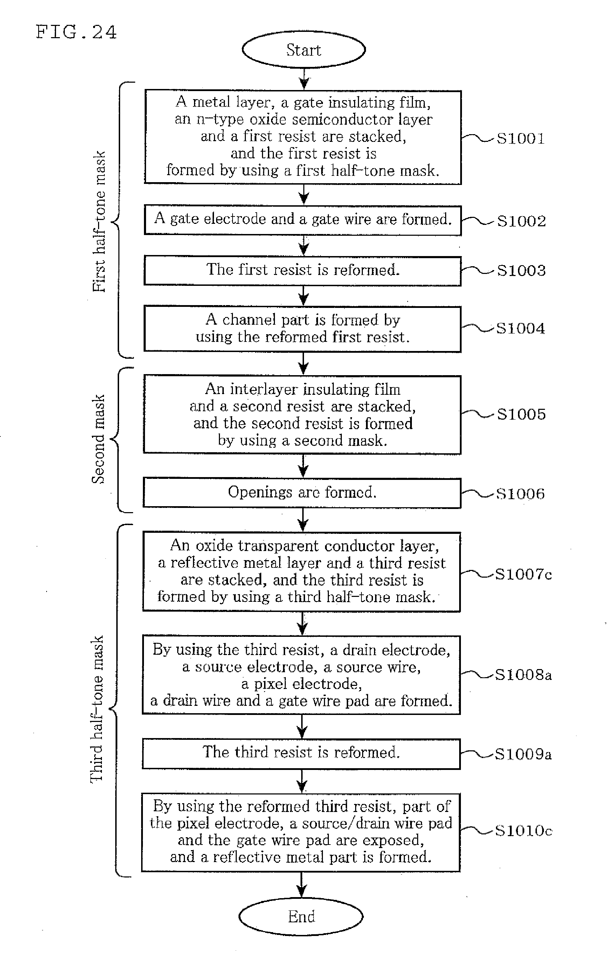

FIG. 24 is a schematic flow chart for explaining the method for producing a TFT substrate according to a fourth embodiment of the invention. The method for producing a TFT substrate in this embodiment corresponds to claim 29.
The method for producing the TFT substrate 1001c according to this embodiment shown in FIG. 24 differs from the above-mentioned method according to the third embodiment in the following point. Specifically, step S1007b of the third embodiment is changed as follows. That is, the oxide transparent conductor layer 1060, a reflective metal layer 1090 and the third resist 1091 are stacked, and the third resist 1091 is formed by using a third half-tone mask 1092 (Step S1007c). In addition, step S1010a of the third embodiment is changed as follows. That is, by using the reformed third resist 1091, part of the pixel electrode 1067, the drain wire pad 1068 and the gate wire pad 1025 are exposed, and a reflective metal part 1094 is formed (Step S1010c). The method shown in FIG. 24 differs from the above-mentioned third embodiment in these points.
Other steps are almost the same as those in the third embodiment. Therefore, in the drawing, the same steps are indicated by the same numerals as used in the third embodiment, and detailed explanation is omitted.

The treatment by using the first half-tone mask and the treatment by using the second mask shown in FIG. 24 are almost the same as those in the first embodiment.
After these treatments, as shown in FIG. 24, the oxide transparent conductor layer 1060, the reflective metal layer 1090 and the third resist 1091 are stacked, and the third resist 1091 is formed into a predetermined shape by using the third half-tone mask 1092 by half-tone exposure (Step S1007c).
Next, treatment using the third half-tone mask 1092 will be explained below referring to the drawing.

### (Treatment using a third half-tone mask)

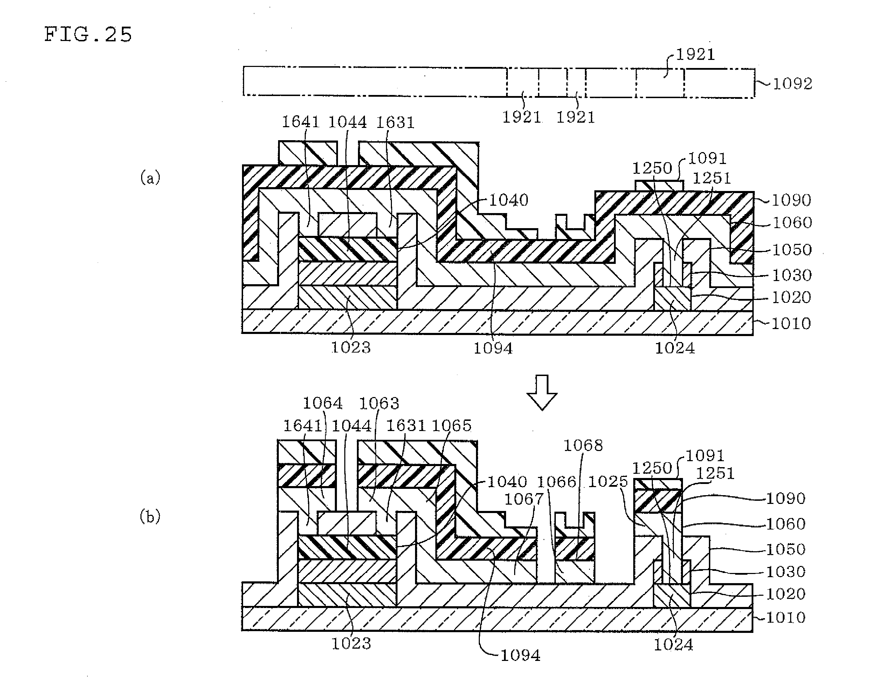

FIG. 25 is a schematic view for explaining treatment using a third half-tone mask in the application example of the method for producing a TFT substrate according to the fourth embodiment of the invention, in which (a) is a cross-sectional view after the formation of an oxide transparent conductor layer/after the formation of a reflective metal layer/after the application of a third resist/after half-tone exposure/after development; and (b) is a cross-sectional view after fourth etching.
In FIG. 25(a), the oxide transparent conductor layer 1060 is formed in a thickness of about 120 nm on the interlayer insulating film 1050, the n-type oxide semiconductor layer 1040 and the metal layer 1020, which are exposed, by using an indium oxide-zinc oxide-tin oxide (In₂O₃:ZnO:SnO₂=about 60:20:20 wt%) target. As mentioned above, the oxide conductor layer composed of indium oxide-tin oxide-zinc oxide is dissolved in an aqueous oxalic acid solution but is not dissolved in an acid mixture, though it is amorphous. Therefore, the above-mentioned oxide conductor layer is advantageous.

Subsequently, the reflective metal layer 1090 is formed on the oxide transparent conductor layer 1060. Specifically, Mo is deposited at first in a thickness of about 50 nm by using the high-frequency sputtering method. Subsequently, Al is deposited in a thickness of about 250 nm by using the high-frequency sputtering method. That is, though not shown, the reflective metal layer 1090 is formed of a Mo thin film layer and an Al thin film layer. First, the Mo thin film layer is formed by the high-frequency sputtering method using a Mo target in an atmosphere of argon 100%. Then, the Al thin film layer is formed by the high-frequency sputtering method using an Al target in an atmosphere of argon 100%. Here, as the metal other than Mo, Ti, Cr or the like may be used. As the reflective metal layer 1090, a thin film of a metal such as Ag and Au or a thin film of an alloy containing at least one of Al, Ag and Au may be used. If the contact resistance between the Al and the oxide transparent conductor layer 1060 is negligibly low, it is not required to use a metal such as Mo in an intermediate layer.

Next, as shown in FIG. 25(a), the third resist 1091 is applied on the reflective metal layer 1090, and the third resist 1091 is formed into a predetermined shape by using the third half-tone mask 1092 and half-tone exposure (Step S1007c). That is, the third resist 1091 is formed in such a shape that it covers the drain electrode 1064, the source electrode 1063, the source wire 1065, the drain wire 1066, the reflective metal part 1094, the pixel electrode 1067 and the gate wire pad 1025. In addition, the third resist 1091 is formed in such a shape that parts of the third resist 1091 covering the part of the pixel electrode 1067 except for the reflective metal part 1094, the drain wire pad 1068 and the gate wire pad 1025 are rendered thinner than other parts due to a half-tone mask part 1921 (see FIG 25(b)).

Subsequently, as shown in FIG. 25(b), as a fourth etching, the exposed reflective metal layer 1090 is patterned with an etching method by using the third resist 1091 and an etching solution (an acid mixture), and, further, the oxide transparent conductor layer 1060 is patterned with an etching method by using the third resist 1091 and an etching solution (an aqueous oxalic acid solution), whereby the drain electrode 1064, the source electrode 1063, the source wire 1065, the pixel electrode 1067, the drain wire 1066 and the gate wire pad 1025 are formed (Step S1008a).

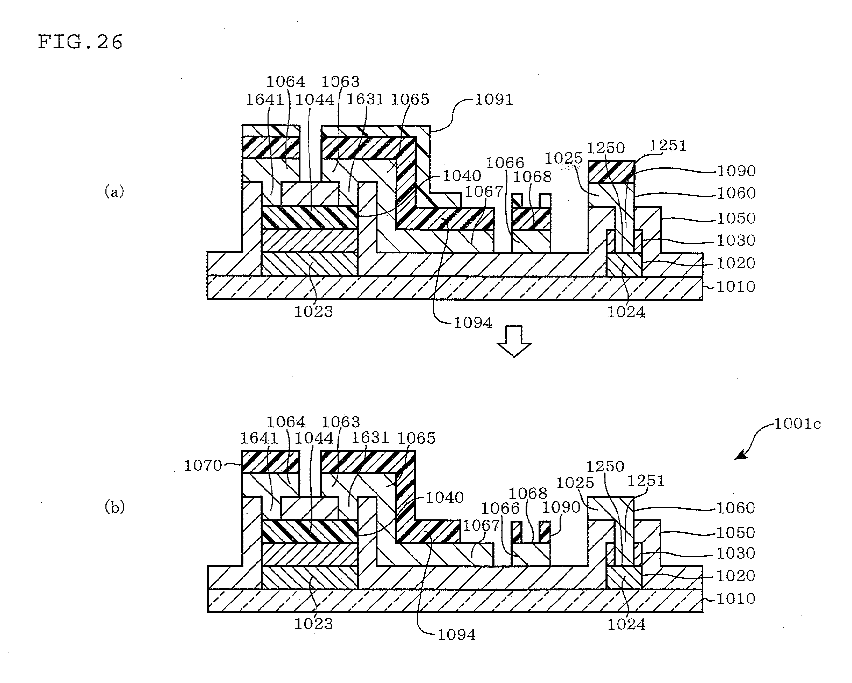

FIG. 26 is a schematic view for explaining treatment using a third half-tone mask in the method for producing a TFT substrate according to the fourth embodiment of the invention, in which (a) is a cross-sectional view after the reformation of a third resist; and (b) is a cross-sectional view after fifth etching/after peeling off the third resist.
In FIG. 26(a), the above-mentioned third resist 1091 is removed through an ashing process, whereby the third resist 1091 is reformed in such a shape that the reflective metal layer 1090 above the part of the pixel electrode 1067 except for the reflective metal part 1094, the drain wire pad 1068 and the gate wire pad 1025 is exposed (Step S1009a).

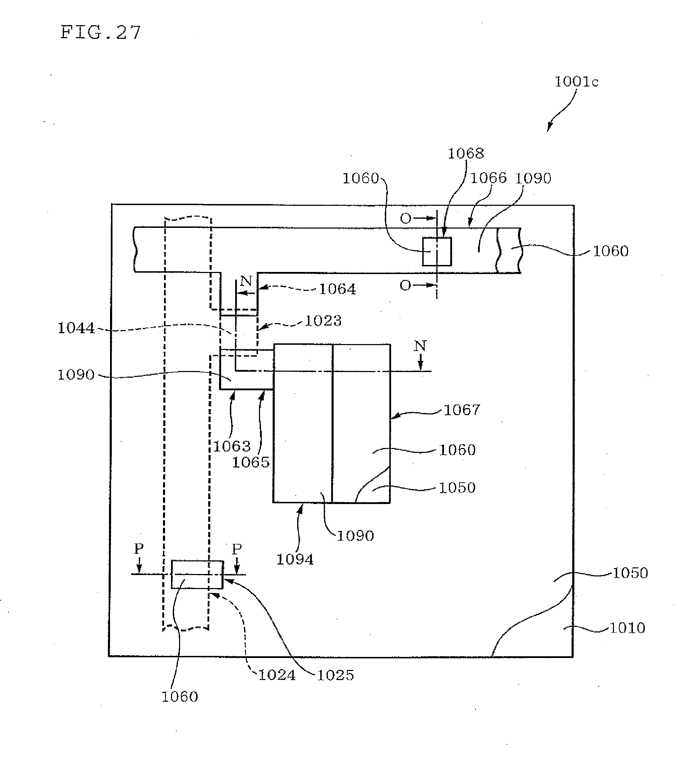

Next, as shown in FIG. 26(b), as a fifth etching, the exposed reflective metal layer 1090 is selectively patterned with an etching method by using the reformed third resist 1091 and an etching solution (an acid mixture), whereby the part of the pixel electrode 1067 except for the reflective metal part 1094, the drain wire pad 1068 and the gate wire pad 1025 are exposed and the reflective metal part 1094 composed of the reflective metal layer 1090 is formed (Step S1010c). Then, the reformed third resist 1091 is removed through an ashing process. As a result, as shown in FIG. 27, the reflective metal layer 1090 stacked on the drain electrode 1064, the source electrode 1063, the source wire 1065 and the drain wire 1066, as well as the reflective metal part 1094 are exposed above the glass substrate 1010. The drain electrode 1064, the gate electrode 1023, the channel part 1044, the source electrode 1063, the source wire 1065, the reflective metal part 1094 and the pixel electrode 1067 shown in FIG. 26(b) are cross-sectional views taken along line N-N in FIG. 27. The drain wire pad 1068 shown in FIG. 26(b) is a cross-sectional view taken along line O-O in FIG. 27. The gate wire pad 1025 shown in FIG. 26(b) is a cross-sectional view taken along line P-P in FIG. 27.

As is apparent from the above, according to the method for producing the TFT substrate 1001c in this embodiment, not only advantageous effects almost similar to those attained in the first embodiment are attained but also a semi-reflective TFT substrate with via hole channels can be produced. Further, since the reflective metal layer 1090 is formed above the source electrode 1063, the drain electrode 1064, the source wire 1065, the reflective metal part 1094 and the drain wire 1066, the electric resistance of the source electrode 1063, the drain electrode 1064, the source wire 1065 and the drain wire 1066 can be decreased. As a result, hot only reliability can be improved but also a decrease in energy efficiency can be suppressed.
In this embodiment, part of the pixel electrode 1067 except for the reflective metal part 1094 is composed of the oxide transparent conductor layer 1060. If light is transmitted through this part, the TFT substrate 1001c can be used as a semi-transmissive TFT substrate.

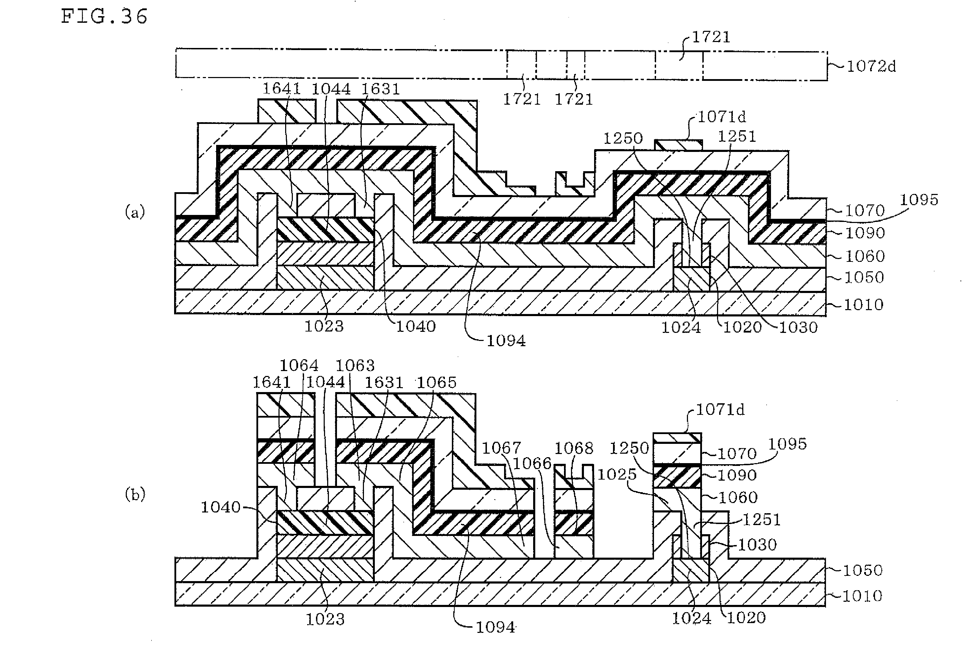

In this embodiment, in Step S1007c, the oxide transparent conductor layer 1060, the reflective metal layer 1090 and the third resist 1091 are stacked, and the third resist 1091 is formed into a predetermined shape by using the third half-tone mask 1092 by half-tone exposure, but not limited thereto. For example, Step S1007c can be changed as follows. The oxide transparent conductor layer 1060, the reflective metal layer 1090, a metal layer-protecting oxide conductor layer 1095 (see FIG. 36(a)) and the third resist 1091 are stacked, and the third resist 1091 is formed into a predetermined shape by using the third half-tone mask 1092 and half-tone exposure. That is, on the reflective metal layer 1090, by using an indium oxide-zinc oxide (In₂O₃:ZnO=about 90:10 wt%) sputtering target, the metal layer-protecting oxide conductor layer 1095 is formed in a thickness of about 50 nm. Here, the IZO film can be patterned by an etched method by an acid mixture, and therefore, the IZO film can be patterned simultaneously with the reflective metal layer 1090 with an etching method. As a result, a TFT substrate in which the metal layer-protecting oxide conductor layer 1095 is formed on the reflective metal layer 1090 can be produced. According to such an application example of the fourth embodiment (not shown), since the reflective metal layer 1090 is protected by the metal layer-protecting oxide conductor layer 1095, discoloration or other problems of the reflective metal layer 1090 can be prevented, and disadvantages such as a decrease in reflectance of the reflective metal layer 1090 can be prevented.

### [Method for producing a TFT substrate according to a fifth embodiment]

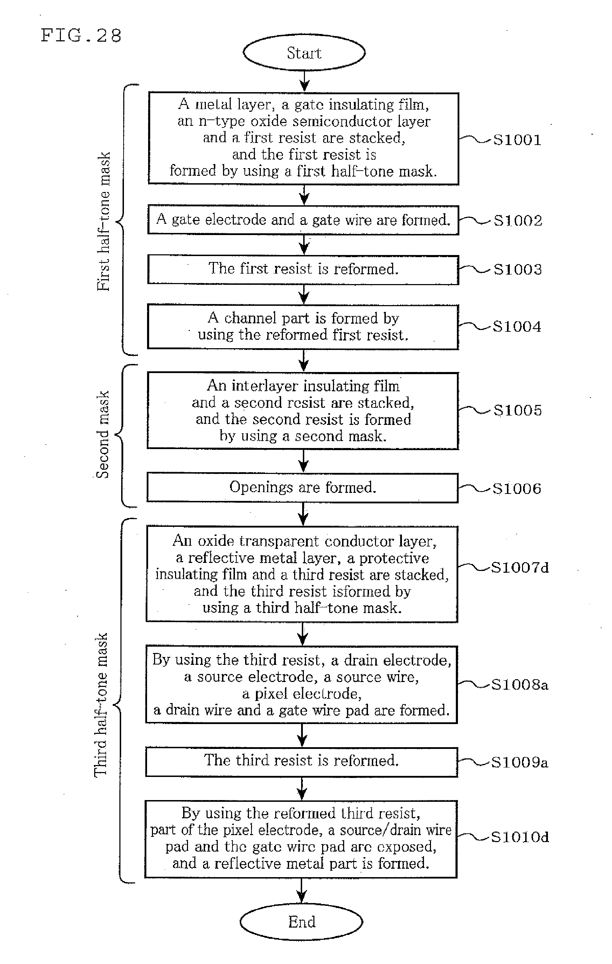

FIG. 28 is a schematic flow chart for explaining the method for producing a TFT substrate according to a fifth embodiment of the invention. The method for producing a TFT substrate in this embodiment corresponds to claim 30.
The method for producing the TFT substrate 1001d according to this embodiment shown in FIG. 28 differs from the above-mentioned method according to the fourth embodiment in the following points. Specifically, steps S1007c and S1010c of the fourth embodiment are changed as follows. The oxide transparent conductor layer 1060, the reflective metal layer 1090, the protective insulating film 1070 and the third resist 1071d are stacked, and the third resist 1071d is formed by using the third half-tone mask 1072d (Step S1007d). Further, by using the reformed third resist 1071d, part of the pixel electrode 1067, the drain wire pad 1068 and the gate wire pad 1025 are exposed, and the reflective metal part 1094 is formed (Step S1010d). That is, the method shown in FIG. 28 differs from the above-mentioned fourth embodiment in these points.
Other steps are almost the same as those in the fourth embodiment. Therefore, in the drawing, the same steps are indicated by the same numerals as used in the fourth embodiment, and detailed explanation is omitted.

The treatment by using the first half-tone mask and the treatment by using the second mask shown in FIG. 28 are almost the same as those in the first embodiment.
After these treatments, as shown in FIG. 28, the oxide transparent conductor layer 1060, the reflective metal layer 1090, the protective insulating film 1070 and the third resist 1071d are stacked, and the third resist 1071d is formed into a predetermined shape by using a third half-tone mask 1072d by half-tone exposure (Step S1007d).
Next, treatment using the third half-tone mask 1072d will be explained below referring to the drawing.

### (Treatment using a third half-tone mask)

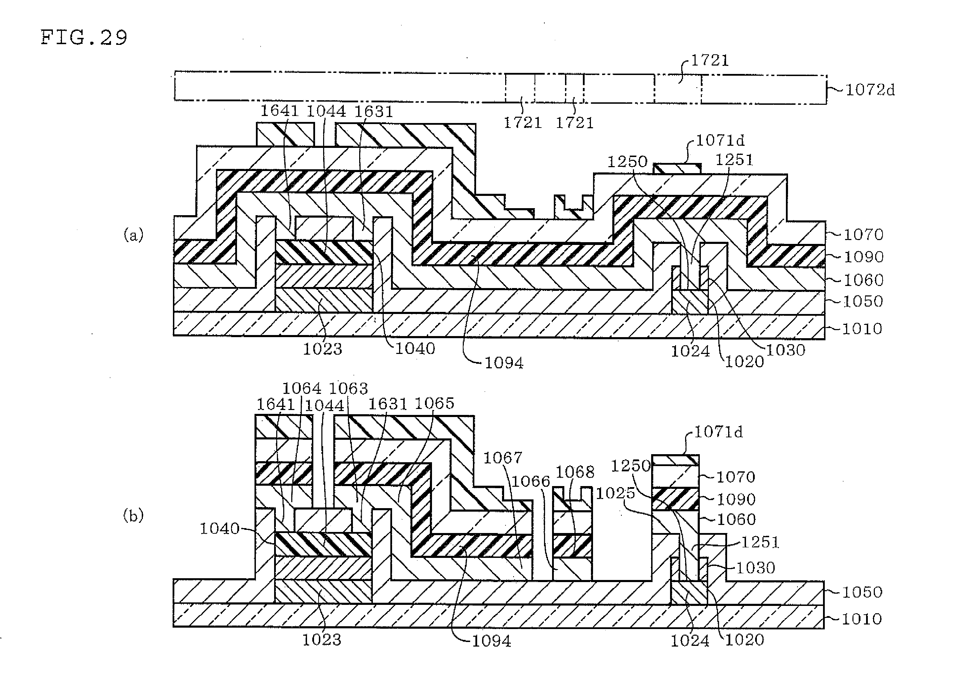

FIG. 29 is a schematic view for explaining treatment using a third half-tone mask of the method for producing a TFT substrate according to the fifth embodiment of the invention, in which (a) is a cross-sectional view after the formation of an oxide transparent conductor layer/after the formation of a reflective metal layer/after the formation of a protective insulating layer/after the application of a third resist/after half-tone exposure/after development; and (b) is a cross-sectional view after fourth etching.
In FIG. 29(a), almost as in the case of the fifth embodiment, the oxide transparent conductor layer 1060 is formed at first by the sputtering method in a thickness of about 120 nm on the interlayer insulating film 1050, the n-type oxide semiconductor layer 1040 and the metal layer 1020, which are exposed, by using an indium oxide-zinc oxide-tin oxide (In₂O₃:ZnO:SnO₂=about 60:20:20 wt%) target. Then, the reflective metal layer 1090 is formed on the oxide transparent conductor layer 1060. That is, first, Mo is deposited a thickness of about 50 nm by the high-frequency sputtering method. Subsequently, Al is deposited in a thickness of about 250 nm by the high-frequency sputtering method. Then, the protective insulating film 1070, which is a silicon nitride (SiNₓ) film, is deposited in a thickness of about 200 nm by the glow discharge CVD (Chemical Vapor Deposition) method on the reflective metal layer 1090. In this embodiment, an SiH₄-NH₃-N₂-based mixed gas is used as a discharge gas.

Next, as shown in FIG. 29(a), the third resist 1071d is applied on the protective insulating film 1070, and the third resist 1071d is formed into a predetermined shape by using the third half-tone mask 1072d and half-tone exposure (Step S1007d). That is, the third resist 1071d is formed in such a shape that it covers the drain electrode 1064, the source electrode 1063, the source wire 1065, the drain wire 1066, the reflective metal part 1094, the pixel electrode 1067 and the gate wire pad 1025. In addition, the third resist 1071d is formed in such a shape that parts of the third resist 1071d covering the part of the pixel electrode 1067 except for the reflective metal part 1094, the drain wire pad 1068 and the gate wire pad 1025 are rendered thinner than other parts due to a half-tone mask part 1721 (see FIG 29(b)).

Next, as shown in FIG. 29(b), as a fourth etching, the exposed protective insulating film 1070 is patterned with a dry etching method by using the third resist 1071d and an etching gas (CHF (CF₄, CHF₃ gas, or the like). Subsequently, the exposed reflective metal layer 1090 is patterned with an etching method by using the third resist 1071d and an etching solution (an acid mixture). Further, the oxide transparent conductor layer 1060 is patterned with an etching method by using the third resist 1071d and an etching solution (an aqueous oxalic acid solution), whereby the drain electrode 1064, the source electrode 1063, the source wire 1065, the pixel electrode 1067, the drain wire 1066 and the gate wire pad 1025 are formed (Step S1008a).

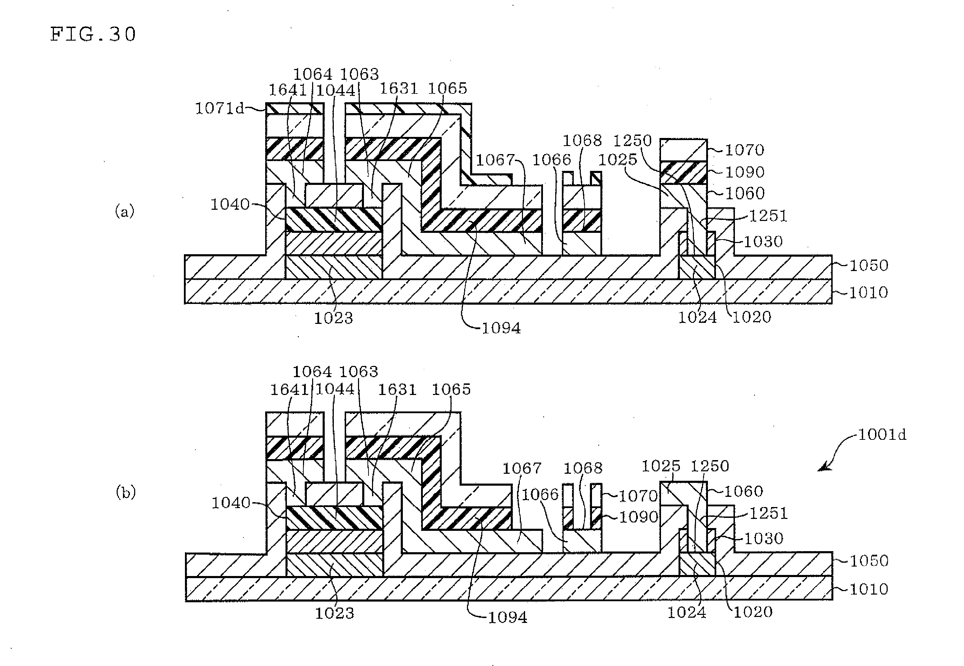

FIG. 30 is a schematic view for explaining treatment using a third-half mask in the method for producing a TFT substrate according to the fifth embodiment of the invention, in which (a) is a cross-sectional view after the reformation of a third resist; and (b) is a cross-sectional view after fifth etching/after peeling off the third resist.
In FIG. 30(a), the above-mentioned third resist 1071d is removed through an ashing process, whereby the third resist 1071d is reformed in such a shape that the reflective metal layer 1090 above the part of the pixel electrode 1067 except for the reflective metal part 1094, the drain wire pad 1068 and the gate wire pad 1025 is exposed (Step S1009a).

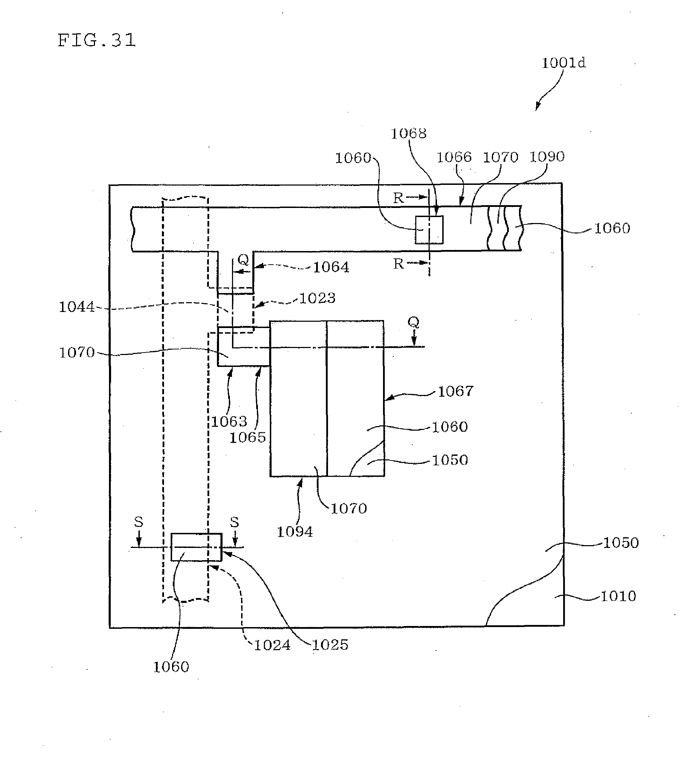

Next, as shown in FIG. 30(b), as a fifth etching, the exposed protective insulating film 1070 is patterned with a dry etching method by using the reformed third resist 1071d and an etching gas (CHF (CF₄, CHF₃ gas, or the like). Subsequently, the exposed reflective metal layer 1090 is selectively patterned with an etching method by using the reformed third resist 1071d and an etching solution (an acid mixture), whereby the part of the pixel electrode 1067 except for the reflective metal part 1094, the drain wire pad 1068 and the gate wire pad 1025 are exposed and the reflective metal part 1094 composed of the reflective metal layer 1090 is formed (Step S1010d). Then, the reformed third resist 1071d is removed through an ashing process.
As a result, as shown in FIG. 31, the protective insulating film 1070 stacked above the drain electrode 1064, the source electrode 1063, the source wire 1065, the reflective metal part 1094 and the drain wire 1066 is exposed above the glass substrate 1010. The drain electrode 1064, the gate electrode 1023, the channel part 1044, the source electrode 1063, the source wire 1065, the reflective metal part 1094 and the pixel electrode 1067 shown in FIG. 30(b) are cross-sectional views taken along line Q-Q in FIG. 31. The drain wire pad 1068 shown in FIG. 30(b) is a cross-sectional view taken along line R-R in FIG. 31. The gate wire pad 1025 shown in FIG. 30(b) is a cross-sectional view taken along line S-S in FIG. 31.

As is apparent from the above, according to the method for producing the TFT substrate 1001d in this embodiment, not only advantageous effects almost similar to those attained in the fourth embodiment are attained but also the upper part of each of the drain electrode 1064, the source electrode 1063, the source wire 1065, the reflective metal part 1094 and the drain wire 1066 is covered with the protective insulating film 1070. Due to such a configuration, operation stability can be improved.
In this embodiment, the side part of each of the source electrode 1063, the drain electrode 1064, the source wire 1065 and the drain wire 1066 is exposed. It is possible to cover these side parts with the protective insulating film 1070.
Then, the method for covering the side parts of each of the source electrode 1063, the drain electrode 1064, the source wire 1065 and the drain wire 1066 with the protective insulating film 1070 will be explained with referring to the drawing.

### [Application example of the fifth embodiment of the method for producing a TFT substrate]

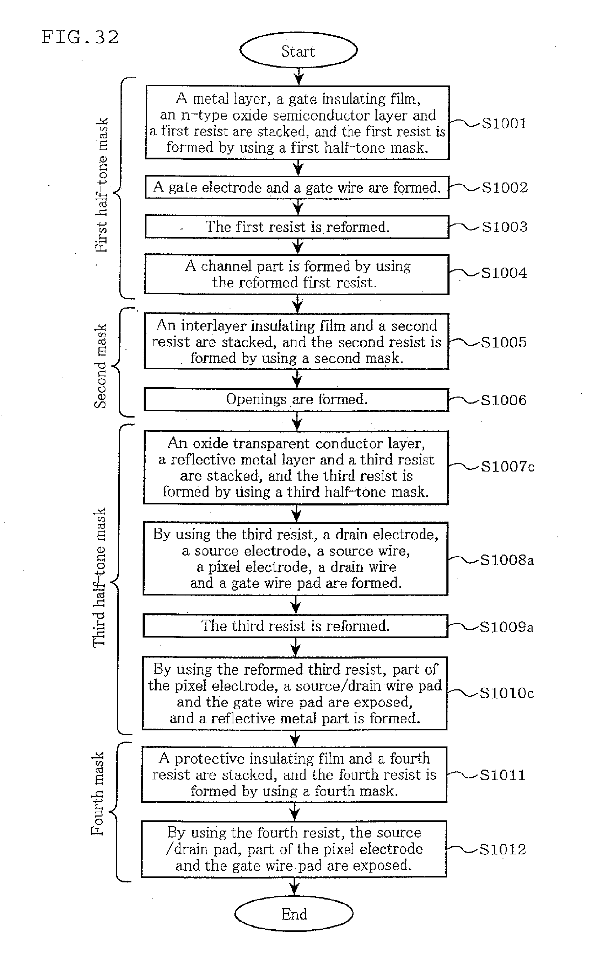

FIG. 32 is a schematic flow chart for explaining an application example in the method for producing a TFT substrate according to the fifth embodiment of the invention. The method for producing in this application example corresponds to claim 31.
The method for producing the TFT substrate 1001d' according to this application example shown in FIG. 32 differs from the above-mentioned fourth embodiment in the following points. Specifically, after step S1010c in the above-mentioned fourth embodiment, the protective insulating film 1070 and a fourth resist 1071d' are stacked, and the fourth resist 1071d' is formed into a predetermined shape by using a fourth mask 1072d' (Step S1011). Further, the drain wire pad 1068, part of the pixel electrode 1067 and the gate wire pad 1025 are exposed by using the fourth resist 1071d' (Step S1012). That is, the method shown in FIG. 32 differs from the above-mentioned fourth embodiment in these points.
Other steps are almost the same as those in the fourth embodiment. Therefore, in the drawing, the same steps are indicated by the same numerals as used in the fourth embodiment, and detailed explanation is omitted.

As shown in FIG. 32, after step S1010c, the protective insulating film 1070 and the fourth resist 1071d' are stacked and the fourth resist 1071d' is formed into a predetermined shape by using the fourth mask 1072d' (Step S1011).
Next, treatment using the fourth mask 1072d' will be explained below referring to the drawing.

### (Treatment using a fourth mask)

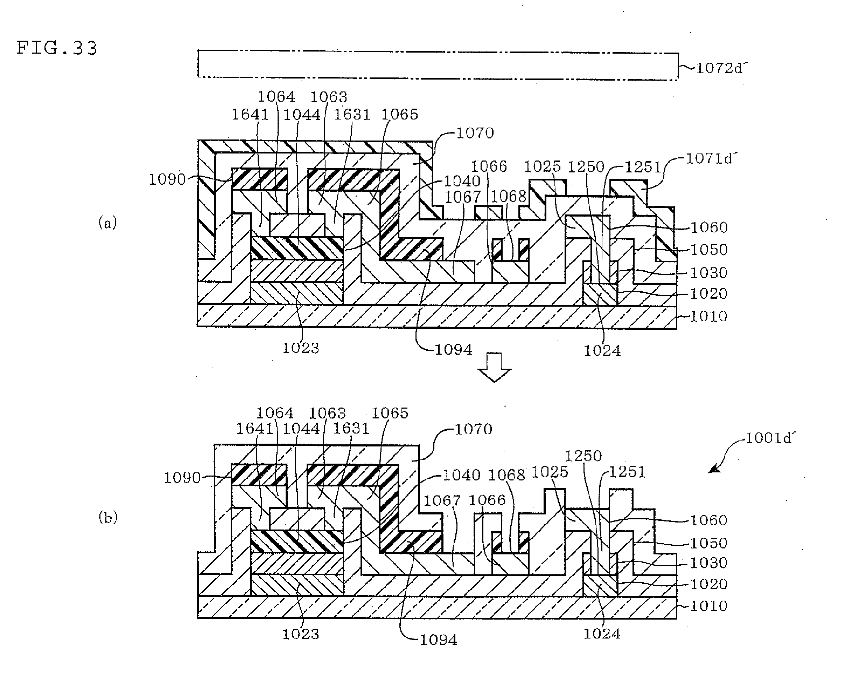

FIG. 33 is a schematic view for explaining treatment using a fourth mask in the application example of the method for producing a TFT substrate according to the fifth embodiment of the invention, in which (a) is a cross-sectional view after the formation of a protective insulating film/after the application of a fourth resist/after exposure/after development; and (b) is a cross-sectional view after a sixth etching/after peeling off the fourth resist.
In FIG. 33(a), first, the protective insulating film 1070, which is a silicon nitride (SiNₓ) film, is deposited in a thickness of about 200 nm by the glow discharge CVD (Chemical Vapor Deposition) method on the interlayer insulating film 1050, the reflective metal layer 1090 and the oxide transparent conductor layer 1060. In this embodiment, an SiH₄-NH₃-N₂-based mixed gas is used as a discharge gas.
Next, the fourth resist 1071d' is applied on the protective insulating film 1070, and the fourth resist 1071d' is formed into a predetermined shape by using the fourth mask 1072d' (Step S1011). That is, the fourth resist 1071d' is formed in such a shape that the protective insulating film 1070 above the part of the pixel electrode 1067 except for the reflective metal part 1094, the drain wire pad 1068 and the gate wire pad 1025 is exposed.

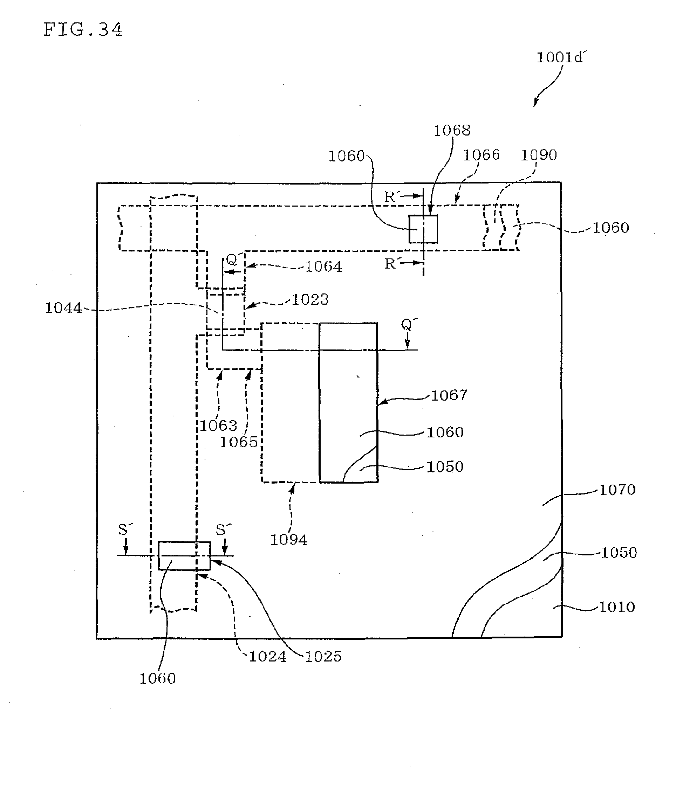

Next, as shown in FIG. 33(b), as a sixth etching, the exposed protective insulating film 1070 is patterned with a dry etching method by using the fourth resist 1071d' and an etching gas (CHF (CF₄, CHF₃ gas, or the like), whereby the part of the pixel electrode 1067 except for the reflective metal part 1094, the drain wire pad 1068 and the gate wire pad 1025 are exposed (Step S1012). Then, the fourth resist 1071d' is removed through an ashing process. As a result, as shown in FIG. 34, the protective insulating film 1070 is exposed above the glass substrate 1010. The drain electrode 1064, the gate electrode 1023, the channel part 1044, the source electrode 1063, the source wire 1065, the reflective metal part 1094 and the pixel electrode 1067 shown in FIG. 33(b) are cross-sectional views taken along line Q'-Q' in FIG. 34. The drain wire pad 1068 shown in FIG. 33(b) is a cross-sectional view taken along line R'-R' in FIG. 34. The gate wire pad 1025 shown in FIG. 33(b) is a cross-sectional view taken along line S'-S' in FIG. 34.

As is apparent from the above, according to the method for producing the TFT substrate 1001d' in this application example, not only advantageous effects almost similar to those attained in the fourth embodiment are attained but also the source electrode 1063, the drain electrode 1064, the source wire 1065 and the drain wire 1066 are covered with the protective insulating film 1070 so as not to be exposed. As a result, the TFT substrate 1001d' is provided with the protective insulating film 1070. Therefore, it is possible to provide a TFT substrate capable of producing readily a display means or an emitting means utilizing a liquid crystal, an organic EL material or the like.

### [Method for producing a TFT substrate according to a sixth embodiment]

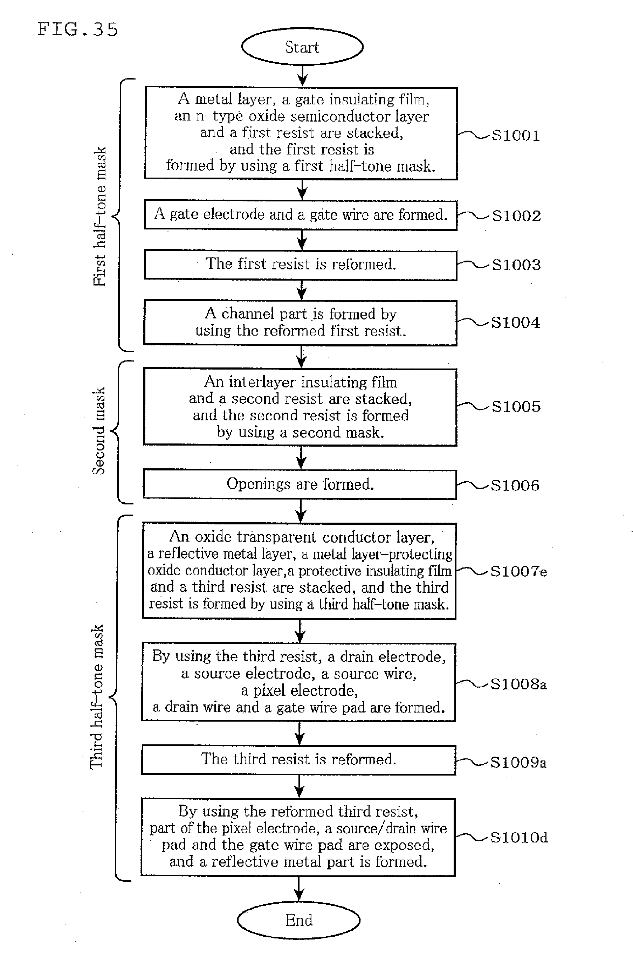

FIG. 35 is a schematic flow chart for explaining the method for producing a TFT substrate according to a sixth embodiment of the invention. The method for producing a TFT substrate in this embodiment corresponds to claims 30 and 32.
The method for producing the TFT substrate 1001e according to this embodiment shown in FIG. 35 differs from the above-mentioned method according to the fifth embodiment in the following point. That is, step S1007d of the fifth embodiment is changed as follows. Specifically, the oxide transparent conductor layer 1060, the reflective metal layer 1090, a metal layer-protecting oxide.conductor layer 1095, the protective insulating film 1070 and the third resist 1071d are stacked, and the third resist 1071d is formed by using a third half-tone mask 1072d (Step S1007e). That is, the method shown in FIG. 35 differs from the above-mentioned fifth embodiment in this point.
Other steps are almost the same as those in the fifth embodiment. Therefore, in the drawing, the same steps are indicated by the same numerals as used in the fifth embodiment, and detailed explanation is omitted.

The treatment by using the first half-tone mask and the treatment by using the second mask shown in FIG. 35 are almost the same as those in the first embodiment.
After these treatments, as shown in FIG. 35, the oxide transparent conductor layer 1060, the reflective metal layer 1090, the metal-layer protecting oxide conductor layer 1095, the protective insulating film 1070 and the third resist 1071d are stacked, and the third resist 1071d is formed into a predetermined shape by using a third half-tone mask 1072d by half-tone exposure (Step S1007e).
Next, treatment using the third half-tone mask 1072d will be explained below referring to the drawing.

### (Treatment using a third mask)

FIG. 36 is a schematic view for explaining treatment using a third half-tone mask of the method for producing a TFT substrate according to the sixth embodiment of the invention, in which (a) is a cross-sectional view after the formation of an oxide transparent conductor layer/after the formation of a reflective metal layer/after the formation of a metal layer-protecting oxide conductor layer/after the formation of a protective insulating layer/after the application of a third resist/after half-tone exposure/after development; and (b) is a cross-sectional view after fourth etching.
In FIG. 36(a), almost as in the case of the fifth embodiment, the oxide transparent conductor layer 1060 is formed at first by the sputtering method in a thickness of about 120 nm on the interlayer insulating film 1050, the n-type oxide semiconductor layer 1040 and the metal layer 1020, which are exposed, by using an indium oxide-zinc oxide-tin oxide (In₂O₃:ZnO:SnO₂=about 60:20:20 wt%) target. Subsequently, the reflective metal layer 1090 is formed on the oxide transparent conductor layer 1060. Specifically, Mo is stacked at first in a thickness of about 50 nm by using the high-frequency sputtering method. Subsequently, Al is stacked in a thickness of about 250 nm by using the high-frequency sputtering method.

Next, on the reflective metal layer 1090, the metal layer-protecting oxide conductor layer 1095 is formed in a thickness of about 50 nm by using an indium oxide-zinc oxide (IZO: In₂O₃:ZnO=about 90:10 wt%) sputtering target. Here, the IZO film can be patterned with an etched method with an acid mixture, and therefore, the IZO film can be patterned simultaneously with the reflective metal layer 1090 with an etching method. Alternatively, after the IZO film alone is patterned with an etching method by using an oxalic acid-based etching solution, the reflective metal layer 1090 may be patterned with an etching method with an acid mixture.
Next, the protective insulating film 1070, which is a silicon nitride (SiNₓ) film, is deposited in a thickness of about 200 nm by the glow discharge CVD (Chemical Vapor Deposition) method on the metal layer-protecting oxide conductor layer 1095. In this embodiment, an SiH₄-NH₃-N₂-based mixed gas is used as a discharge gas.

Next, as shown in FIG. 36(a), the third resist 1071d is applied on the protective insulating film 1070, and the third resist 1071d is formed into a predetermined shape by using the third half-tone mask 1072d by half-tone exposure (Step S1007e). That is, the third resist 1071d is formed in such a shape that it covers the drain electrode 1064, the source electrode 1063, the source wire 1065, the drain wire 1066, the reflective metal part 1094, the pixel electrode 1067 and the gate wire pad 1025. In addition, the third resist 1071d is formed in such a shape that parts of the third resist 1071d covering the part of the pixel electrode 1067 except for the reflective metal part 1094, the drain wire pad 1068 and the gate wire pad 1025 are rendered thinner than other parts due to a half-tone mask part 1721 (see FIG 36(b)).

Next, as shown in FIG. 36(b), as a fourth etching, the exposed protective insulating film 1070 is patterned with a dry etching method by using the third resist 1071d and an etching gas (CHF (CF₄, CHF₃ gas, or the like). Subsequently, the metal layer-protecting oxide conductor layer 1095 and the reflective metal layer 1090, which are exposed, are patterned with an etching method by using the third resist 1071d and an etching solution (an acid mixture). Then, the oxide transparent conductor layer 1060 is patterned with an etching method by using the third resist 1071d and an etching solution (an aqueous oxalic acid solution), whereby the drain electrode 1064, the source electrode 1063, the source wire 1065, the pixel electrode 1067, the drain wire 1066 and the gate wire pad 1025 are formed (Step S1008a).

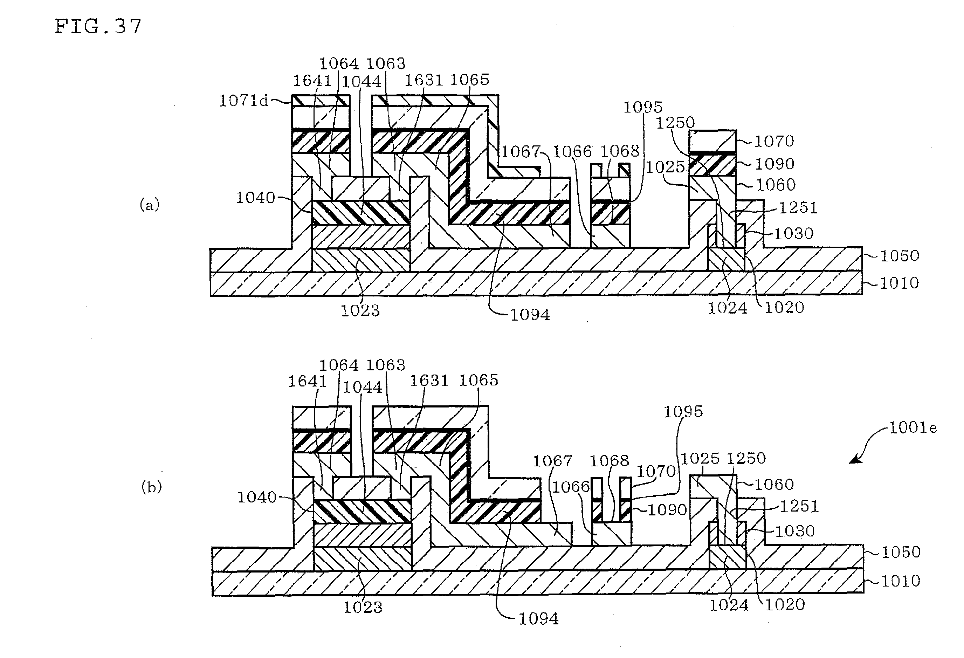

FIG. 37 is a schematic view for explaining treatment using a third half-tone mask of the method for producing a TFT substrate according to the sixth embodiment of the invention, in which (a) is a cross-sectional view after the reformation of a third resist; and (b) is a cross-sectional view after fifth etching/after peeling off the third resist.
In FIG. 37(a), the above-mentioned third resist 1071d is removed through an ashing process, and the third resist 1071d is reformed in such a shape that the reflective metal layer 1090 above the part of the pixel electrode 1067 except for the reflective metal part 1094, the drain wired pad 1068 and the gate wire pad 1025 is exposed (Step S1009a).

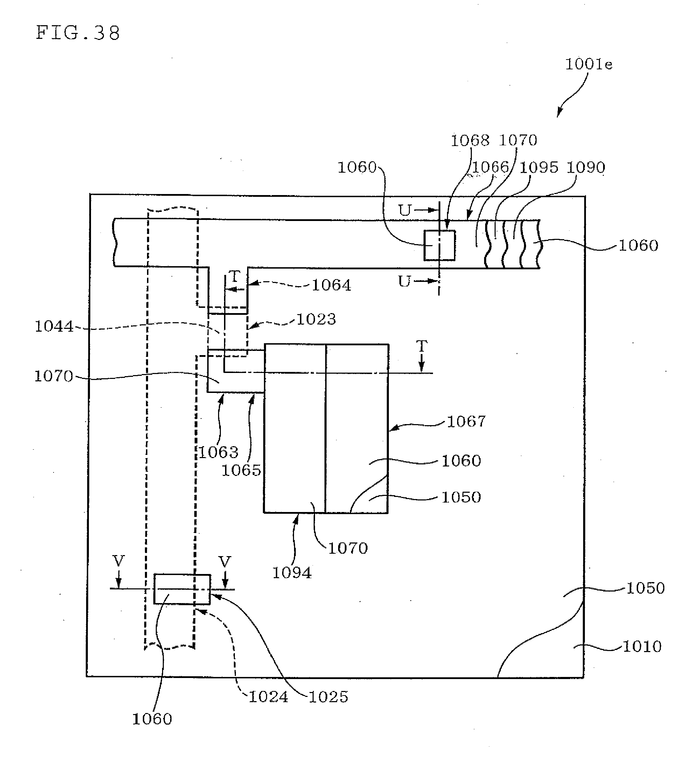

Next, as shown in FIG. 37(b), as a fifth etching, the exposed protective insulating film 1070 is patterned with a dry etching method by using the reformed third resist 1071d and an etching gas (CHF (CF₄, CHF₃ gas, or the like). Subsequently, the metal layer-protecting oxide conductor layer 1095 and the reflective metal layer 1090, which are exposed, are selectively patterned with an etching method by using the reformed third resist 1071d and an etching solution (an acid mixture), whereby the part of the pixel electrode 1067 except for the reflective metal part 1094, the drain wire pad 1068 and the gate wire pad 1025 are exposed and the reflective metal part 1094 composed of the metal layer-protecting oxide conductor layer 1095 and the reflective metal layer 1090 is formed (Step S1010d).
Then, the reformed third resist 1071d is removed through an ashing process. As a result, as shown in FIG. 38, the protective insulating film 1070 stacked above the drain electrode 1064, the source electrode 1063, the source wire 1065, the reflective metal part 1094 and the drain wire 1066 is exposed above the glass substrate 1010. The drain electrode 1064, the gate electrode 1023, the channel part 1044, the source electrode 1063, the source wire 1065, the reflective metal part 1094 and the pixel electrode 1067 shown in FIG. 37(b) are cross-sectional views taken along line T-T in FIG. 38. The drain wire pad 1068 shown in FIG. 37(b) is a cross-sectional view taken along line U-U in FIG. 38. The gate wire pad 1025 shown in FIG. 37(b) is a cross-sectional view taken along line V-V in FIG. 38.

As is apparent from the above, according to the method for producing the TFT substrate 1001e in this embodiment, advantageous effects almost similar to those attained in the fifth embodiment are attained. Further, since the reflective metal layer 1090 is protected by the metal layer-protecting oxide conductor layer 1095, discoloration or other problems of the reflective metal layer 1090 can be prevented, and therefore, disadvantages such as a decrease in the reflectance of the reflective metal layer 1090 can be prevented.
In this embodiment, the side part of each of the source electrode 1063, the drain electrode 1064, the source wire 1065 and the drain wire 1066 is exposed. It is possible to cover these side parts with the protective insulating film 1070.
Then, the method for covering the side part of each of the source electrode 1063, the drain electrode 1064, the source wire 1065 and the drain wire 1066 with the protective insulating film 1070 will be explained with referring to the drawing.

### [Application example of the sixth embodiment of the method for producing a TFT substrate]

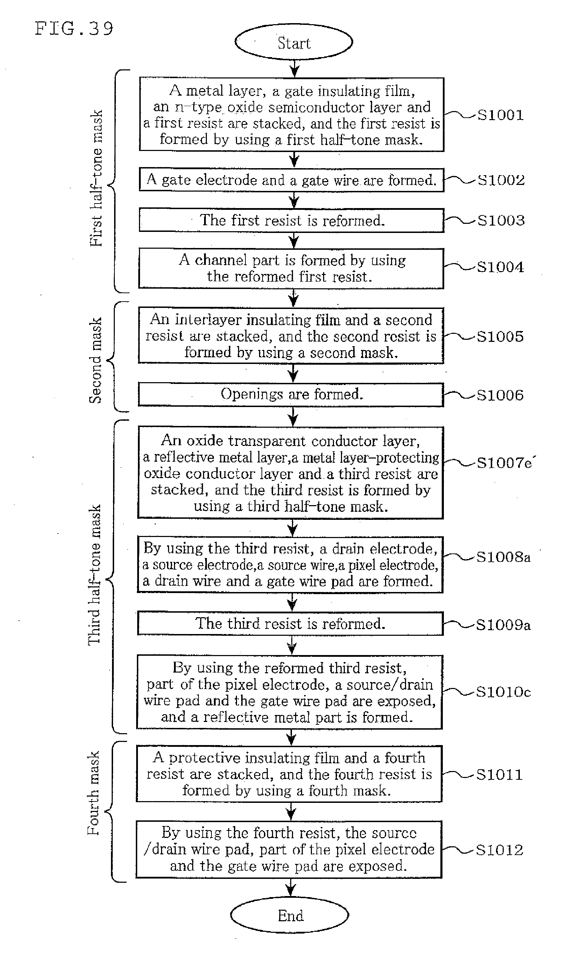

FIG. 39 is a schematic flow chart for explaining an application example in the method for producing a TFT substrate according to the sixth embodiment of the invention. The method for producing in this application example corresponds to claims 31 and 32.
The method for producing the TFT substrate 1001e' according to this application example shown in FIG. 39 differs from the above-mentioned application example in the fifth embodiment in the following point. That is, step S1007c in the application example of the fifth embodiment is changed as follows. Specifically, the oxide transparent conductor layer 1060, the reflective metal layer 1090, the metal layer-protecting oxide conductor layer 1095 and the third resist 1091 are stacked, and the third resist 1091 is formed into a predetermined shape by using a third half-tone mask 1092d (Step S1007e'). That is, the method shown in FIG. 39 differs from the above-mentioned application example of the fifth embodiment in this point.
Other steps are almost the same as those in the application example of the fifth embodiment. Therefore, in the drawing, the same steps are indicated by the same numerals as used in the application example of the fifth embodiment, and detailed explanation is omitted.

As shown in FIG. 39, by changing step S1007c in the application example of the fifth embodiment, a TFT substrate in which the metal layer-protecting oxide conductor layer 1095 is formed above the reflective metal layer 1090 is produced as in the case of the above-mentioned application example of the fourth embodiment. Specifically, the oxide transparent conductor layer 1060, the reflective metal layer 1090, the metal layer-protecting oxide conductor layer 1095 and the third resist 1091 are stacked, and the third resist 1091 is formed into a predetermined shape by using the third half-tone mask 1092d (Step S1007e'). Subsequently, treatments in steps S1008a, 1009a and 1010c are conducted.

Then, after the above-mentioned step S1010c, the protective insulating film 1070 and the fourth resist 1071d' are stacked, and the fourth resist 1071d'is formed into a predetermined shape by using a fourth mask 1072d' (Step S1011). Further, by using the fourth resist 1071d', the drain wire pad 1068, part of the pixel electrode 1067 and the gate wire pad 1025 are exposed (Step S1012).

### (Treatment using a fourth mask)

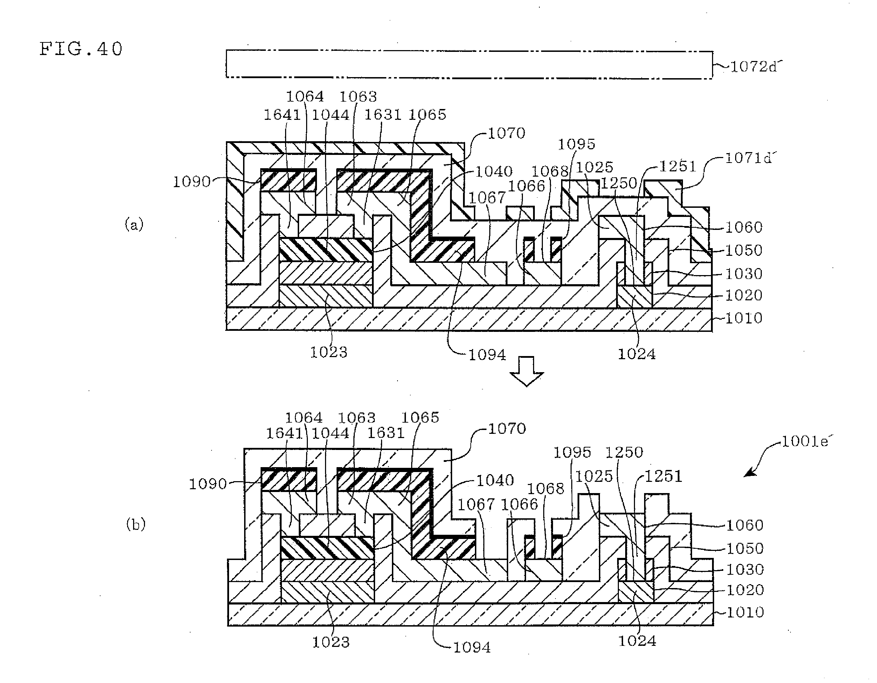

FIG. 40 is a schematic view for explaining treatment using a fourth mask in the application example of the method for producing a TFT substrate according to the sixth embodiment of the invention, in which (a) is a cross-sectional view after the formation of a protective insulating film/after the application of a fourth resist/after exposure/after development; and (b) is a cross-sectional view after sixth etching/after peeling off the fourth resist
In FIG. 40 (a), the protective insulating film 1070, which is a silicon nitride (SiNₓ) film, is deposited in a thickness of about 200 nm by the glow discharge CVD (Chemical Vapor Deposition) method on the interlayer insulating film 1050, the metal layer-protecting oxide conductor layer 1095 and the oxide transparent conductor layer 1060. In this embodiment, an SiH₄-NH₃-N₂-based mixed gas is used as a discharge gas.
Next, the fourth resist 1071d' is applied on the protective insulating film 1070, and the fourth resist 1071d' is formed into a predetermined shape by using the fourth mask 1072d'(Step S1011). That is, the fourth resist 1071d' is formed in such a shape that the protective insulating film 1070 above the part of the pixel electrode 1067 except for the reflective metal part 1094, the drain wire pad 1068 and the gate wire pad 1025 is exposed.

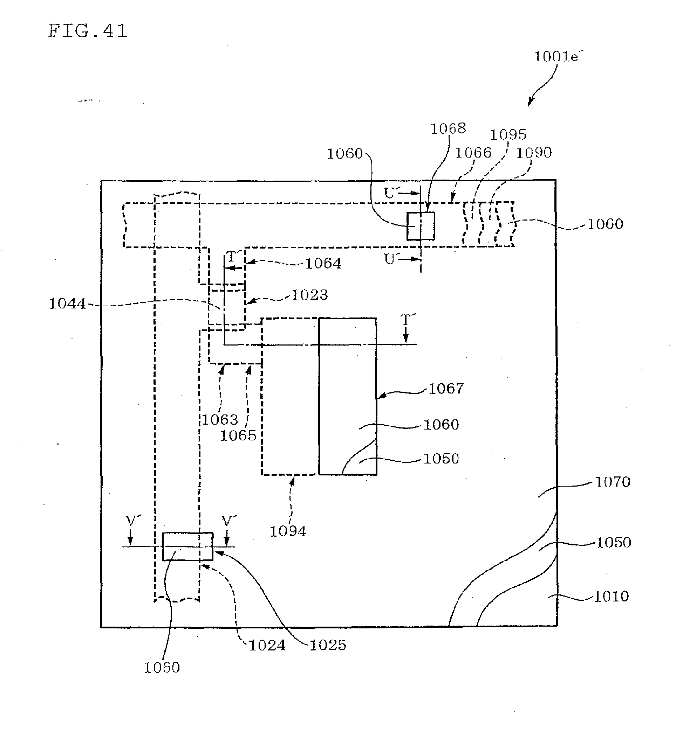

Next, as shown in FIG. 40(b), as a sixth etching, the exposed protective insulating film 1070 is patterned with a dry etching method by using the fourth resist 1071d' and an etching gas (CHF (CF₄, CHF₃ gas, or the like), whereby the part of the pixel electrode 1067 except for the reflective metal part 1094, the drain wire pad 1068 and the gate wire pad 1025 are exposed (Step S1012). Next, the fourth resist 1071d' is removed through an ashing process. As a result, as shown in FIG. 40, the protective insulating film 1070 is exposed above the glass substrate 1010. The drain electrode 1064, the gate electrode 1023, the channel part 1044, the source electrode 1063, the source wire 1065, the reflective metal part 1094 and the pixel electrode 1067 shown in FIG. 40(b) are cross-sectional views taken along line T'-T' in FIG. 41. The drain wire pad 1068 shown in FIG. 40(b) is a cross-sectional view taken along line U'-U' in FIG. 41. The gate wire pad 1025 shown in FIG. 40(b) is a cross-sectional view taken along line V'-V' in FIG. 41.

As is apparent from the above, according to the method for producing the TFT substrate 1001e' in this application example, advantageous effects almost similar to those attained in the fifth embodiment can be attained. Further, the source electrode 1063, the drain electrode 1064, the source wire 1065 and the drain 1066 are covered with the protective insulating film 1070 so as not to be exposed. In addition, the TFT substrate 1001e' is provided with the protective insulating film 1070. As a result, it is possible to provide the TFT substrate 1001e' capable of producing readily a display means or an emitting means utilizing a liquid crystal, an organic EL material or the like.

### [A TFT substrate according to a first embodiment]

Further, the invention is also advantageous as an invention of the TFT substrate 1001.
As shown in FIG. 6(b) and FIG. 7, the TFT substrate 1001 according to a first embodiment comprises a glass substrate 1010, the gate electrode 1023, the gate wire 1024, the n-type oxide semiconductor layer 1040, the oxide transparent conductor layer 1060 and the channel guard 1500.
The gate electrode 1023 and the gate wire 1024 are formed on the glass substrate 1010 and insulated by having their top surfaces covered with the gate insulating film 1030 and by having their side surfaces covered with the interlayer insulating film 1050.
The n-type oxide semiconductor layer 1040 as an oxide layer is formed on the gate insulating film 1030 above the gate electrode 1023.
The oxide transparent conductor layer 1060 as a conductor layer is formed on the n-type oxide semiconductor layer 1040 with the channel part 1044 interposed therebetween.
The channel guard 1500 is formed on the channel part 1044 constituting the n-type oxide semiconductor layer 1040 for protecting the channel part 1044.

This channel guard 1500 is composed of the interlayer insulating film 1050 in which a pair of openings 1631 and 1641 are formed. In the openings 1631 and 1641, the source electrode 1063 and the drain electrode 1064 composed of the oxide transparent conductor layer 1060 are formed.
Due to such a configuration, since the upper part of the n-type oxide semiconductor layer 1040 constituting the channel part 1044 is protected by the channel guard 1500, the TFT substrate 1001 can be operated stably for a prolonged period of time. In addition, since the channel guard 1500, the channel part 1044, the drain electrode 1064 and the source electrode 1063 can be formed easily without fail, not only manufacturing yield is improved but also manufacturing cost can be reduced.

In addition, in the TFT substrate 1001, the source wire 1065, the drain wire 1066, the source electrode 1063, the drain electrode 1064 and the pixel electrode 1067 are formed from the oxide conductor layer 1060. As a result, the oxide conductor layer 1060 functions as the source wire 1065, the drain wire 1066, the source electrode 1063, the drain wire 1066, the drain electrode 1064 and the pixel electrode 1067. As mentioned above, the source wire 1065, the drain wire 1066, the source electrode 1063, the drain electrode 1064 and the pixel electrode 1067 can be produced efficiently. That is, the number of masks used in production can be decreased and production steps can be reduced. As a result, production efficiency can be improved and manufacturing cost can be decreased.
Further, in the TFT substrate 1001, the n-type oxide semiconductor layer 1040 is used as an oxide layer and the oxide transparent conductor layer 1060 is used as a conductive layer. As a result, an oxide semiconductor layer is used as an active layer of a TFT. By doing this, a TFT remains stable when electric current is flown, and the TFT substrate is advantageously used for an organic EL apparatus which is operated under current control mode.

Further, in the TFT substrate 1001, since the n-type oxide semiconductor layer 1040 is formed only at positions corresponding to the channel part 1044, the source electrode 1063 and the drain electrode 1064, concern for occurrence of interference of gate wires 1024 (crosstalk) can be eliminated.

In this embodiment, the gate electrode 1023 and the gate wire 1024 are composed of the metal layer 1020. If the TFT substrate 1001 is provided with the metal layer 1020 as mentioned above, a metal layer-protecting oxide conductor layer (not shown), which protects the metal layer 1020, may be formed on the metal layer 1020. Due to such a configuration, the metal surface can be prevented from being exposed when the opening 1251 for the gate wire pad 1025 is formed, whereby connection reliability can be improved.

Further, in the TFT substrate 1001, since the source wire 1065, the drain wire 1066, the source electrode 1063, the drain electrode 1064 and the pixel electrode 1067 are composed of the oxide transparent conductor layer 1060. Due to such a configuration, the amount of transmitted light is increased, and as a result, a display apparatus improved in luminance can be provided.
In addition, since the energy gap of n-type the oxide semiconductor layer 1040 and the oxide transparent conductor layer 1060 is rendered about 3.0 eV or more, malfunction caused by light can be prevented.

As mentioned above, in the TFT substrate 1001 of this embodiment, since the channel part 1044 is protected by the channel guard 1500, the TFT substrate 1001 can be operated stably for a prolonged period of time. In addition, since the n-type oxide semiconductor layer 1040 is formed only at predetermined positions (predetermined positions corresponding to the channel part 1044, the source electrode 1063 and the drain electrode 1064), concern for occurrence of interference of the gate wires 1024 (crosstalk) can be eliminated.
Meanwhile, in this embodiment, on the glass substrate 1010, the metal layer 1020, the gate insulating film 1030 and the n-type oxide semiconductor layer 1040 are stacked, and further, the interlayer insulating film 1050 and the oxide transparent conductor layer 1060 are stacked. The stacking configuration is, however, not limited thereto. For example, these layers may be stacked with other layers being interposed therebetween. Here, "other layers" mean, for example, layers which do not impair the functions or the effects of this embodiment or layers which allow other functions or effects to be exhibited. The same applies to the embodiments given later.

### [A TFT substrate according to a second embodiment]

As shown in FIG. 22(b) and FIG. 23, in the TFT substrate 1001b' according to a second embodiment, the auxiliary conductive layer 1080 is formed on the source wire 1065, the drain wire 1066, the source electrode 1063, the drain electrode 1064 and the pixel electrode 1067.
Further, in the TFT substrate 1001b', the upper part of the glass substrate 1010 is covered with the protective insulating film 1070, and the protective insulating film 1070 has openings at positions corresponding to the pixel electrode 1067, the drain wire pad 1068 and the gate wire pad 1025.
The other configurations are almost similar to those of the TFT substrate 1001.

As is apparent from the above, the TFT substrate 1001b' according to this embodiment can attain advantageous effects almost similar to those attained by the TFT substrate 1001 in the first embodiment. In addition, since the electric resistance of the source wire 1065, the drain wire 1066, the source electrode 1063, the drain electrode 1064 and the pixel electrode 1067 can be lowered, reliability can be improved and a decrease in energy efficiency can be suppressed. Further, the TFT substrate 1001b'is provided with the protective insulating film 1070. Therefore, it is possible to provide a TFT substrate capable of producing readily a display means or an emitting means utilizing a liquid crystal, an organic EL material or the like.

### [A TFT substrate according to a third embodiment]

As shown in FIG. 40(b) and FIG. 41, in the TFT substrate 1001e' according to a third embodiment, part of the pixel electrode 1067 is covered with the reflective metal part 1094 which is composed of the reflective metal layer 1090. The reflective metal layer 1090 may be composed of a thin film comprising aluminum, silver or gold or an alloy layer containing aluminum, silver or gold. Due to such a configuration, a larger amount of light can be reflected, resulting in improvement in luminance by reflected light.
Further, in the TFT substrate 1001e', the reflective metal layer 1090 is stacked on the source wire 1065, the drain wire 1066, the source electrode 1063 and the drain electrode 1064. Therefore, a larger amount of light can be reflected, resulting in improvement in luminance by reflected light. In addition, since the reflective metal layer 1090 functions as the auxiliary conductive layer 1080, the electric resistance of each electrode and wire can be reduced. As a result, not only reliability can be improved but also a decrease in energy efficiency can be suppressed.

In addition, in the TFT substrate 1001e', the metal layer-protecting oxide conductor layer 1095 for protecting the reflective metal layer 1090 is stacked above the reflective metal layer 1090. Due to such a configuration, discoloration or other problems of the reflective metal layer 1090 can be prevented, and disadvantages such as a decrease in reflectance of the reflective metal layer 1090 can be prevented. Further, corrosion of the reflective metal layer 1090 can be prevented and durability can be improved.
Other configurations are almost similar to those of the TFT substrate 1001 of the first embodiment.

As is apparent from the above, the TFT substrate 1001e' according to this embodiment can attain advantageous effects almost similar to those attained by the TFT substrate 1001 in the first embodiment, and in addition, can be used as a semi-reflective or a semi-transmissive TFT substrate.

### [Method for producing a TFT substrate according to a seventh embodiment]

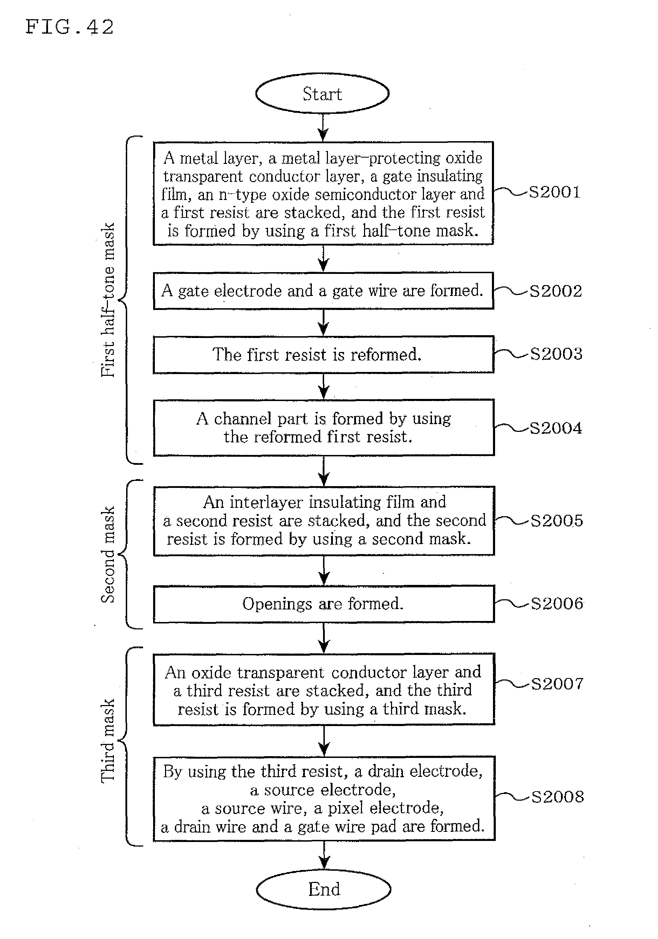

FIG. 42 is a schematic flow chart for explaining the method for producing a TFT substrate according to a seventh embodiment of the invention. The method for producing a TFT substrate in this embodiment corresponds to claim 34.
In FIG. 42, first, a metal layer 2020 as the thin film for a gate electrode/gate wire, a metal layer-protecting oxide transparent conductor layer 2026, a gate insulating film 2030, an n-type oxide semiconductor layer 2040 as an oxide layer and a first resist 2041 are stacked in this order on a glass substrate 2010, and the first resist 2041 is formed into a predetermined shape with a first half-tone mask 2042 by half-tone exposure (Step S2001).
Next, treatment using the first half-tone mask 2042 will be explained below referring to the drawing.

### (Treatment using a first half-tone mask)

FIG. 43 is a schematic view for explaining treatment using a first half-tone mask in the method for producing a TFT substrate according to the seventh embodiment of the invention, in which (a) is a cross-sectional view after the formation of a metal layer/after the formation of a metal layer-protecting oxide transparent conductor layer/after the formation of a gate insulating film/after the formation of an n-type oxide semiconductor layer/after the application of a first resist/after half-tone exposure/after development; (b) is a cross-sectional view after a first etching/after reformation of the first resist; and (c) is a cross-sectional view after second etching/after peeling off the first resist
In FIG. 43(a), a transparent glass substrate 2010 is provided at first.
A plate-like element as the base material of the TFT substrate 2001 is not limited to the above-mentioned glass substrate 2010. For example, a plate- or sheet-like element made of a resin may be used. In addition, the above-mentioned sheet-like element is not limited to the transparent glass substrate 2010. For example, a light-shielding or semi-transparent glass substrate may be used.

Next, a metal layer 2020 for forming the gate electrode 2023 and the gate wire 2024 is formed on the glass substrate 2010. At first, by using the high-frequency sputtering method, Al is formed in a thickness of about 250 nm. Subsequently, by using the high-frequency sputtering method, Mo (molybdenum) is formed in a thickness of about 50 nm. That is, though not shown, the metal layer 2020 is formed of an Al thin film layer and a Mo thin film layer. First, the Al thin film layer is formed by the high-frequency sputtering method using an Al target in an atmosphere of argon 100%. Then, the Mo thin film layer is formed by the high-frequency sputtering method using a Mo target in an atmosphere of argon 100%.

Next, a metal layer-protecting oxide transparent conductor layer 2026 with a thickness of about 100 nm is formed on the metal layer 2020 by using an indium oxide-zinc oxide (generally called IZO; In₂O₃:ZnO=about 90:10 wt%) sputtering target. This layer formation is conducted under the condition of an oxygen-to-argon ratio of about 1:99 (vol%) and a substrate temperature of about 150°C. Under this condition, the metal layer-protecting oxide transparent conductor layer 2026 is obtained as an amorphous film. As is apparent from the above, a transparent conducive film such as an IZO film is arranged on the surface of the gate wire 2024 as the metal layer-protecting oxide transparent conductor layer 2026. As a result, the surface of a metal used in the gate wire 2024 is prevented from being exposed when forming the opening 2251 in the gate insulating film 2030 in order to form the gate wire pad 2025. Due to such a configuration, not only the corrosion of the metal layer 2020 can be prevented but also durability can be improved, and connection with a high degree of reliability can be realized. As a result, operation stability of the TFT substrate 2001 is improved, and a liquid crystal display apparatus or an EL emitting apparatus (not shown) utilizing the TFT substrate 2001 can be operated stably. In addition, if an insulating product such as SiNₓ, SiONₓ and SiO₂ is used as the gate insulating film 2030 and the opening 2251 is formed in the gate insulating film 2030 by the reactive ion etching method by using CHF (CF₄, CHF₃ or the like), a transparent conductive film such as an IZO film serves as a protective film of the metal layer (Al/Mo layer) 2020, thereby suppressing damage on the metal layer 2020 by CHF.

The material for the above-mentioned metal layer-protecting oxide conductor layer 2026 is not limited to the above-mentioned indium oxide-zinc oxide, and it may be a conductive metal oxide which can be simultaneously etched with an acid mixture (generally called PAN) which is an etching solution for an Al thin film layer. That is, as for the composition of the indium oxide-zinc oxide, any composition may be used insofar as it allows the indium oxide-zinc oxide to be etched simultaneously with Al using PAN. In/(In + Zn) may be about 0.5 to 0.95 (weight ratio), preferably about 0.7 to 0.9 (weight ratio). The reason therefor is as follows. If In/(In + Zn) is less than about 0.5 (weight ratio), durability of the conductive metal oxide itself may be decreased. If In/(In + Zn) is more than about 0.95 (weight ratio), it may be difficult to be etched simultaneously with Al. In addition, in the case where the conductive metal oxide is etched simultaneously with Al, it is desirable for the conductive metal oxide to be amorphous. The reason therefor is that a crystallized film may be hard to be etched simultaneously with Al.
In addition, the thickness of the above-mentioned metal layer-protecting oxide conductor layer 2026 may be about 10 to 200 nm, preferably about 15 to 150 nm, more preferably about 20 to 100 nm. The reason therefor is as follows. If the thickness is less than about 10 nm, the metal layer-protecting oxide conductor layer 2026 may not be very effective as a protective film. A thickness exceeding about 200 nm may result in an economical disadvantage.

As a material replacing IZO, a material obtained by incorporating a lanthanoide-based element into ITO, a material obtained by incorporating an oxide of a high-melting-point metal such as Mo, W or the like can be used. Here, a preferable amount is about 30 at.% or less, more preferably 1 to 20 at.%, relative to all metal elements.
If the amount exceeds approximately 30 at.%, the etching rate in an aqueous oxalic acid solution or an acid mixture may be lowered. The film thickness may preferably be about 20 nm to 500 nm. It is more preferred that the thickness be about 30 nm to 300 nm. If the thickness is less than about 20 nm, the film may have pinholes and cannot function as a protective film. On the other hand, if the film thickness exceeds about 500 nm, film formation or etching takes a lot of time, leading to an economical disadvantage.

In the meantime, Mo on Al is used in order to decrease the contact resistance with the metal layer-protecting oxide transparent conductor layer 2026. The Mo layer is not required to be formed if the contact resistance is negligibly low. Further, instead of the above-mentioned Mo, Ti(titanium), Cr(chromium) or the like may be used. Further, as the gate wire 2024, a thin film of a metal such as Ag(silver), Cu(copper) or a thin film of an alloy may be used. In this embodiment, the Mo thin film layer is formed. Mo is especially preferable since it can be also etched with PAN which is an etching solution for the Al thin film layer or the metal layer-protecting oxide conductor layer 2026, whereby patterning can be conducted without increasing the number of steps. The thickness of the above-mentioned thin film of a metal such as Mo, Ti and Cr may be about 10 nm to 200 nm. The thickness is preferably about 15 nm to 100 nm, and more preferably about 20 nm to 50 nm. The reason therefor is as follows. If the thickness is less than about 10 nm, the effect of decreasing the contact resistance may be small. On the other hand, a thickness exceeding about 200 nm results in an economical disadvantage.

Although Al may be pure Al (Al with a purity of almost 100%), a metal such as Nd (neodymium), Ce (cerium), Mo, W (tungsten) and Nb (niobium) may be added. A metal such as Ce, W and Nb is preferable to suppress a cell reaction with an oxide transparent conductor layer 2060. The added amount can be appropriately selected, but preferably about 0.1 to 2 wt%.
In this embodiment, the metal layer 2020 and the metal layer-protecting oxide transparent conductor layer 2026 are used as the thin film for a gate electrode/gate wire. However, the thin film for a gate electrode/gate wire is not limited to these. For example, an oxide transparent conductor layer composed of indium oxide-tin oxide (In₂O₃:SnO=about 90:10 wt%) or the like may be used as the thin film for a gate electrode/gate wire.

Further, as metal layer-protecting oxide conductor layer 2026, the same material as that for the oxide transparent conductor layer 2060, which is mentioned later, may be used. By doing this, the kind of the material used can be decreased, and the desired TFT substrate 2001 can be effectively obtained. The material for the metal layer-protecting oxide conductor layer 2026 can be selected based on etching properties, protective film properties or the like.
In the meantime, the position where the metal layer-protecting oxide conductor layer 2026 is formed is not limited to a position above the metal layer 2020 as the thin film for a gate electrode/gate wire. For example, though not shown, if an auxiliary conductive layer composed of a metal is stacked above the oxide transparent conductor layer 2060, the metal layer-protecting oxide conductor layer 2026 may be formed on this auxiliary conductive layer.

Next, on the metal layer-protecting oxide conductor layer 2026, a gate insulating film 2030, which is a silicon nitride (SiNₓ) film, is deposited in a thickness of about 300 nm by the glow discharge CVD (Chemical Vapor Deposition) method. In this embodiment, an SiH₄-NH₃-N₂-based mixed gas is used as a discharge gas.

In this embodiment, a silicon nitride film composed of SiNₓ or the like is used as the gate insulating film 2030. However, an oxide insulator may also be used as an insulating film. In this case, a higher dielectric ratio of the oxide insulating film is advantageous for the operation of the thin film transistor. In addition, a higher degree of insulating properties is preferable. As examples of insulating films satisfying these requirements, an oxide insulating film composed of an oxide having a superlattice structure is preferable. Furthermore, it is possible to use an amorphous oxide insulating film. The amorphous oxide insulating film can be advantageously used in combination with a substrate having a low thermal resistance, such as a plastic substrate, since film formation temperature can be kept low.
For example, ScAlMgO₄, ScAlZnO₄, ScAlCoO₄, ScAlMnO₄, ScGaZnO₄, ScGaMgO₄, or ScAlZn₃O₆, ScAlZn₄O₇, ScAlZn₇O₁₀, or ScGaZn₃O₆, ScGaZn₅O₈, ScGaZn₇O₁₀, or ScFeZn₂O₅, ScFeZn₃O₆, ScFeZn₆O₉ may also be used.
Furthermore, oxides such as aluminum oxide, titanium oxide, hafnium oxide and lanthanoid oxide, and a composite oxide having a superlattice structure may also be used.

Next, an n-type oxide semiconductor layer 2040 with a thickness of about 150 nm is formed on the gate insulating film 2030 by using an indium oxide-zinc oxide (In₂O₃:ZnO=about 97:3 wt%) target. This layer formation is conducted under the condition of an oxygen-to-argon ratio of about 10:90 (vol%) and a substrate temperature of about 150°C. Under this condition, the n-type oxide conductor layer 2040 is obtained as an amorphous film. Meanwhile, the n-type oxide semiconductor layer 2040 is obtained as an amorphous film when formed at a low temperature of about 200°C or lower, and is obtained as a crystallized film when formed at a high temperature exceeding about 200°C. The above-mentioned amorphous film can be crystallized by heat treatment. In this embodiment, the n-type oxide semiconductor layer 2040 is formed as an amorphous film, and the amorphous film is then crystallized.
The n-type oxide semiconductor layer 2040 is not limited to the above-mentioned oxide semiconductor layer formed of indium oxide-zinc oxide, for example, an oxide semiconductor layer based on indium oxide-gallium oxide-zinc oxide or an oxide semiconductor layer formed of indium oxide-samarium oxide, zinc oxide-magnesium oxide or the like may also be used.

The carrier density of the above-mentioned indium oxide-zinc oxide thin film was 10⁺¹⁶ cm⁻³ or less, which was in a range allowing the film to function satisfactorily as a semiconductor. In addition, the hole mobility was 25 cm²/V·sec. Usually, as long as the carrier density is less than the 10⁺¹⁷ cm⁻³, the film functions satisfactorily as a semiconductor. In addition, the mobility is approximately 10 times as large as that of amorphous silicon. In view of the above, the n-type oxide semiconductor layer 2040 is a satisfactorily effective semiconductor thin film.

In addition, since the n-type oxide semiconductor layer 2040 is required to be transparent, an oxide, whose energy gap is about 3.0 eV or more, may be used. The energy gap may preferably be about 3.2 eV or more, more preferably about 3.4 eV or more. The energy gap of the above-mentioned n-type oxide semiconductor layer based on indium oxide-zinc oxide, an n-type oxide semiconductor layer based on indium oxide-gallium oxide-zinc oxide or an n-type oxide semiconductor layer formed of indium oxide-samarium oxide, zinc oxide-magnesium oxide or the like is about 3.2 eV or more, and therefore, these n-type oxide semiconductor layers may be used preferably. Although these thin films (n-type oxide semiconductor layer) can be dissolved in an aqueous oxalic acid solution or an acid mixture when it is amorphous, they become insoluble in and resistant to an aqueous oxalic acid solution or an acid mixture when crystallized by heating. The crystallization temperature can be controlled according to the amount of zinc oxide to be added.

Next, as shown in FIG. 43(a), a first resist 2041 is applied on the n-type oxide semiconductor layer 2040, and the first resist 2041 is formed into a predetermined shape with the first half-tone mask 2042 by half-tone exposure (Step S2001). That is, the first resist 2041 covers a gate electrode 2023 and a gate wire 2024, and part of the first resist 2041 covering the gate wire 2024 is rendered thinner than other parts due to a half-tone mask part 2421.

Next, as shown in FIG. 43(b), as a first etching, the n-type oxide semiconductor layer 2040 is patterned with an etching method at first with the first resist 2041 and an etching solution (an aqueous oxalic acid solution). Subsequently, the gate insulating film 2030 is patterned with a dry etching method by using the first resist 2041 and an etching gas (CHF (CF₄, CHF₃ gas, or the like). Further, the metal layer-protecting oxide transparent conductor layer 2026 and the metal layer 2020 is patterned with an etching method by using the first resist 2041 and an etching solution (an acid mixture), whereby the gate electrode 2023 and the gate wire 2024 are formed (Step S2002).
Then, the above-mentioned first resist 2041 is removed through an ashing process. As a result, the n-type oxide semiconductor layer 2040 above the gate wire 2024 is exposed, and the first resist 2041 is reformed in such a shape that the n-type oxide semiconductor layer 2040 above the gate electrode 2023 is covered (Step S2003).

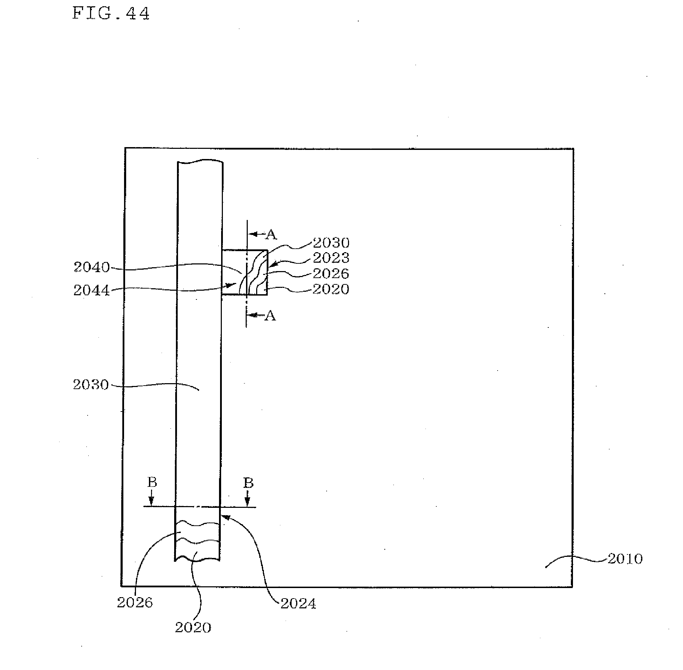

Next, as shown in FIG. 43(c), as a second etching, the exposed n-type oxide semiconductor conductor layer 2040 on the gate wire 2024 is removed by etching with the reformed first resist 2041 and an etching solution (an aqueous oxalic acid solution), whereby a channel part 2044 composed of the n-type oxide semiconductor layer 2040 is formed (Step S2004).
Next, the reformed first resist 2041 is removed through an ashing process, whereby, as shown in FIG. 44, the gate insulating film 2030 stacked above the gate wire 2024 and the channel part 2044 formed on the gate insulating film 2030 above the gate electrode 2023 are exposed above the glass substrate 2010. The gate electrode 2023 and the channel part 2044 shown in FIG. 43(c) are cross-sectional view taken along line A-A in FIG. 44. The gate wire 2024 shown in FIG. 43(c) is a cross-sectional view taken along line B-B in FIG. 44.

As is apparent from the above, by using the n-type oxide semiconductor layer 2040 as an active layer for a TFT, a TFT remains stable when electric current is flown. Therefore, the TFT substrate is advantageously used for an organic EL apparatus which is operated under current control mode.
Further, in the invention, since the n-type oxide semiconductor layer 2040 is formed only at the predetermined positions corresponding to the channel part 2044, the source electrode 2063 and the drain electrode 2064, concern for interference of the gate wire 2024 (crosstalk) can be eliminated.

Next, as shown in FIG. 42, an interlayer insulating film 2050 and a second resist 2051 are stacked in this order on the glass substrate 2010, the gate insulting film 2030 and the n-type oxide semiconductor layer 2040, and a second resist 2051 is formed into a predetermined shape by using a second mask 2052 (Step S2005).
Next, treatment using the second mask 2052 will be explained below referring to the drawing.

### (Treatment using a second mask)

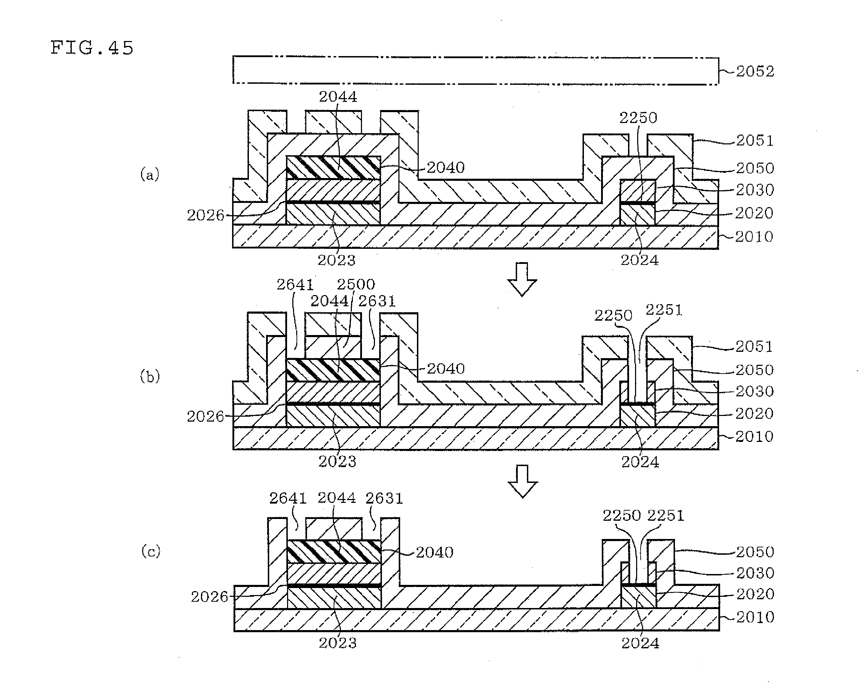

FIG. 45 is a schematic view for explaining treatment using a second mask in the method for producing a TFT substrate according to the seventh embodiment of the invention, in which (a) is a cross-sectional view after the formation of an interlayer insulating film/after the application of a second resist/after exposure/after development; (b) is a cross-sectional view after third etching; (c) is a cross-sectional view after peeling off the second resist.
In FIG. 45(a), the interlayer insulating film 2050, which is a silicon nitride (SiNₓ) film, is deposited in a thickness of about 200 nm by the glow discharge CVD (Chemical Vapor Deposition) method on the glass substrate 2010, the gate insulating film 2030 and the n-type oxide semiconductor layer 2040, which are exposed. In this embodiment, an SiH₄-NH₃-N₂-based mixed gas is used as a discharge gas.

Next, as shown in FIG. 45(a), the second resist 2051 is applied on the interlayer insulating film 2050, and the second resist 2051 is formed into a predetermined shape by using the second mask 2052 (Step S2005). That is, the second resist 2051 is formed on the interlayer insulating film 2050 except for the parts above a source electrode 2063 and a drain electrode 2064 which are formed in the later process, as well as the part above a gate wire pad portion 2250. The gate wire 2024 and the gate electrode 2023 are insulated by having their top surfaces covered with the gate insulating film 2030 and by having their side surfaces covered with the interlayer insulating film 2050.

Subsequently, by using the second resist 2051 and an etching gas (CHF (CF₄, CHF₃ gas, or the like), the interlayer insulating film 2050 at positions corresponding to the source electrode 2063 and the drain electrode 2064, as well as the gate insulating film 2030 and the interlayer insulating film 2050 above the gate wire pad 2250 are patterned with an etching method, whereby a pair of openings 2631 and 2641 for the source electrode 2063 and the drain electrode 2064, as well as an opening 2251 for the gate wire pad 2025 are formed (Step S2006). In this step, since the etching rate of the n-type oxide semiconductor layer 2040 in CHF is significantly low, the n-type oxide semiconductor layer 2040 is not damaged. Further, since the channel part 2044 is protected by a channel guard 2500 composed of the interlayer insulating film 2050 formed on the channel part 2044, operation stability of the TFT substrate 2001 can be improved.

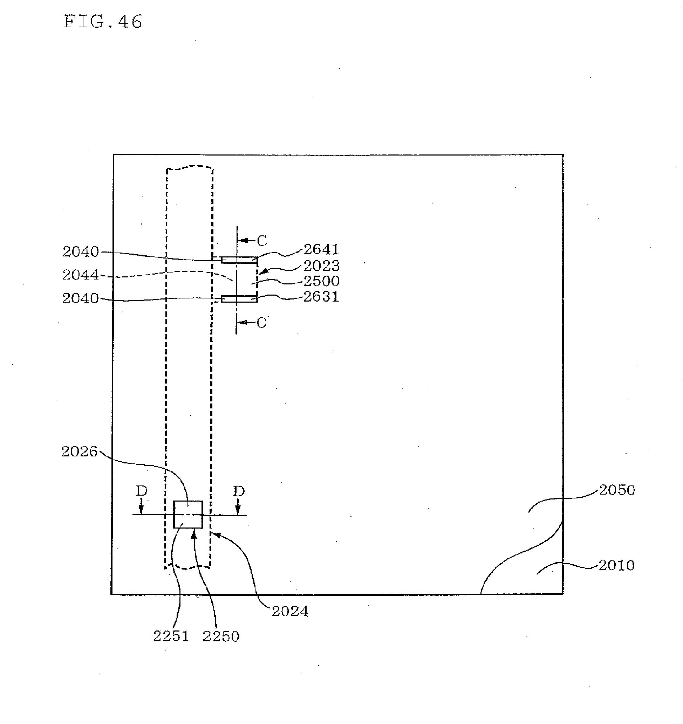

Next, after removing the second resist 2051 by an ashing process, as shown in FIG. 45(c), the interlayer insulating film 2050, the n-type oxide semiconductor layer 2040 and the metal layer-protecting oxide transparent conductor layer 2026 are exposed above the glass substrate 2010 (see FIG. 46). The n-type oxide semiconductor layer 2040 is exposed through the openings 2631 and 2641, and the metal layer-protecting oxide transparent conductor layer 2026 is exposed through the opening 2251. The gate electrode 2023, the channel part 2044 and the openings 2631 and 2641 shown in FIG. 45(c) are cross-sectional views taken along line C-C in FIG. 46. The gate wire pad part 2250 and the opening 2251 shown in FIG. 45(c) are cross-sectional views taken along line D-D in FIG. 5.
The shape or size of the openings 2631, 2641 and 2251 are not particularly restricted.

Next, as shown in FIG. 42, above the glass substrate 2010 on which the openings 2631, 2641 and 2251 are formed, the oxide transparent conductor layer 2060 as a conductor layer and a third resist 2061 are stacked in this order.
By using a third mask 2062, the third resist 2061 is formed into a predetermined shape (Step S2007).
In this embodiment, the oxide transparent conductor layer 2060 is used as a conductor layer. However, the conductor layer is not limited to the oxide transparent conductor layer 2060. For example, a metal layer having conductivity or a semitransparent or nontransparent oxide conductor layer may be used as the conductor layer. For example, the above conductor layer may be a layer composed of a metal. By doing this, it is possible to provide a reflective TFT substrate which can be operated stably for a prolonged period of time, and is capable of reducing manufacturing yield and decreasing manufacturing cost.
Next, treatment using the third mask 2062 will be explained below referring to the drawing.

### (Treatment using a third mask)

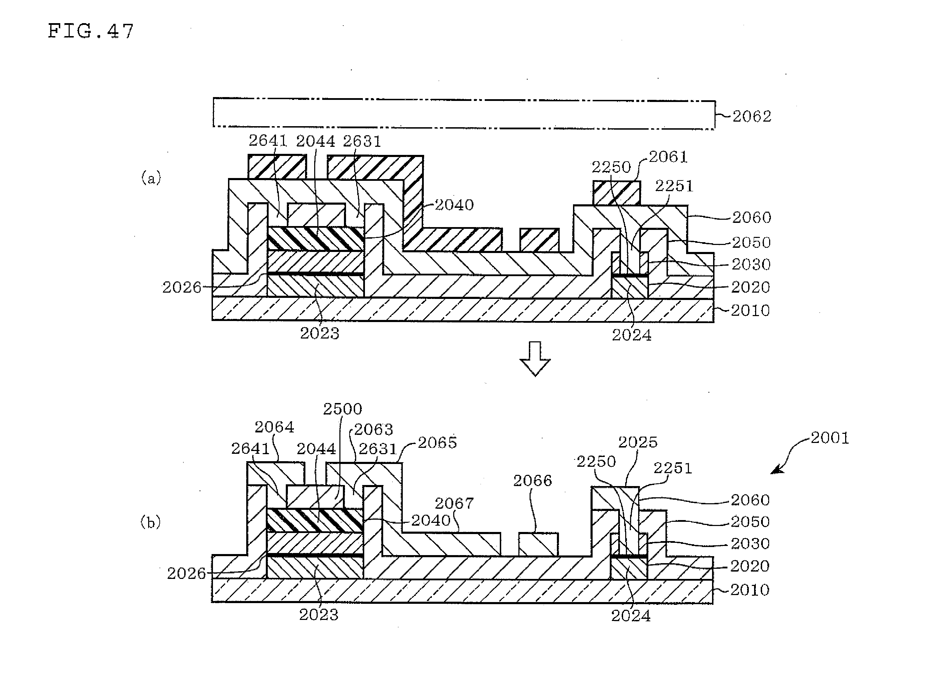

FIG. 47 is a schematic view for explaining treatment using a third mask in the method for producing a TFT substrate according to the seventh embodiment of the invention, in which (a) is a cross-sectional view after the formation of an oxide transparent conductor layer/after the application of a third resist/after exposure/after development; and (b) is a cross-sectional view after fourth etching/after peeling off the third resist.
In FIG. 47(a), on the interlayer insulating film 2050, the n-type oxide semiconductor layer 2040 and the metal layer-protecting oxide transparent conductor layer 2026, which are exposed, the oxide transparent conductor layer 2060 is formed in a thickness of about 120 nm by using an indium oxide-zinc oxide (In₂O₃:ZnO=about 90:10 wt%) target. This layer formation is conducted under the condition of an oxygen-to-argon ratio of about 10:90 (vol%) and a substrate temperature of about 150°C. Under this condition, the oxide transparent conductor layer 2060 is obtained as an amorphous film. The amorphous indium oxide-zinc oxide thin film can be etched with an acid mixture or an aqueous oxalic acid solution.

The oxide transparent conductor layer 2060 is not limited to the oxide conductor layer composed of the above-mentioned indium oxide-zinc oxide. For example, the oxide transparent conductor layer 2060 may be an oxide conductor layer composed of indium oxide-tin oxide, indium oxide-tin oxide-zinc oxide, indium oxide-tin oxide-samarium oxide or the like or an oxide conductor layer obtained by incorporating a lanthanoide-based element into indium oxide-zinc oxide, indium oxide-tin oxide, indium oxide-tin oxide-zinc oxide, indium oxide-tin oxide-samarium oxide or the like.
In this embodiment, a source electrode 2063, a drain electrode 2064, a source wire 2065, a drain wire 2066 and a pixel electrode 2067 are formed from the oxide transparent conductor layer 2060. Therefore, it is preferred that the oxide transparent conductor layer 2060 be improved in conductivity.

In addition, since the oxide transparent oxide layer 2060 is required to be transparent, an oxide, whose energy gap is about 3.0 eV or more, may be used. The energy gap may preferably be about 3.2 eV or more, more preferably about 3.4 eV or more. The energy gap of the oxide conductor layer composed of indium oxide-zinc oxide, indium oxide-tin oxide, indium oxide-tin oxide-zinc oxide, indium oxide-tin oxide-samarium oxide or the like or the oxide conductor layer obtained by incorporating a lanthanoide-based element into indium oxide-zinc oxide, indium oxide-tin oxide, indium oxide-tin oxide-zinc oxide, indium oxide-tin oxide-samarium oxide or the like is about 3.2 eV or more, and therefore, these oxide conductor layers may be used preferably.

Next, as shown in FIG. 47(a), the third resist 2061 is applied on the oxide transparent conductor layer 2060, and the third resist 2061 is formed into a predetermined shape by using the third mask 2062 (Step S2007). That is, the third resist 2061 is formed in such a shape that it covers the drain electrode 2064, the source electrode 2063, the source wire 2065, the drain wire 2066, the pixel electrode 2067 and the gate wire pad 2025 (see FIG. 47(b)). In this embodiment, the pixel electrode 2067 and the source electrode 2063 are connected through the source wire 2065. However, the pixel electrode 2067 and the drain electrode 2064 may be connected through the drain wire 2066.

Subsequently, as shown in FIG. 47(b), as a fourth etching, the oxide transparent conductor layer 2060 is patterned with an etching method by using the third resist 2061 and an aqueous oxalic acid solution, whereby the drain electrode 2064, the source electrode 2063, the source wire 2065, the pixel electrode 2067, the drain wire 2066 and the gate wire pad 2025 are formed (Step S2008).
By doing this, the source electrode 2063 and the drain electrode 2064 composed of the oxide transparent conductor layer 2060 are respectively formed in the pair of openings 2631 and 2641 of the interlayer insulating film 2050. As a result, it can be ensured that the source electrode 2063 and the drain electrode 2064 are formed with the channel guard 2500 and the channel part 2044 interposed therebetween. That is, since the channel guard 2500, the channel part 2044, the source electrode 2063 and the drain electrode 2064 can be formed readily without fail, not only manufacturing yield is improved but also manufacturing cost can be reduced. The TFT substrate 2001 with such a structure is referred to as a TFT substrate with via hole channels.

Further, the drain electrode 2064, the source electrode 2063, the source wire 2065, the pixel electrode 2067 and the drain wire 2066, each composed of the oxide transparent conductor layer 2060, can be formed efficiently by the fourth etching. That is, the number of masks used in the production can be decreased, leading to the reduction of production steps. As a result, production efficiency can be improved and manufacturing cost can be reduced.
In addition, since each of the drain electrode 2064, the source electrode 2063, the source wire 2065, the pixel electrode 2067 and the drain wire 2066 is composed of the oxide transparent conductor layer 2060, the amount of transmitted light is increased, whereby a display apparatus improved in luminance can be provided.

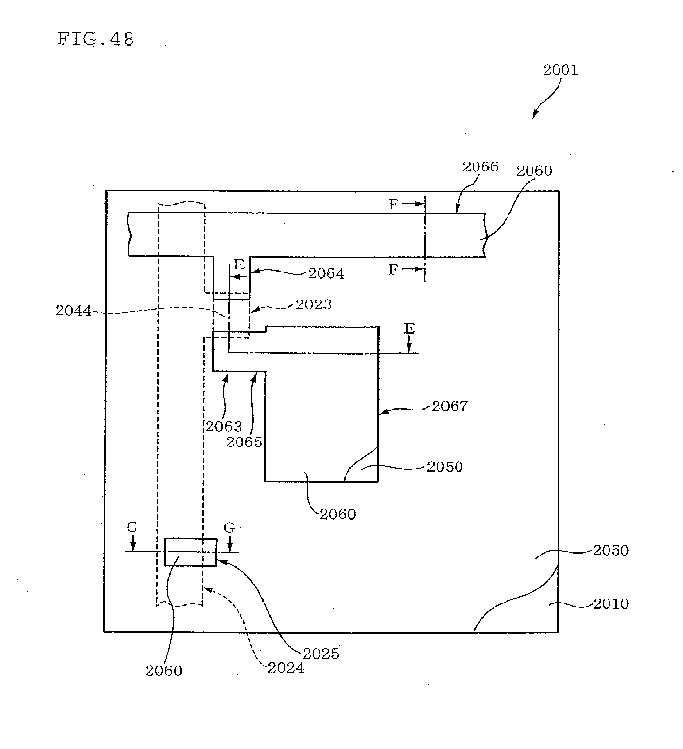

Next, the third resist 2061 is removed through an ashing process. As a result, the drain electrode 2064, the source electrode 2063, the source wire 2065, the pixel electrode 2067, the drain wire 2066 and the gate wire pad 2025, each composed of the oxide transparent conductor layer 2060, are exposed. The drain electrode 2064, the gate electrode 2023, the channel part 2044, the source electrode 2063, the source wire 2065 and the pixel electrode 2067 shown in FIG. 47(b) are cross-sectional views taken along line E-E in FIG. 48. The drain wire 2066 shown in FIG. 47(b) is a cross-sectional view taken along line F-F in FIG. 48. The gate wire pad 2025 shown in FIG. 47(b) is a cross-sectional view taken along line G-G in FIG. 48.

As mentioned above, according to the method for the TFT substrate 2001 in this embodiment, by using three masks 2042, 2052 and 2062, it is possible to produce the TFT substrate 2001 with via channel holes in which an oxide semiconductor layer (n-type oxide semiconductor layer 2040) is used as an active semiconductor layer. That is, since production steps are reduced, manufacturing cost can be decreased. In addition, since the channel part 2044 is protected by the channel guard 2500, the TFT substrate 2001 can be operated stably for a prolonged period of time. Further, since the n-type semiconductor layer 2040 is formed only at predetermined positions (positions corresponding to the channel part 2044, the source electrode 2063 and the drain electrode 2064), concern for occurrence of interference of the gate wires 2024 (crosstalk) can be eliminated.
Meanwhile, in this embodiment, on the glass substrate 2010, the metal layer 2020, the metal layer-protecting oxide transparent conductor layer 2026, the gate insulating film 2030, the n-type oxide semiconductor layer 2040 and the first resist 2041 are stacked, then the interlayer insulating film 2050 and the second resist 2051 are stacked, and further, the oxide transparent conductor layer 2060 and the third resist 2061 are stacked. The stacking configuration is, however, not limited thereto. For example, these layers may be stacked with other layers being interposed therebetween. Here, "other layers" mean, for example, layers which do not impair the functions or the effects of this embodiment or layers which allow other functions or effects to be exhibited. The same applies to the embodiments given later.

### [Application example of the seventh embodiment of the method for producing a TFT substrate]

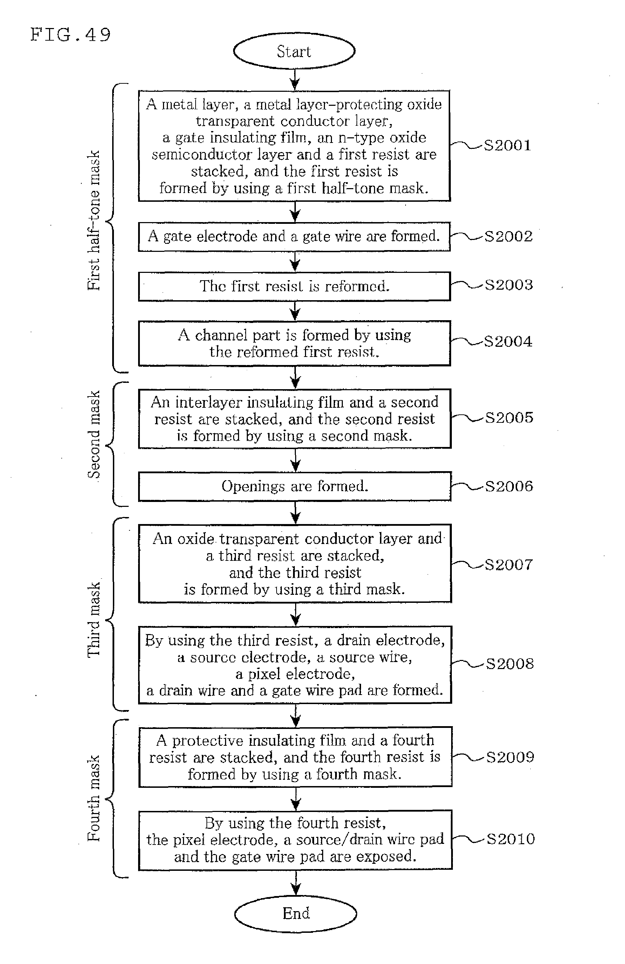

FIG. 49 is a schematic flow chart for explaining an application example in the method for producing a TFT substrate according to the seventh embodiment of the invention. The method for producing in this application example corresponds to claim 35.
The method for producing the TFT substrate 2001' according to this application example shown in FIG. 49 differs from the above-mentioned seventh embodiment in the following point. Specifically, the protective insulating film 2070 and a fourth resist 2071 are stacked above the TFT substrate 2001 of the above-mentioned seventh embodiment (Step S2009). Further, the pixel electrode 2067, the drain wire pad 2068 and the gate wire pad 2025 are exposed by using the fourth resist 2071 (Step S2010). The method shown in FIG. 49 differs from the seventh embodiment in these points.
Other steps are almost the same as those in the seventh embodiment. Therefore, in the drawing, the same steps are indicated by the same numerals as used in the seventh embodiment, and detailed explanation is omitted.

The treatment by using the first half-tone mask, the treatment by using the second mask and the treatment by using the third mask shown in FIG. 49 are almost the same as those in the seventh embodiment.
After these treatments, as shown in FIG. 49, the protective insulating film 2070 and the fourth resist 2071 are stacked, and the fourth resist 2071 is formed into a predetermined shape by using a fourth mask 2072 (Step S2009).
Next, treatment using the fourth mask 2072 will be explained below referring to the drawing.

### (Treatment using a fourth mask)

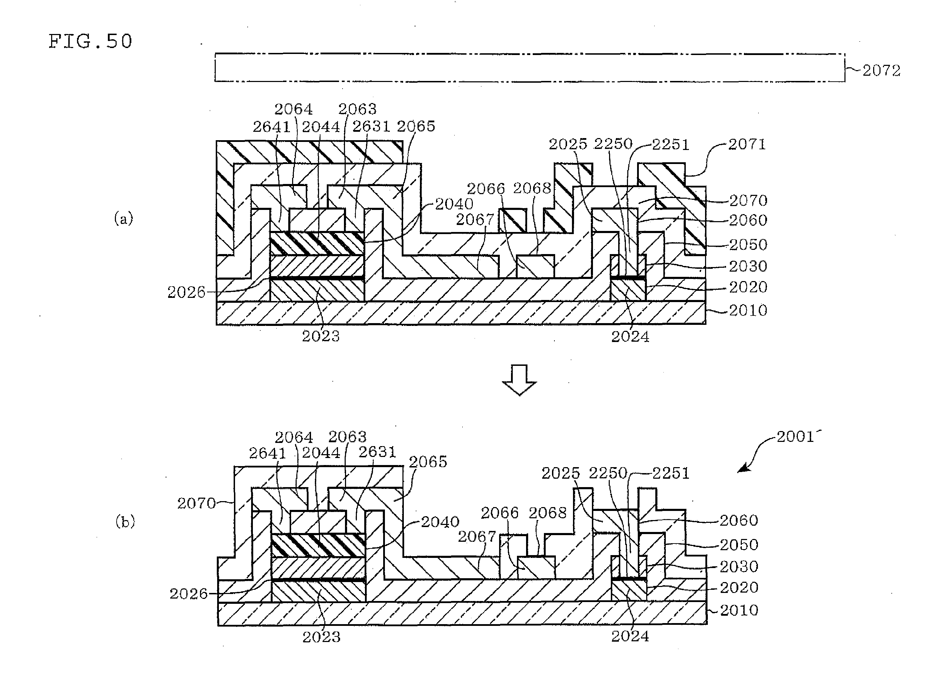

FIG. 50 is a schematic view for explaining treatment using a fourth mask in the application example of the method for producing a TFT substrate according to the seventh embodiment of the invention, in which (a) is a cross-sectional view after the formation of a protective insulating film/after the application of a fourth resist/after exposure/after development; and (b) is a cross-sectional view after fifth etching/after peeling off the fourth resist.
In FIG. 50(a), first, the protective insulating film 2070, which is a silicon nitride (SiNₓ) film, is deposited in a thickness of about 200 nm by the glow discharge CVD (Chemical Vapor Deposition) method on the interlayer insulating film 2050 and the oxide transparent conductor layer 2060. In this embodiment, an SiH₄-NH₃-N₂-based mixed gas is used as a discharge gas.
Next, the fourth resist 2071 is applied on the protective insulating film 2070, and the fourth resist 2071 is formed into a predetermined shape by using a fourth mask 2072 (Step S2009). That is, the fourth resist 2071 is formed in such a shape that the protective insulating film 2070 above the pixel electrode 2067, the drain wire pad 2068 and the gate wire pad 2025 is exposed (Step S2009).

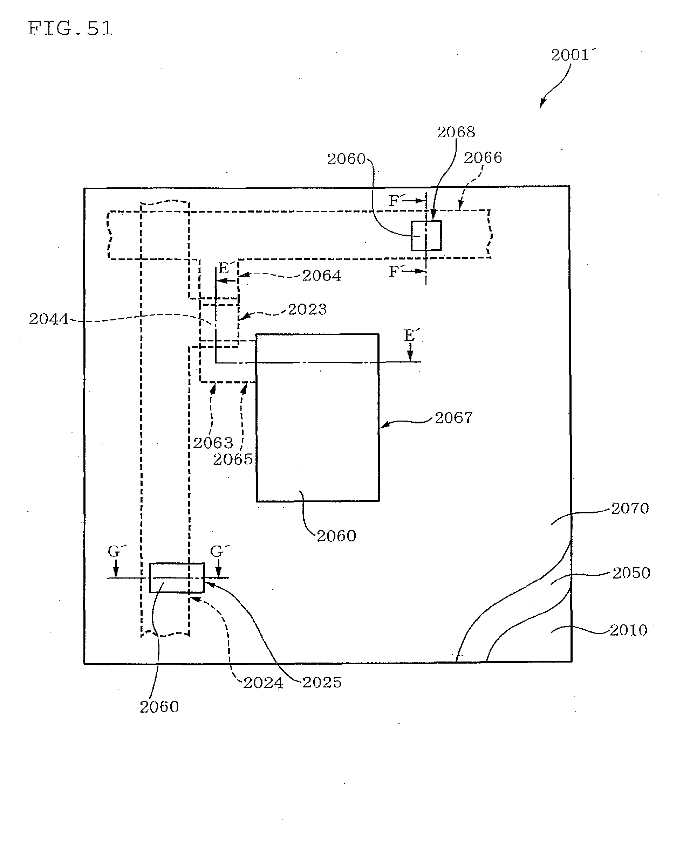

Next, as shown in FIG. 50(b), as a fifth etching, the exposed protective insulating film 2070 is patterned with a dry etching method by using the fourth resist 2071 and an etching gas (CHF (CF₄, CHF₃ gas, or the like), whereby the pixel electrode 2067, the drain wire pad 2068 and the gate wire pad 2025 are exposed (Step S2010). Subsequently, the fourth resist 2071 is removed through an ashing process, whereby the protective insulating film 2070 is exposed above the glass substrate 2010 as shown in FIG. 51. The drain electrode 2064, the gate electrode 2023, the channel part 2044, the source electrode 2063, the source wire 2065 and the pixel electrode 2067 shown in FIG. 50(b) are cross-sectional views taken along line E'-E' in FIG. 51. The drain wire pad 2068 shown in FIG. 50(b) is a cross-sectional view taken along line F'-F' in FIG. 51. The gate wire pad 2025 shown in FIG. 50(b) is a cross-sectional view taken along line G'-G' in FIG. 51.

As is apparent from the above, according to the method for producing the TFT substrate 2001' in this application example, not only advantageous effects almost similar to those attained in the seventh embodiment are attained but also the source electrode 2063, the drain electrode 2064, the source wire 2065 and the drain wire 2066 are covered with the protective insulating film 2070 so as to not to be exposed. As a result, the TFT substrate 2001' is provided with the protective insulating film 2070. Therefore, it is possible to provide the TFT substrate 2001'capable of producing readily a display means or an emitting means utilizing a liquid crystal or an organic EL material.
This application example provides a method in which the top surfaces and the side surfaces of the source electrode 2063, the drain electrode 2064, the source wire 2065 and the drain wire 2066 are mostly covered. However, as shown in the second embodiment of the method for producing a reflective TFT substrate 2001b, the method may be a method in which the top surfaces of the source electrode 2063, the drain electrode 2064, the source wire 2065 and the drain wire 2066 are mostly covered.

### [Method for producing a reflective TFT substrate according to a first embodiment]

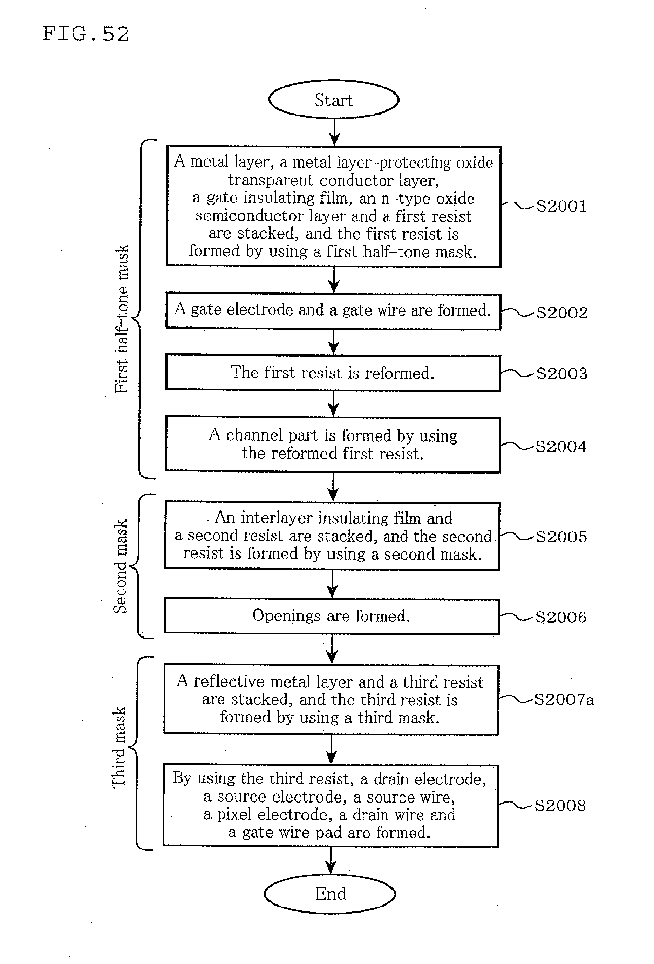

FIG. 52 is a schematic flow chart for explaining the method for producing a reflective TFT substrate according to a first embodiment of the invention. The method for producing a reflective TFT substrate in this embodiment corresponds to claim 36.
The method for producing the reflective TFT substrate 2001a according to this embodiment shown in FIG. 52 differs from the method for producing the TFT substrate 2001 in the above-mentioned seventh embodiment in the following point. Specifically, Step S2007 is changed as follows. The reflective metal layer 2060a and the third resist 2061 are stacked, and the third resist 2061 is formed by using the third mask 2062 (Step S2007a). The method shown in FIG. 52 differs from the seventh embodiment in this point.
Other steps are almost the same as those in the method for producing the TFT substrate 2001 in the seventh embodiment. Therefore, in the drawing, the same steps are indicated by the same numerals as used in the seventh embodiment, and detailed explanation is omitted.

The treatment by using the first half-tone mask and the treatment by using the second mask shown in FIG. 52 are almost the same as those in the method for producing the TFT substrate 2001 in the seventh embodiment.
After these treatments, as shown in FIG. 52, the reflective metal layer 2060a and the third resist 2061 are stacked in this order above the glass substrate 2010 on which the openings 2631, 2641 and 2251 are formed, and the third resist 2061 is formed into a predetermined shape by using a third mask 2062 (Step S2007a).
Next, treatment using the third mask 2062 will be explained below referring to the drawing.

### (Treatment using a third mask)

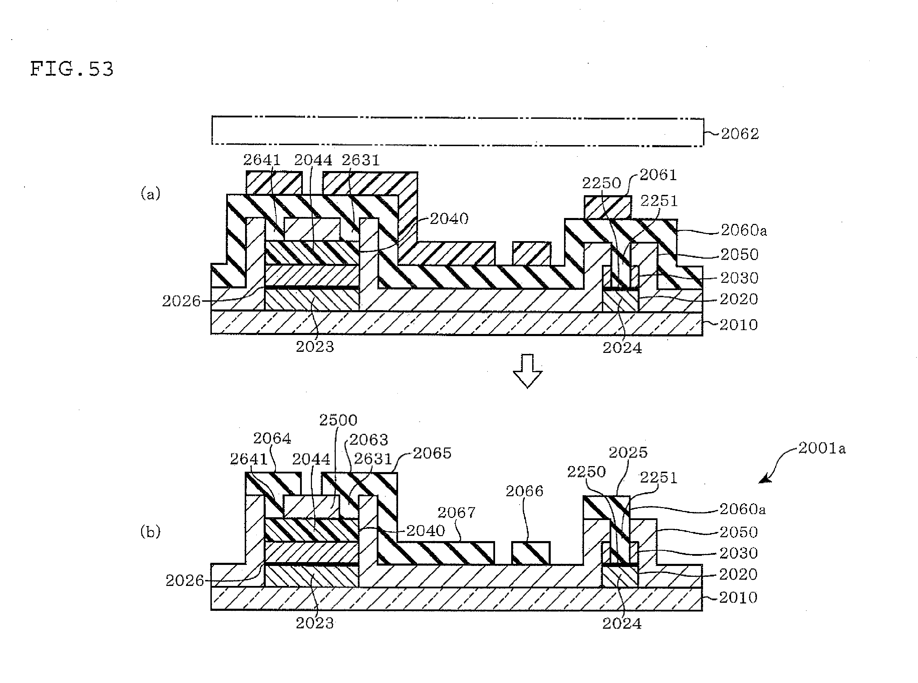

FIG. 53 is a schematic view for explaining treatment using a third half-tone mask of the method for producing a reflective TFT substrate according to the first embodiment of the invention, in which (a) is a cross-sectional view after the formation of a reflective metal layer/after the application of a third resist/after exposure/after development; and (b) is a cross-sectional view after fourth etching/after peeling off the third resist.
In FIG. 53(a), on the interlayer insulating film 2050, the n-type oxide semiconductor layer 2040 and the metal layer-protecting oxide transparent conductor layer 2026, which are exposed, Al is deposited in a thickness of about 120 nm, whereby a reflective metal layer 2060a composed of Al is formed. That is, the Al thin film layer is formed by the high-frequency sputtering method using an Al target in an atmosphere of argon 100%. In the meantime, the reflectance of the reflective metal layer 2060a may be 80% or more. By doing this, a reflective TFT substrate 2001a improved in luminance can be provided. Further, instead of the reflective metal layer 2060a composed of Al, a thin film of a metal such as Ag and Au may be used. By doing this, a larger amount of light can be reflected, resulting in improvement in luminance.

Next, as shown in FIG. 53(a), the third resist 2061 is applied on the reflective metal layer 2060a, and the third resist 2061 is formed into a predetermined shape by using the third mask 2062 (Step S2007a). That is, the third resist 2061 is formed in such a shape that it covers the drain electrode 2064, the source electrode 2063, the source wire 2065, the drain wire 2066, the pixel electrode 2067 and the gate wire pad 2025 (see FIG. 53(b)). In this embodiment, the pixel electrode 2067 and the source electrode 2063 are connected through the source wire 2065. However, the pixel electrode 2067 and the drain electrode 2064 may be connected through the drain wire 2066.

Subsequently, as shown in FIG. 53(b), as a fourth etching, the reflective metal layer 2060a is patterned with an etching method by using the third resist 2061 and an acid mixture, whereby the drain electrode 2064, the source electrode 2063, the source wire 2065, the pixel electrode 2067, the drain wire 2066 and the gate wire pad 2025 are formed (Step S2008).
By doing this, the source electrode 2063 and the drain electrode 2064 composed of the reflective metal layer 2060a are respectively formed in the pair of openings 2631 and 2641 of the interlayer insulating film 2050. As a result, it can be ensured that the source electrode 2063 and the drain electrode 2064 are formed with the channel guard 2500 and the channel part 2044 interposed therebetween. That is, the channel guard 2500, the channel part 2044, the source electrode 2063 and the drain electrode 2064 can be formed readily without fail, not only manufacturing yield is improved but also manufacturing cost can be reduced. The reflective TFT substrate 2001a with such a structure is referred to as a reflective TFT substrate with via hole channels.

Further, the drain electrode 2064, the source electrode 2063, the source wire 2065, the pixel electrode 2067 and the drain wire 2066, each composed of the reflective metal layer 2060a, can be formed efficiently by the fourth etching. That is, the number of masks used in the production can be decreased, leading to the reduction of production steps. As a result, production efficiency can be improved and manufacturing cost can be reduced.

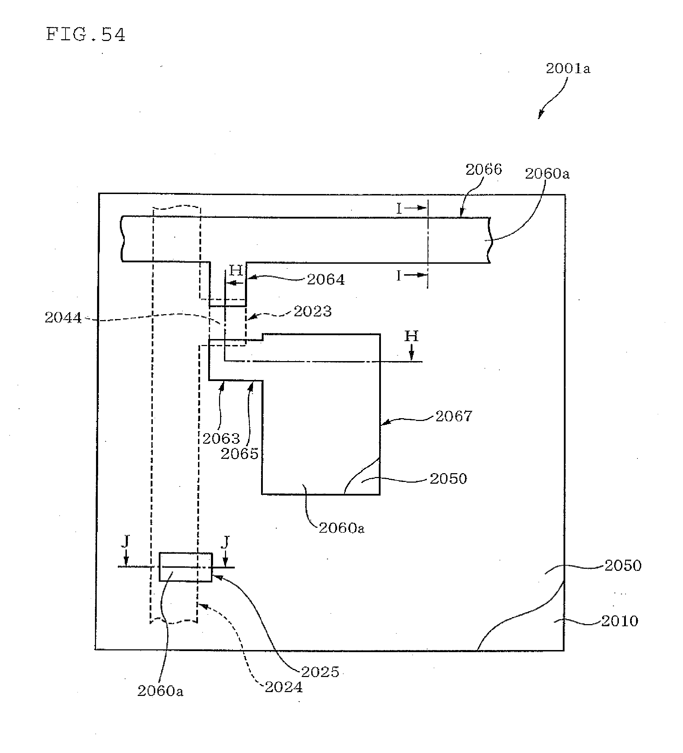

Next, the third resist 2061 is removed through an ashing process. As a result, the drain electrode 2064, the source electrode 2063, the source wire 2065, the pixel electrode 2067, the drain wire 2066 and the gate wire pad 2025, each composed of the reflective metal layer 2060a, are exposed. The drain electrode 2064, the gate electrode 2023, the channel part 2044, the source electrode 2063, the source wire 2065 and the pixel electrode 2067 shown in FIG. 53(b) are cross-sectional views taken along line H-H in FIG. 54. The drain wire 2066 shown in FIG. 53(b) is a cross-sectional view taken along line I-I in FIG. 54. The gate wire pad 2025 shown in FIG. 53(b) is a cross-sectional view taken along line J-J in FIG. 54.

As mentioned above, according to the method for the reflective TFT substrate 2001a in this embodiment, by using three masks 2042, 2052 and 2062, it is possible to produce the reflective TFT substrate 2001a with via channel holes in which an oxide semiconductor layer (n-type oxide semiconductor layer 2040) is used as an active semiconductor layer. As a result, production steps are reduced and manufacturing cost can be decreased. In addition, since the channel part 2044 is protected with the channel guard 2500, the reflective TFT substrate 2001a can be operated stably for a prolonged period of time. Further, since the n-type semiconductor layer 2040 is formed only at predetermined positions (positions corresponding to the channel part 2044, the source electrode 2063 and the drain electrode 2064), concern for occurrence of interference of the gate wires 2024 (crosstalk) can be eliminated.

### [Method for producing a reflective TFT substrate according to a second embodiment]

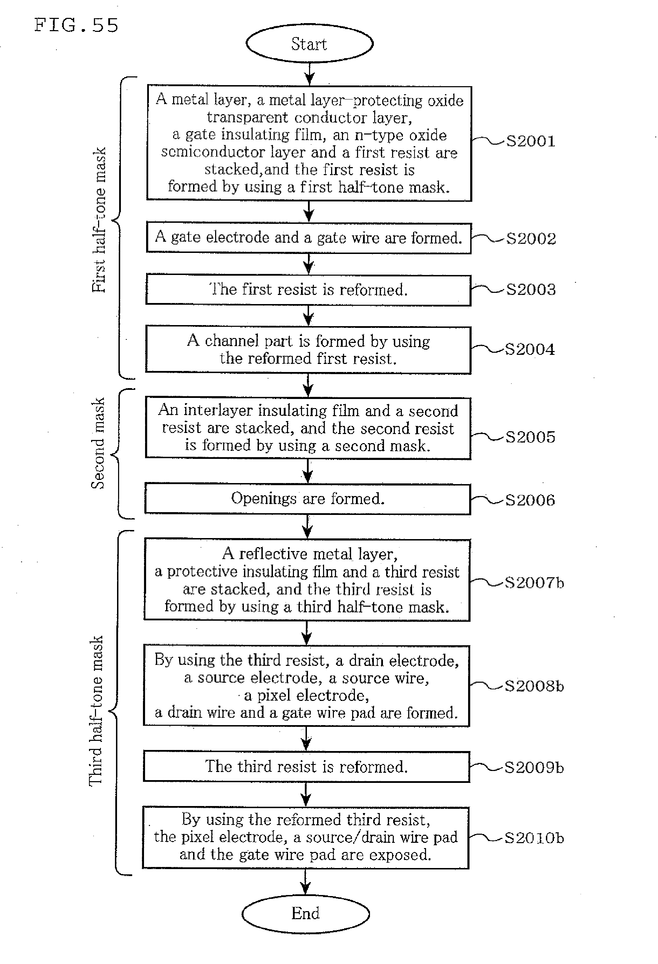

FIG. 55 is a schematic flow chart for explaining the method for producing a reflective TFT substrate according to a second embodiment of the invention. The method for producing a reflective TFT substrate in this embodiment corresponds to claim 37.
The method for producing the reflective TFT substrate 2001b according to this embodiment shown in FIG. 55 differs from the method for producing the reflective TFT substrate 2001a in the above-mentioned first embodiment in the following points. Specifically, the steps S2007a and S2008 in the above-mentioned first embodiment are changed as follows. The reflective metal layer 2060a, the protective insulating film 2070b and the third resist 2071b are stacked, and the third resist 2071b is formed by using a third half-tone mask 2072b (Step S2007b), the drain electrode 2064, the source electrode 2063, the source wire 2065, the pixel electrode 2067, the drain wire 2066 and the gate wire pad 2025 are formed by using the third resist 2071b (Step S2008b), the third resist 2071b is reformed (Step S2009b), and further, by using the reformed third resist 2071b, the pixel electrode 2067, the drain wire pad 2068 and the gate wire pad 2025 are exposed (Step S2010b). The method shown in FIG. 55 differs from the first embodiment of the method for producing a reflective TFT substrate in these points.
Other steps are almost the same as those in the method for producing the reflective TFT substrate in the first embodiment. Therefore, in the drawing, the same steps are indicated by the same numerals as used in the seventh embodiment, and detailed explanation is omitted.

The treatment by using the first half-tone mask and the treatment by using the second mask shown in FIG. 55 are almost the same as those in the first embodiment.
After these treatments, as shown in FIG. 55, the reflective metal layer 2060a, the protective insulting film 2070b and the third resist 2071b are stacked, and the third resist 2071b is formed into a predetermined shape by using a third half-tone mask 2072b (Step S2007b).
Next, treatment using the third half-tone mask 2072b will be explained below referring to the drawing.

### (Treatment using a third half-tone mask)

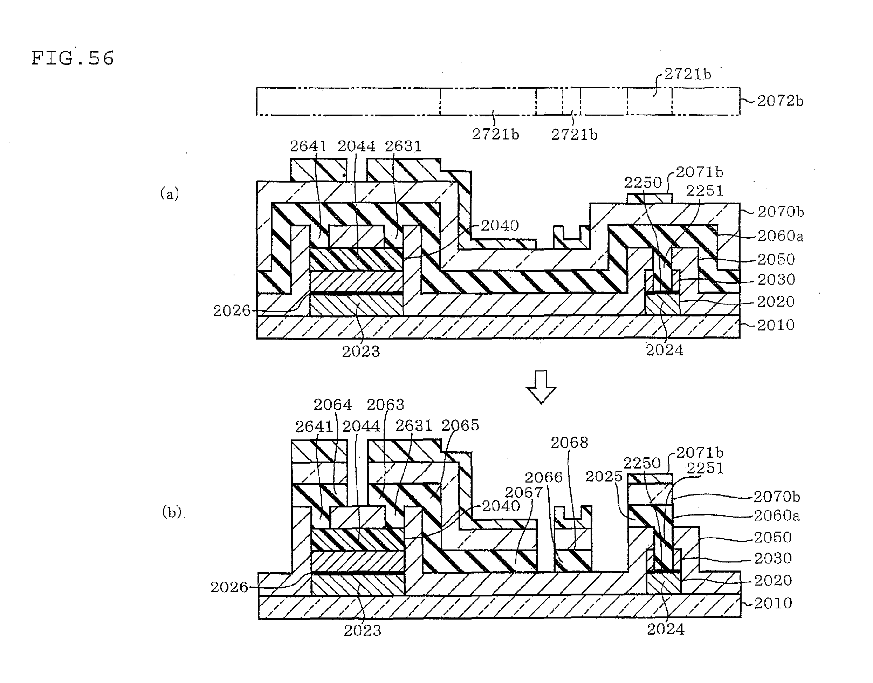

FIG. 56 is a schematic view for explaining treatment using a third half-tone mask in the method for producing a reflective TFT substrate according to the second embodiment of the invention, in which (a) is a cross-sectional view after the formation of a reflective metal layer/after the formation of a protective insulating film/after the application of a third resist/after half-tone exposure/after development; and (b) is a cross-sectional view after fourth etching.
In FIG. 56(a), first, as in the case of the first embodiment of the method for producing a reflective TFT substrate, on the interlayer insulating film 2050, the n-type oxide semiconductor layer 2040 and the metal layer-protecting oxide transparent conductor layer 2026, which are exposed, Al is deposited in a thickness of about 120 nm, whereby a reflective metal layer 2060a composed of Al is formed.

Next, a protective insulating film 2070b, which is a silicon nitride (SiNₓ) film, is deposited in a thickness of about 200 nm by the glow discharge CVD (Chemical Vapor Deposition) method on the reflective metal layer 2060a. In this embodiment, an SiH₄-NH₃-N₂-based mixed gas is used as a discharge gas.

Next, as shown in FIG. 56(a), the third resist 2071b is applied on the protective insulating film 2070b, and the third resist 2071b is formed into a predetermined shape by using the third half-tone mask 2072b by half-tone exposure (Step S2007b). That is, the third resist 2071b is formed in such a shape that it covers the drain electrode 2064, the source electrode 2063, the source wire 2065, the drain wire 2066, the pixel electrode 2067 and the gate wire pad 2025. In addition, the third resist 2071b is formed in such a shape that parts of the third resist 2071b covering the pixel electrode 2067, the drain wire pad 2068 and the gate wire pad 2025 are rendered thinner than other parts due to a half-tone mask part 2721b (see FIG. 56(b)).

Subsequently, as shown in FIG. 56(b), as a fourth etching, the exposed protective insulating film 2070b is patterned with a dry etching method by using the third resist 2071b and an etching gas (CHF (CF₄, CHF₃ gas, or the like). Further, the reflective metal layer 2060a is patterned with an etching method by using the third resist 2071b and an etching solution (an acid mixture), whereby the drain electrode 2064, the source electrode 2063, the source wire 2065, the pixel electrode 2067, the drain wire 2066 and the gate wire pad 2025 are formed (Step S2008b).

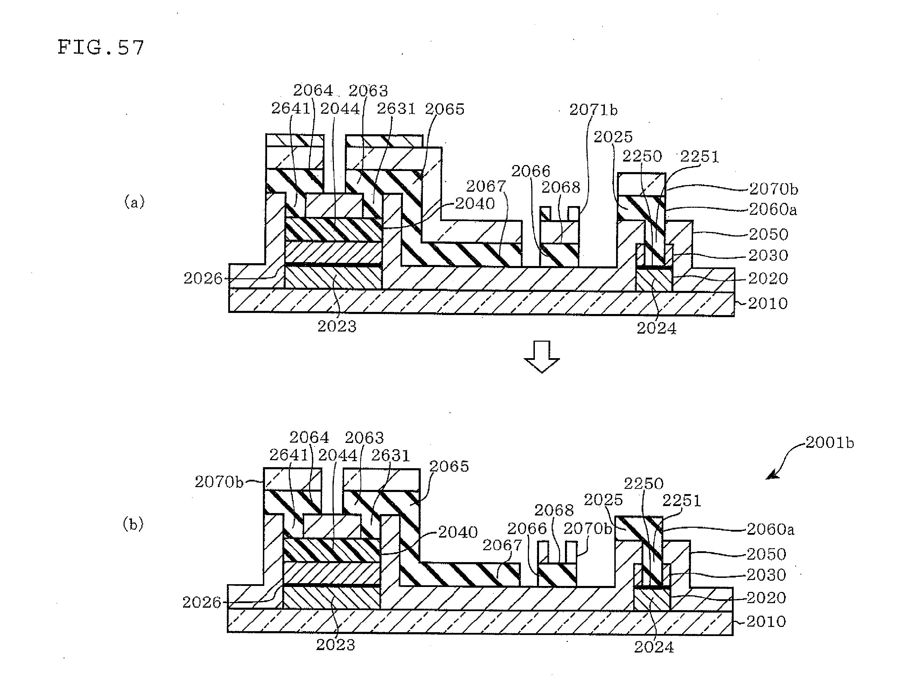

FIG. 57 is a schematic view for explaining treatment using a third half-tone mask in the method for producing a reflective TFT substrate according to the second embodiment of the invention, in which (a) is a cross-sectional view after the reformation of the third resist; and (b) is a cross-sectional view after fifth etching/after peeling off the third resist.
In FIG. 57(a), the above-mentioned third resist 2071b is removed through an ashing process, and the third resist 2071b is reformed in such a shape that the protective insulating film 2070 above the pixel electrode 2067, the drain wire pad 2068 and the gate wire pad 2025 is exposed (Step S2009b).

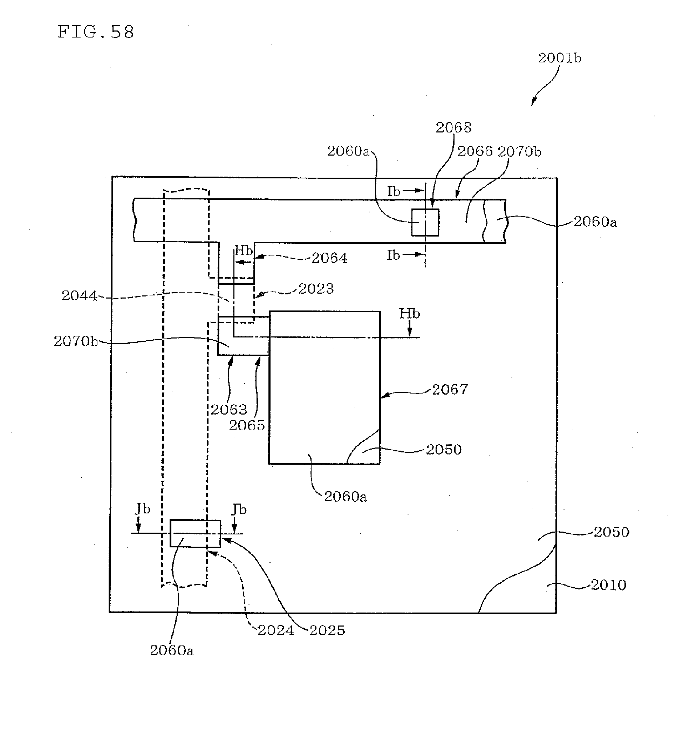

Next, as shown in FIG. 57(b), as a fifth etching, the exposed protective insulating film 2070b is patterned with a dry etching method by using the reformed third resist 2071b and an etching gas (CHF (CF₄, CHF₃ gas, or the like), whereby the pixel electrode 2067, the drain wire pad 2068 and the gate wire pad 2025 are exposed (Step S2010b). Subsequently, the reformed third resist 2071b is removed through an ashing process, whereby the protective insulating film 2070b stacked on the drain electrode 2064, the source electrode 2063, the source wire 2065 and the drain wire 2066 is exposed above the glass substrate 2010 as shown in FIG. 58. The drain electrode 2064, the gate electrode 2023, the channel part 2044, the source electrode 2063, the source wire 2065 and the pixel electrode 2067 shown in FIG. 57(b) are cross-sectional views taken along line Hb-Hb in FIG. 58. The drain wire pad 2068 shown in FIG. 57(b) is a cross-sectional view taken along line Ib-Ib in FIG. 58. The gate wire pad 2025 shown in FIG. 57(b) is a cross-sectional view taken along line Jb-Jb in FIG. 58.

As is apparent from the above, according to the method for producing the reflective TFT substrate 2001b in this embodiment, advantageous effects almost similar to those attained in the first embodiment of the method for producing a reflective TFT substrate are attained. Further, by covering the upper part of each of the source electrode 2063, the drain electrode 2064, the source wire 2065 and the drain wire 2066 with the protective insulating film 2070b, operation stability of a TFT can be improved.
In this embodiment, the protective insulating film 2070b is formed on the source electrode 2063 and the source wire 2065. However, the protective insulating film 2070b may not necessarily be formed. By doing this, since the top surfaces of the source electrode 2063 and the source wire 2065 also function as the reflective layers, the amount of reflected light can be increased, resulting in improved luminance.

In this embodiment, the side part of each of the source electrode 2063, the drain electrode 2064, the source wire 2065 and the drain wire 2066 is exposed. It is possible to cover these side parts with the protective insulating film 2070c.
Then, the method for covering the side part of each of the source electrode 2063, the drain electrode 2064, the source wire 2065 and the drain wire 2066 with the protective insulating film 2070c will be explained with referring to the drawing.

### [Method for producing a reflective TFT substrate according to a third embodiment]

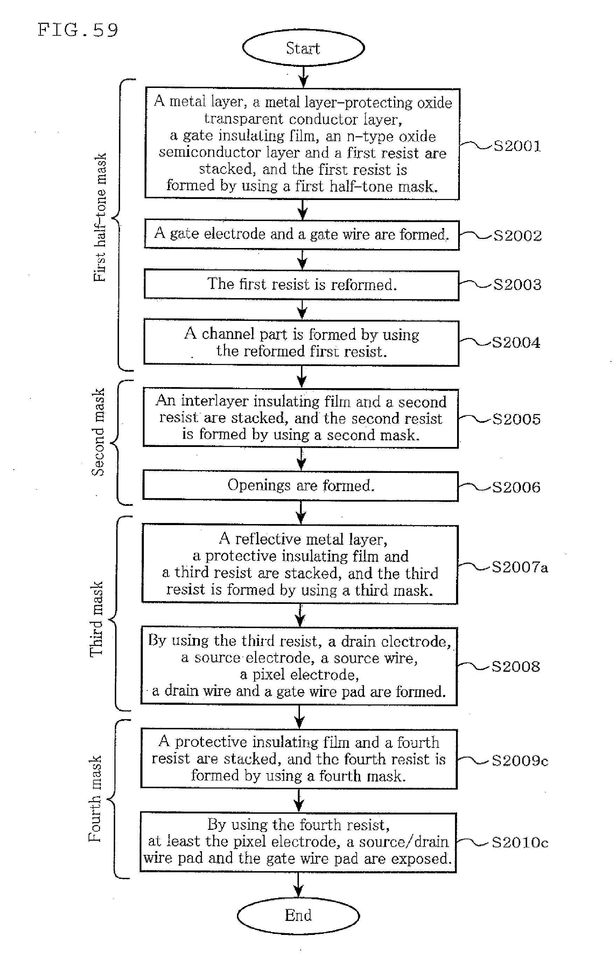

FIG. 59 is a schematic flow chart for explaining the method for producing a reflective TFT substrate according to a third embodiment of the invention. The method for producing a reflective TFT substrate this embodiment corresponds to claim 38.
The method for producing the reflective TFT substrate 2001c according to this embodiment shown in FIG. 59 differs from the above-mentioned first embodiment in the following points. Specifically, the protective insulating film 2070 c and a fourth resist 2071c are stacked above the reflective TFT substrate 2001a of the above-mentioned first embodiment (Step S2009c). Further, the source electrode 2063, the source wire 2065, the pixel electrode 2067, the drain wire pad 2068 and the gate wire pad 2025 are exposed by using the fourth resist 2071c (Step S2010c). The method shown in FIG. 59 differs from the method for producing the reflective TFT substrate 2001a in the first embodiment in these points.
Other steps are almost the same as those in the first embodiment of the method for producing the reflective TFT substrate 2001a. Therefore, in the drawing, the same steps are indicated by the same numerals as used in the first embodiment, and detailed explanation is omitted.

The treatment by using the first half-tone mask and the treatment by using the second mask shown in FIG. 59 are almost the same as those in the first embodiment.
After these treatments, as shown in FIG. 59, the protective insulating film 2070c and the fourth resist 2071c are stacked, and the fourth resist 2071c is formed into a predetermined shape by using a fourth mask 2072c (Step S2009c).
Next, treatment using the fourth mask 2072c will be explained below referring to the drawing.

### (Treatment using a fourth mask)

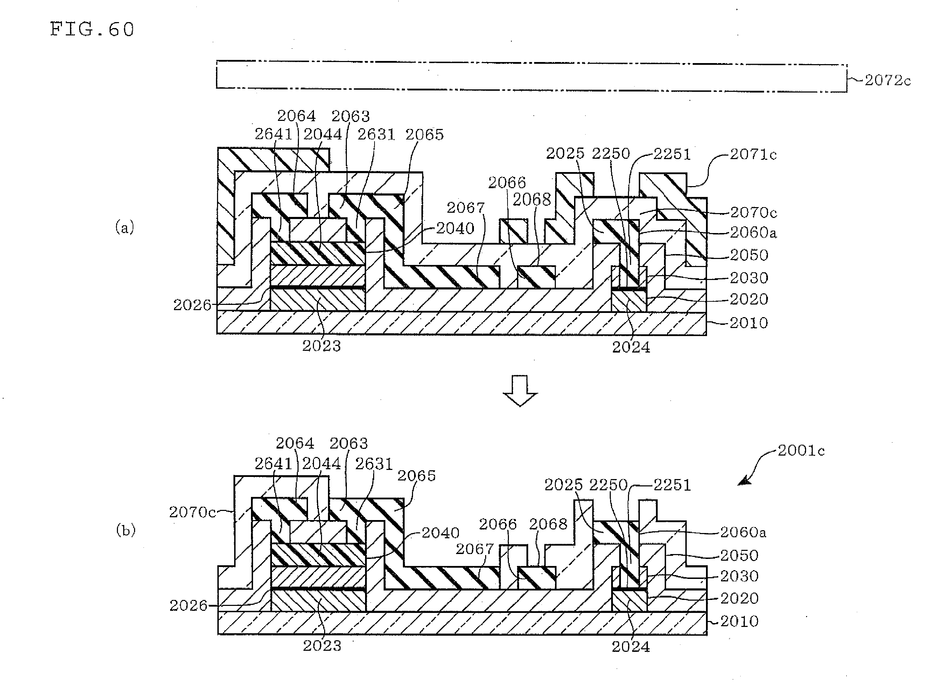

FIG. 60 is a schematic view for explaining treatment using a fourth mask in the method for producing a TFT substrate according to the third embodiment of the invention, in which (a) is a cross-sectional view after the formation of a protective insulating film/after the application of a fourth resist/after exposure/after development; and (b) is a cross-sectional view after fifth etching/after peeling off the fourth resist.
In FIG. 60(a), first, a protective insulating film 2070c, which is a silicon nitride (SiNₓ) film, is deposited in a thickness of about 200 nm by the glow discharge CVD (Chemical Vapor Deposition) method on the interlayer insulating film 2050 and the reflective metal layer 2060a. In this embodiment, an SiH₄-NH₃-N₂-based mixed gas is used as a discharge gas.
Next, the fourth resist 2071c is applied on the protective insulating film 2070c and the fourth resist 2071c is formed into a predetermined shape with the fourth mask 2072c (Step S2009c). That is, the fourth resist 2071c is formed in such a shape that the protective insulating film 2070c above the source electrode 2063, the source wire 2065, the pixel electrode 2067, the drain wire pad 2068 and the gate wire pad 2025 is exposed (Step S2009c).
In this embodiment, the source electrode 2063 and the source wire 2065 are also exposed. However, the configuration is not limited thereto. For example, it suffices that at least the pixel electrode 2067, the drain wire pad 2068 and the gate wire pad 2025 are exposed.

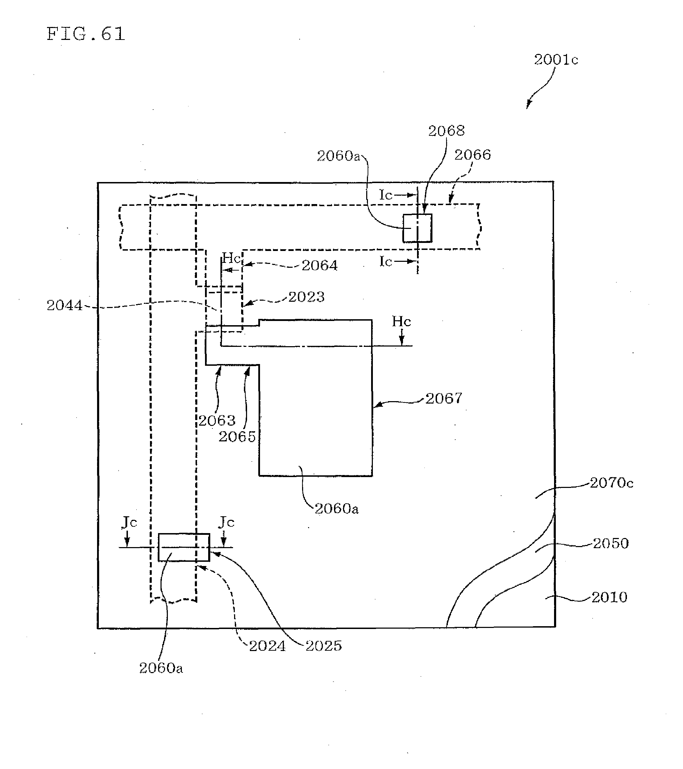

Next, as shown in FIG. 60(b), as a fifth etching, the exposed protective insulating film 2070c is patterned with a dry etching method by using the fourth resist 2071c and an etching gas (CHF (CF₄, CHF₃ gas, or the like), whereby the source electrode 2063, the source wire 2065, the pixel electrode 2067, the drain wire pad 2068 and the gate wire pad 2025 are exposed (Step S2010c). Subsequently, the fourth resist 2071c is removed through an ashing process, whereby the protective insulating film 2070c is exposed above the glass substrate 2010 as shown in FIG. 61. The drain electrode 2064, the gate electrode 2023, the channel part 2044, the source electrode 2063, the source wire 2065 and the pixel electrode 2067 shown in FIG. 60(b) are cross-sectional views taken along line Hc-Hc in FIG. 61. The drain wire pad 2068 shown in FIG. 60(b) is a cross-sectional view taken along line Ic-Ic in FIG. 61. The gate wire pad 2025 shown in FIG. 60(b) is a cross-sectional view taken along line Jc-Jc in FIG. 61.

As is apparent from the above, according to the method for producing the reflective TFT substrate 2001c in this embodiment, advantageous effects almost similar to those attained in the first embodiment are attained. Further, the drain electrode 2064 and the drain wire 2066 are covered with the protective insulating film 2070c so as to not to be exposed. As a result, the reflective TFT substrate 2001c is provided with the protective insulating film 2070c. Therefore, it is possible to provide the reflective TFT substrate 2001c capable of producing readily a display means or an emitting means utilizing a liquid crystal, an organic EL material or the like.

### [Method for producing a reflective TFT substrate according to a fourth embodiment]

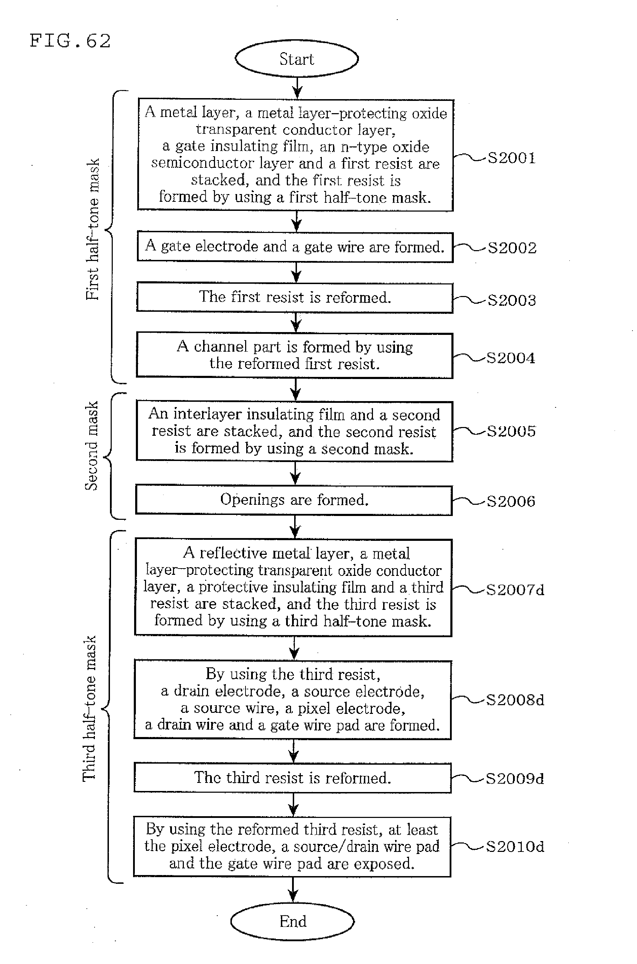

FIG. 62 is a schematic flow chart for explaining the method for producing a reflective TFT substrate according to a fourth embodiment of the invention. The method for producing a reflective TFT substrate in this embodiment corresponds to claims 37 and 40.
The method for producing the reflective TFT substrate 2001d according to this embodiment shown in FIG. 62 differs from the method for producing the reflective TFT substrate 2001b in the above-mentioned second embodiment in the following point. Specifically, the metal layer-protecting oxide transparent conductor layer 2069 is stacked above the reflective metal layer 2060a (Step S2007d). The method shown in FIG. 62 differs from the second embodiment of the method for producing a reflective TFT substrate 2001b in this point.
Other steps are almost the same as those in the method for producing the reflective TFT substrate 2001b in the second embodiment. Therefore, in the drawing, the same steps are indicated by the same numerals as used in the second embodiment, and detailed explanation is omitted.

The treatment by using the first half-tone mask and the treatment by using the second mask shown in FIG. 62 are almost the same as those in the second embodiment.
Next, treatment using the third half-tone mask 2072d will be explained below referring to the drawing.

### (Treatment using a third half-tone mask)

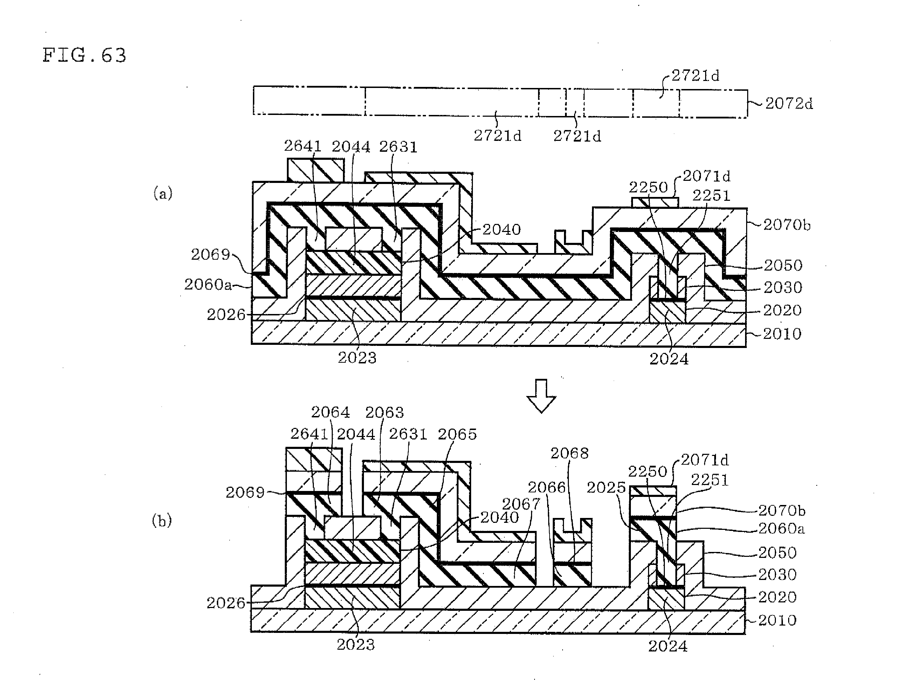

FIG. 63 is a schematic view for explaining treatment using a third half-tone mask in the method for producing a reflective TFT substrate according to the fourth embodiment of the invention, in which (a) is a cross-sectional view after the formation of a reflective metal layer/after the formation of a metal layer-protecting oxide transparent conductor layer/after the formation of a protective insulating film/after the application of a third resist/after half-tone exposure/after development; (b) is a cross-sectional view after fourth etching.
In FIG. 63(a), on the interlayer insulating film 2050, the n-type oxide semiconductor layer 2040 and the metal layer-protecting oxide transparent conductor layer 2026, which are exposed, Al is deposited in a thickness of about 120 nm, whereby a reflective metal layer 2060a composed of Al is formed. That is, an Al thin film layer is formed by the high-frequency sputtering method using an Al target in an atmosphere of argon 100%.

Next, on the reflective metal layer 2060a, the metal layer-protecting oxide transparent conductor layer 2069 is formed in a thickness of about 50 nm by using an indium oxide-zinc oxide (generally called IZO; In₂O₃:ZnO=about 90:10 wt%) sputtering target. This layer formation is conducted under the condition of an oxygen-to-argon ratio of about 1:99 (vol%) and a substrate temperature of about 150°C. Under this condition, the metal layer-protecting oxide transparent conductor layer 2069 is obtained as an amorphous film. By doing this, since the metal layer-protecting oxide transparent conductor layer 2069 can be etched with an acid mixture simultaneously with the reflective metal layer 2060a, production efficiency can be improved.

Next, on the metal layer-protecting oxide transparent conductor layer 2069, a protective insulating film 2070b, which is a silicon nitride (SiNₓ) film, is deposited in a thickness of about 200 nm by the glow discharge CVD (Chemical Vapor Deposition) method. In this embodiment, an SiH₄-NH₃-N₂-based mixed gas is used as a discharge gas.

Next, as shown in FIG. 63(a), the third resist 2071d is applied on the protective insulating film 2070b, and the third resist 2071d is formed into a predetermined shape by using the third half-tone mask 2072d by half-tone exposure (Step S2007d). That is, the third resist 2071d is formed in such a shape that it covers the drain electrode 2064, the source electrode 2063, the source wire 2065, the drain wire 2066, the pixel electrode 2067 and the gate wire pad 2025. In addition, the third resist 2071d is formed in such a shape that the parts of the third resist 2071d covering the source electrode 2063, the source wire 2065, the pixel electrode 2067, the drain wire pad 2068 and the gate wire pad 2025 are rendered thinner than other parts due to a half-tone mask part 2721d (see FIG. 63(b)).

Subsequently, as shown in FIG. 63(b), as a fourth etching, the exposed protective insulating film 2070b is patterned with a dry etching method by using the third resist 2071d and an etching gas (CHF (CF₄, CHF₃ gas, or the like). Further, the metal layer-protecting oxide transparent conductor layer 2069 and the reflective metal layer 2060a are simultaneously patterned with an etching method by using the third resist 2071b and an etching solution (an acid mixture), whereby the drain electrode 2064, the source electrode 2063, the source wire 2065, the pixel electrode 2067, the drain wire 2066 and the gate wire pad 2025 are formed (Step S2008d).

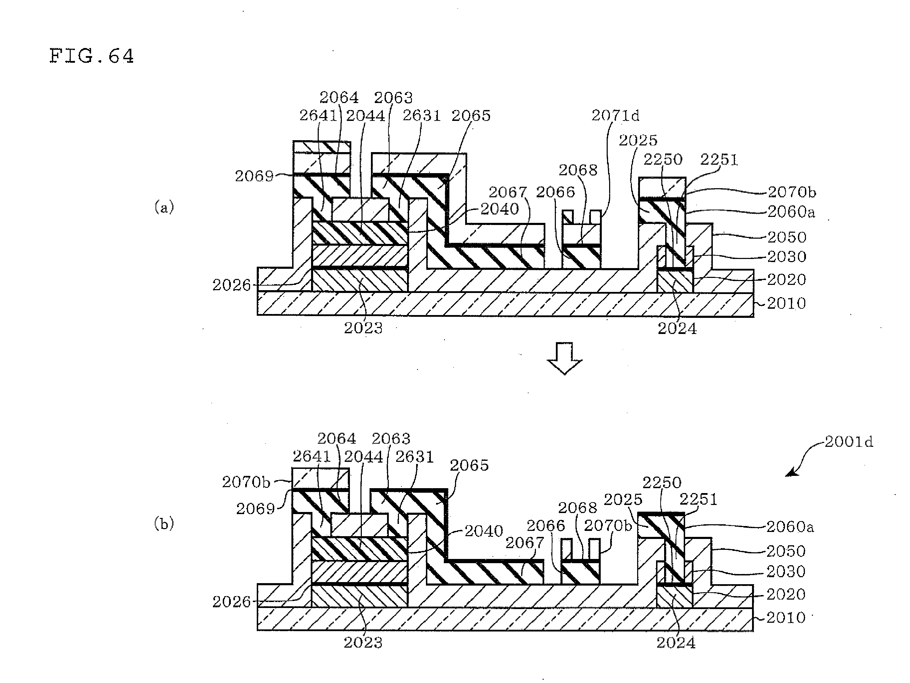

FIG. 64 is a schematic view for explaining treatment using a third half-tone mask in the method for producing a reflective TFT substrate according to the fourth embodiment of the invention, in which (a) is a cross-sectional view after the reformation of a third resist; and (b) is a cross-sectional view after fifth etching/after peeling off the third resist.
In FIG. 64(a), the above-mentioned third resist 2071d is removed through an ashing process, and the third resist 2071d is reformed in such a shape that the protective insulating film 2070 above the source electrode 2063, the source wire 2065, the pixel electrode 2067, the drain wire pad 2068 and the gate wire pad 2025 is exposed (Step S2009d).

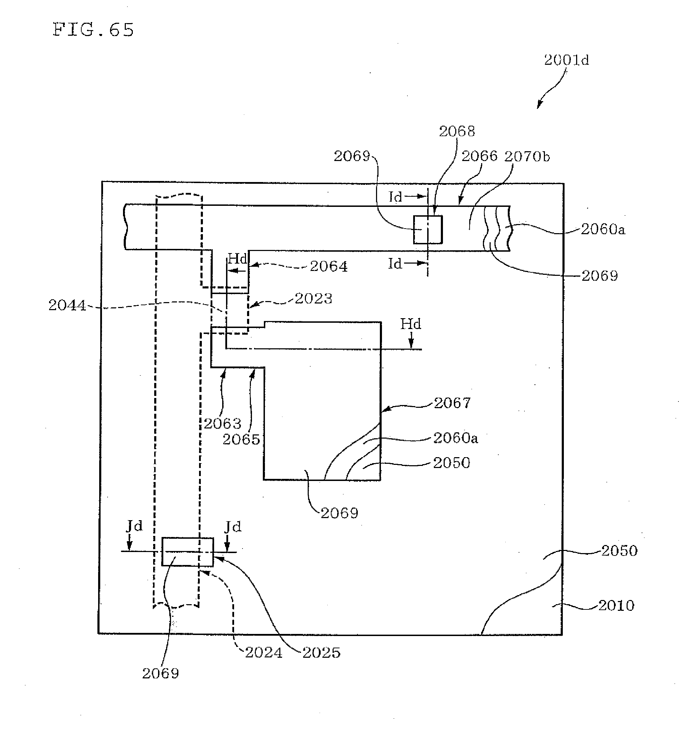

Next, as shown in FIG. 64(b), as a fifth etching, the exposed protective insulating film 2070b is patterned with a dry etching method by using the reformed third resist 2071b and an etching gas (CHF (CF₄, CHF₃ gas, or the like), whereby the source electrode 2063, the source wire 2065, the pixel electrode 2067, the drain wire pad 2068 and the gate wire pad 2025 are exposed (Step S2010d). Subsequently, the reformed third resist 2071b is removed through an ashing process, whereby the protective insulating film 2070b stacked above the drain electrode 2064 and the drain wire 2066 is exposed above the glass substrate 2010, as shown in FIG. 65. The drain electrode 2064, the gate electrode 2023, the channel part 2044, the source electrode 2063, the source wire 2065 and the pixel electrode 2067 shown in FIG. 64(b) are cross-sectional views taken along line Hd-Hd in FIG. 65. The drain wire pad 2068 shown in FIG. 64(b) is a cross-sectional view taken along line Id-Id in FIG. 65. The gate wire pad 2025 shown in FIG. 64(b) is a cross-sectional view taken along line Jd-Jd in FIG. 65.

As is apparent from the above, according to the method for producing the reflective TFT substrate 2001d in this embodiment, advantageous effects almost similar to those attained in the second embodiment of the method for producing a reflective TFT substrate are attained. Further, not only the reflective metal layer 2060a can be prevented from corrosion but also the durability thereof can be improved. Further, discoloration or other problems of the reflective metal layer 2060a can be prevented, and disadvantages such as a decrease in reflectance of the reflective metal layer 2060a can be prevented. In addition, in this embodiment, the protective insulating film 2070b is not formed above the source electrode 2063 and the source wire 2065 to expose the source electrode 2063 and the source wire 2065. Therefore, since the top surfaces of the source electrode 2063 and the source wire 2065 also function as the reflective layer, the amount of reflected light can be increased, resulting in improved luminance.
In the meantime, the metal layer-protecting oxide transparent conductor layer 2069 formed in this embodiment can also be formed in the above-mentioned first and the third embodiments of the method for producing a reflective TFT substrate, and the same advantageous effects as those attained in this embodiment can be attained.

### [Method for producing a reflective TFT substrate according to a fifth embodiment]

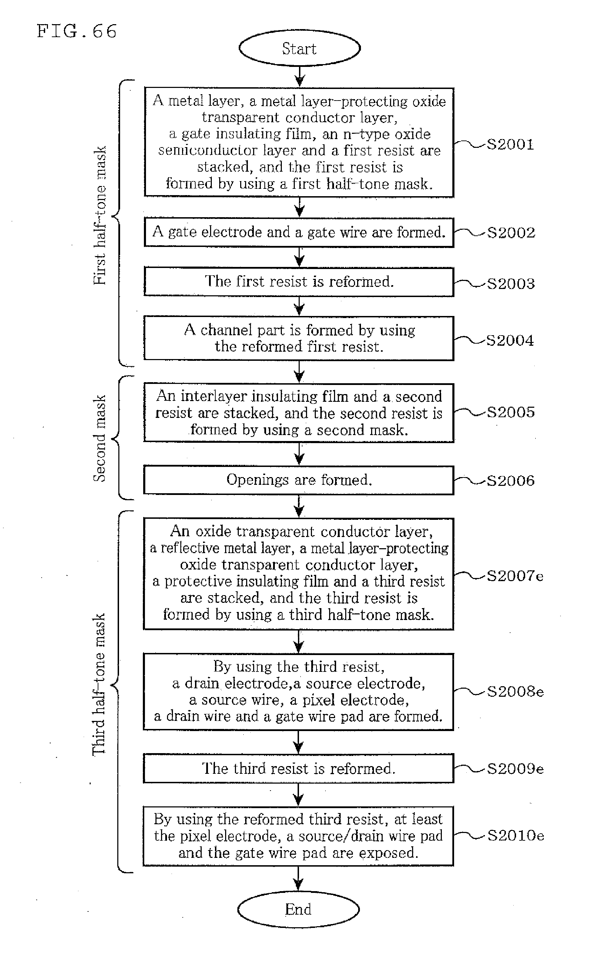

FIG. 66 is a schematic flow chart for explaining the method for producing a reflective TFT substrate according to a fifth embodiment of the invention. The method for producing a reflective TFT substrate in this embodiment corresponds to claims 37 and 39.
The method for producing the reflective TFT substrate 2001e according to this embodiment shown in FIG. 66 differs from the method for producing the reflective TFT substrate 2001d in the above-mentioned fourth embodiment in the following point. Specifically, the oxide transparent conductor layer 2060 is formed between the n-type oxide semiconductor layer 2040 and the reflective metal layer 2060a (Step S2007e). The method shown in FIG. 66 differs from the fourth embodiment of the method for producing a reflective TFT substrate 2001d in this point.
Other steps are almost the same as those in the method for producing the reflective TFT substrate 2001d in the fourth embodiment. Therefore, in the drawing, the same steps are indicated by the same numerals as used in the fourth embodiment, and detailed explanation is omitted.

The treatment by using the first half-tone mask and the treatment by using the second mask shown in FIG. 66 are almost the same as those in the fourth embodiment.
Next, treatment using the third half-tone mask 2072d will be explained below referring to the drawing.

### (Treatment using a third half-tone mask)

FIG. 67 is a schematic view for explaining treatment using a third half-tone mask in the method for producing a reflective TFT substrate according to the fifth embodiment of the invention, in which (a) is a cross-sectional view after the formation of an oxide transparent conductor layer/after the formation of a reflective metal layer/after the formation of a metal layer-protecting oxide transparent conductor layer/after the formation of a protective insulating film/after the application of a third resist/after half-tone exposure/after development; (b) is a cross-sectional view after fourth etching.

### Treatment using a third mask)

In FIG. 67(a), first, on the interlayer insulating film 2050, the n-type oxide semiconductor layer 2040 and the metal layer-protecting oxide transparent conductor layer 2026, which are exposed, the oxide transparent conductor layer 2060 is formed in a thickness of about 50 nm by using an indium oxide-zinc oxide (generally called IZO; In₂O₃:ZnO=about 90:10 wt%) sputtering target. This layer formation is conducted under the condition of an oxygen-to-argon ratio of about 1:99 (vol%) and a substrate temperature of about 150°C. Under this condition, the oxide transparent conductor layer 2060 is obtained as an amorphous film. By doing this, since simultaneous etching with the metal layer-protecting oxide transparent conductor layer 2069 and the reflective metal layer 2060e with an acid mixture is enabled, production efficiency can be improved.

Subsequently, a reflective metal layer 2060e is formed on the oxide transparent conductor layer 2060. First, by using the high-frequency sputtering method, Mo is formed in a thickness of about 50 nm. Subsequently, by using the high-frequency sputtering method, Al is formed in a thickness of about 250 nm. That is, though not shown, the reflective metal layer 2060e is formed of a Mo thin film layer and an Al thin film layer. First, the Mo thin film layer is formed by the high-frequency sputtering method using a Mo target in an atmosphere of argon 100%. Then, the Al thin film layer is formed by the high-frequency sputtering method using an Al target in an atmosphere of argon 100%.

Next, on the reflective metal layer 2060e, the metal layer-protecting oxide transparent conductor layer 2069 is formed in a thickness of about 50 nm by using an indium oxide-zinc oxide (generally called IZO; In₂O₃:ZnO=about 90:10 wt%) sputtering target. This layer formation is conducted under the condition of an oxygen-to-argon ratio of about 1:99 (vol%) and a substrate temperature of about 150°C.

Next, a protective insulating film 2070b, which is a silicon nitride (SiNₓ) film, is deposited in a thickness of about 100 nm by the glow discharge CVD (Chemical Vapor Deposition) method on the metal layer-protecting oxide transparent conductor layer 2069. In this embodiment, an SiH₄-NH₃-N₂-based mixed gas is used as a discharge gas.

Next, as shown in FIG. 67(a), the third resist 2071d is applied on the protective insulating film 2070b, and the third resist 2071d is formed into a predetermined shape by using the third half-tone mask 2072d by half-tone exposure (Step S2007e). That is, the third resist 2071d is formed in such a shape that it covers the drain electrode 2064, the source electrode 2063, the source wire 2065, the drain wire 2066, the pixel electrode 2067 and the gate wire pad 2025. In addition, the third resist 2071d is formed in such a shape that parts of the third resist 2071d covering the source electrode 2063, the source wire 2065, the pixel electrode 2067, the drain wire pad 2068 and the gate wire pad 2025 are rendered thinner than other parts due to a half-tone mask part 2721d (see FIG. 67(b)).

Subsequently, as shown in FIG. 67(b), as a fourth etching, the exposed protective insulating film 2070b is patterned with a dry etching method by using the third resist 2071d and an etching gas (CHF (CF₄, CHF₃ gas, or the like). Further, the metal layer-protecting oxide transparent conductor layer 2069, the reflective metal layer 2060e and the oxide transparent conductor layer 2060 are simultaneously patterned with an etching method by using the third resist 2071d and an etching solution (an acid mixture), whereby the drain electrode 2064, the source electrode 2063, the source wire 2065, the pixel electrode 2067, the drain wire 2066 and the gate wire pad 2025 are formed (Step S2008e).

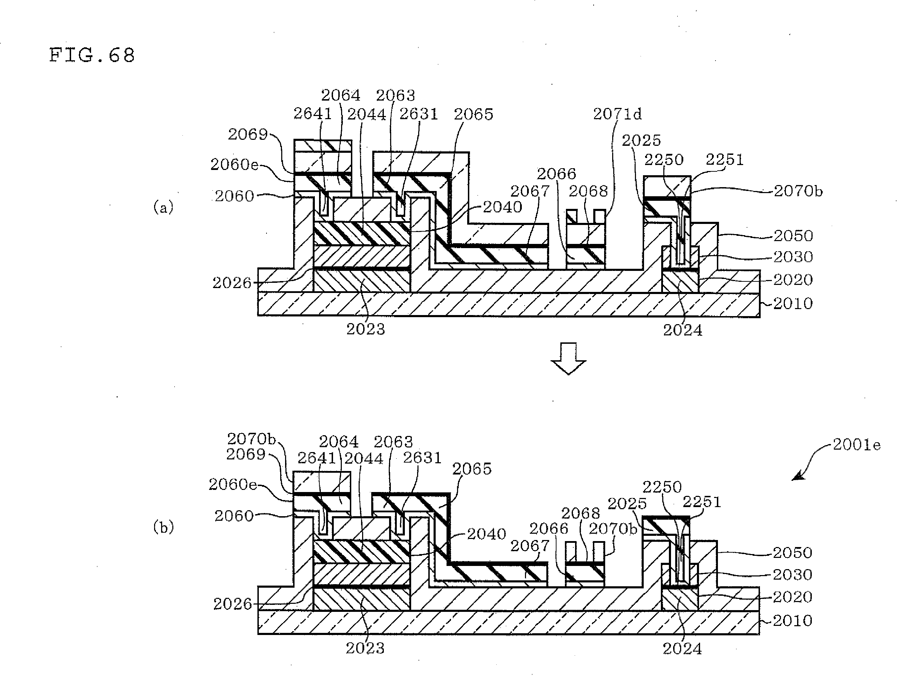

FIG. 68 is a schematic view for explaining treatment using a third half-tone mask in the method for producing a reflective TFT substrate according to the fifth embodiment of the invention, in which (a) is a cross-sectional view after the reformation of a third resist; and (b) is a cross-sectional view after fifth etching/after peeling off the third resist.
In FIG. 68(a), the above-mentioned third resist 2071d is removed through an ashing process, and the third resist 2071d is reformed in such a shape that the protective insulating film 2070b above the source electrode 2063, the source wire 2065, the pixel electrode 2067, the drain wire pad 2068 and the gate wire pad 2025 is exposed (Step S2009e).

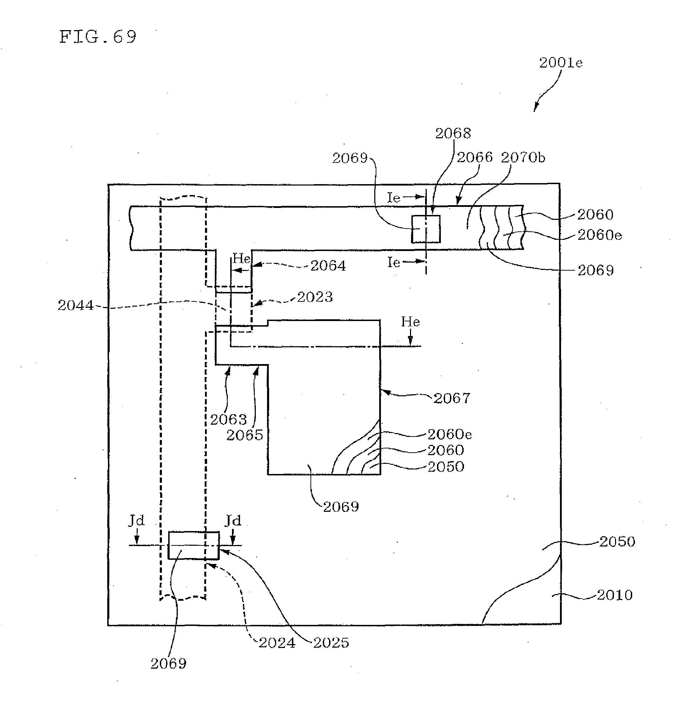

Next, as shown in FIG. 68(b), as a fifth etching, the exposed protective insulating film 2070b is patterned with a dry etching method by using the reformed third resist 2071d and an etching gas (CHF (CF₄, CHF₃ gas, or the like), whereby the source electrode 2063, the source wire 2065, the pixel electrode 2067, the drain wire pad 2068 and the gate wire pad 2025 are exposed (Step S2010e). Subsequently, the reformed third resist 2071d is removed through an ashing process, whereby the protective insulating film 2070b stacked above the drain electrode 2064 and the drain wire 2066 is exposed above the glass substrate 2010, as shown in FIG. 69. The drain electrode 2064, the gate electrode 2023, the channel part 2044, the source electrode 2063, the source wire 2065 and the pixel electrode 2067 shown in FIG. 68(b) are cross-sectional views taken along line He-He in FIG. 69. The drain wire pad 2068 shown in FIG. 68(b) is a cross-sectional view taken along line Ie-Ie in FIG. 69. The gate wire pad 2025 shown in FIG. 68(b) is a cross-sectional view taken along line Je-Je in FIG. 69.

As is apparent from the above, according to the method for producing the reflective TFT substrate 2001e in this embodiment, advantageous effects almost similar to those attained in the fourth embodiment of the method for producing a reflective TFT substrate are attained. Further, switching speed of a TFT can be increased, and durability of a TFT can be improved.
In the meantime, the oxide transparent conductor layer 2060 formed in this embodiment can also be formed in the above-mentioned first and the third embodiments of the method for producing a reflective TFT substrate, and the same advantageous effects as those attained in this embodiment can be attained.

### [A TFT substrate according to a fourth embodiment]

Next, a fourth embodiment of a TFT substrate 2001 of the invention will be explained.
As shown in FIG. 47(b) and FIG. 48, the TFT substrate 2001 according to the fourth embodiment comprises the glass substrate 2010, the gate electrode 2023, the gate wire 2024, the gate insulating film 2030, the n-type oxide semiconductor layer 2040, the interlayer insulating film 2050, the source electrode 2063 and the drain electrode 2064.
The gate electrode 2023 and the gate wire 2024 are formed on the glass substrate 2010.
The gate insulating film 2030 are formed above the gate electrode 2023 and the gate wire 2024, thereby insulating the top surfaces of the gate electrode 2023 and the gate wire 2024.
The n-type oxide semiconductor layer 2040 is formed above the gate electrode 2023 and above the gate insulating film 2030.
The interlayer insulating film 2050 is formed on the side of the gate insulating electrode 2023 and the gate wire 2024, as well as above and on the side of the n-type oxide semiconductor layer 2040. Therefore, the interlayer insulating film 2050 insulates the side surfaces of the gate insulating electrode 2023 and the gate wire 2024, as well as the n-type oxide semiconductor layer 2040. In the interlayer insulating film 2050, an opening for a source electrode 2631 and an opening for a drain electrode 2641 are respectively formed at positions where the channel part 2044 formed of the n-type oxide semiconductor layer 2040 is interposed.
The source electrode 2063 is formed in the opening for a source electrode 2631.
The drain electrode 2064 is formed in the opening for a drain electrode 2641.

In the TFT substrate 2001, as for the conductor layer constituting the source electrode 2063 and the drain electrode 2064, the same oxide transparent conductor layer 2060 is formed. At least the pixel electrode 2067 is formed from this oxide transparent conductor layer 2060.
In this embodiment, the oxide transparent conductor layer 2060 is used as the conductor layer. However, the conductor layer is not limited thereto. For example, a conductor layer composed of a metal may be used. By doing this, the TFT substrate can be operated stably for a prolonged period of time, and manufacturing yield can be improved. Further, a reflective TFT substrate capable of reducing manufacturing cost can be provided.
In addition, in the TFT substrate 2001, the n-type oxide semiconductor layer 2040 is used as the oxide layer. By using the n-type oxide semiconductor layer 2040 as an active layer for a TFT, the TFT substrate 2001 remains stable when electric current is flown. The TFT substrate 2001 is advantageously used for an organic EL apparatus which is operated under current control mode.

Further, in the TFT substrate 2001, the n-type oxide semiconductor layer 2040 is formed at predetermined positions corresponding to the channel part 2044, the source electrode 2063 and the drain electrode 2064. Due to such a configuration, the n-type oxide semiconductor layer 2040 is normally formed only at the predetermined positions, concern for occurrence of interference of the gate wires 2024 (crosstalk) can be eliminated.

As is apparent from the above, in the TFT substrate 2001 of this embodiment, since the n-type oxide semiconductor layer 2040 constituting the channel part 2044 is protected by the interlayer insulating film 2050, the TFT substrate 2001 can be operated stably for a prolonged period of time. In addition, the channel part 2044, the drain electrode 2064 and the source electrode 2063 can be produced readily without fail. Therefore, not only manufacturing yield can be improved but also manufacturing cost can be decreased. In addition, the number of masks used in the production can be decreased, leading to the reduction of production steps. As a result, production efficiency can be improved and manufacturing cost can be reduced.

In the meantime, the TFT substrate 2001 has a variety of application examples. For example, as shown in FIG. 50 (b) and FIG. 51, the TFT substrate 2001 may have a configuration in which the upper part of the glass substrate 2010 is covered with the protective insulating film 2070, and the protective insulating film 2070 has openings at positions corresponding to the pixel electrode 2067, the drain wire pad 2068 and the gate wire pad 2025. Due to such a configuration, the TFT substrate 2001' is provided with the protective insulating film 2070. As a result, it is possible to provide a TFT substrate 2001' capable of producing readily a display means or an emitting means utilizing a liquid crystal, an organic EL material or the like.
In the meantime, in this embodiment, on the glass substrate 2010, the metal layer 2020, the gate insulating film 2030 and the n-type oxide semiconductor layer 2040 are stacked, and further the interlayer insulating film 2050 and the oxide transparent conductor layer 2060 are stacked. The stacking configuration is, however, not limited thereto. For example, these layers may be stacked with other layers being interposed therebetween. Here, "other layers" mean, for example, layers which do not impair the functions or the effects of this embodiment or layers which allow other functions or effects to be exhibited. The same applies to the embodiments given later.

### [A reflective TFT substrate according to a first embodiment]

Next, a first embodiment of a reflective TFT substrate 2001a of the invention will be explained.
As shown in FIG. 53(b) and FIG. 54, the TFT substrate 2001a according to the first embodiment comprises a substrate 2010, the gate electrode 2023, the gate wire 2024, the n-type oxide semiconductor layer 2040 as an oxide layer, the reflective metal layer 2060a and the channel guard 2500.
The gate electrode 2023 and the gate wire 2024 are formed on the glass substrate 2010. Further, the gate electrode 2023 and the gate wire 2024 are insulated by having their top surfaces covered with the gate insulating film 2030 and by having their side surfaces covered with the interlayer insulating film 2050.
The n-type oxide semiconductor layer 2040 is formed above the gate electrode 2023 and above the gate insulating film 2030.
The reflective metal layer 2060a is formed on the n-type oxide semiconductor layer 2040 with the channel part 2044 interposed therebetween.
The channel guard 2500 is formed on the channel part 2044 composed of the n-type oxide semiconductor layer 2040 and protects the channel part 2044.

The channel guard 2500 is composed of the interlayer insulating film 2050 in which a pair of openings 2631 and 2641 are formed. In the openings 2631 and 2641, the source electrode 2063 and the drain electrode 2064, each having the reflective metal layer 2060a, are formed.
Due to such a configuration, since the upper part of the n-type oxide semiconductor layer 2040 constituting the channel part 2044 is protected by the channel part 2500, the reflective TFT substrate 2001a can be operated stably for a prolonged period of time. In addition, the channel guard 2500, the channel part 2044, the drain electrode 2064 and the source electrode 2063 can be produced readily without fail. Therefore, not only manufacturing yield can be improved but also manufacturing cost can be decreased.

Further, it is preferred that the reflective metal layer 2060a be composed of a thin film composed of aluminum, silver or gold or an alloy layer containing aluminum, silver or gold. Due to such a configuration, a larger amount of light can be reflected, whereby the luminance by the reflected light can be improved.

In the reflective TFT substrate 2001a, the channel guard 2500 is formed of the interlayer insulating film 2050, and in the pair of openings 2641 and 2631 of the interlayer insulating film 2050, the drain electrode 2064 and the source electrode 2063 are respectively formed. Due to such a configuration, the channel part 2044, the drain electrode 2064 and the source electrode 2063 can be produced easily without flail. Therefore, not only manufacturing yield can be improved but also manufacturing cost can be decreased.

Further, in the reflective TFT substrate 2001a, the source wire 2065, the drain wire 2066, the source electrode 2063, the drain electrode 2064 and the pixel electrode 2067 are formed from the reflective metal layer 2060a. As a result, as mentioned above, the source wire 2065, the drain wire 2066, the source electrode 2063, the drain electrode 2064 and the pixel electrode 2067 can be produced efficiently. That is, the number of masks used in the production can be decreased, leading to the reduction of production steps. As a result, production efficiency can be improved and manufacturing cost can be reduced.
In addition, in the reflective TFT substrate 2001a, the n-type oxide semiconductor layer 2040 is used as the oxide layer. By using the oxide semiconductor layer as an active layer for a TFT, the TFT remains stable when electric current is flown. Therefore, the reflective TFT substrate 2001a is advantageously used for an organic EL apparatus which is operated under current control mode. Further, since the energy gap of the n-type oxide semiconductor layer 2040 is rendered 3.0 eV or more, malfunction caused by light can be prevented.

In the reflective TFT substrate 2001a, the n-type oxide semiconductor layer 2040 is formed at predetermined positions corresponding to the channel part 2044, the source electrode 2063 and the drain electrode 2064. Due to such a configuration, concern for occurrence of interference of the gate wires 2024 (crosstalk) can be eliminated.

In addition, in the reflective TFT substrate 2001a, since the gate electrode 2023 and the gate wire 2024 are formed of the metal layer 2020 and the metal layer-protecting oxide transparent conductor layer 2026, not only the metal layer 2020 can be prevented from corrosion but also the durability thereof can be improved. Due to such a configuration, the metal surface can be prevented from being exposed when the opening 2251 for the gate wire pad 2025 is formed, whereby connection reliability can be improved.

As is apparent from the above, in the reflective TFT substrate 2001a of this embodiment, since the upper part of the n-type oxide semiconductor layer 2040 constituting the channel part 2044 is protected by the interlayer insulating film 2050, the reflective TFT substrate 2001a can be operated stably for a prolonged period of time. In addition, the channel guard 2500, the channel part 2044, the drain electrode 2064 and the source electrode 2063 can be produced easily without fail. Therefore, not only manufacturing yield can be improved but also manufacturing cost can be decreased.

### [A reflective TFT substrate according to a second embodiment]

Next, a second embodiment of a reflective TFT substrate 2001b of the invention will be explained.
As shown in FIG. 57(b) and FIG. 58, the reflective TFT substrate 2001b according to the second embodiment differs from the reflective TFT substrate 2001a according to the first embodiment in the following points. That is, the reflective TFT substrate 2001b according to the second embodiment is provided with the protective insulating film 2070b covering the upper part of the source electrode 2063, the source wire 2065, the drain electrode 2064 and the drain wire 2066, and the protective insulating film 2070b has openings above the pixel electrode 2067, the drain wire pad 2068 and the gate wire pad 2025, respectively. The reflective TFT substrate 2001b of this embodiment differs from the reflective TFT substrate 2001a of the first embodiment in these points. Other configurations are almost similar to those of the reflective TFT substrate 2001a.

As is apparent from the above, in the reflective TFT substrate 2001b of this embodiment, since the upper part of the source electrode 2063, the drain electrode 2064, the source wire 2065 and the drain wire 2066 is covered with the protective insulating film 2070b, operation stability of a TFT can be improved.
In this embodiment, the protective insulating film 2070b is formed on the source electrode 2063 and the source wire 2065. However, a configuration in which this protective insulating film 2070b is not formed may be adopted. Due to such a configuration, since the upper part of the source electrode 2063 and the source wire 2065 also functions as a reflective layer, the amount of reflected light can be increased, resulting in improved luminance.

### [A reflective TFT substrate according to a third embodiment]

Next, a third embodiment of a reflective TFT substrate 2001c of the invention will be explained.
As shown in FIG. 60(b) and FIG. 61, the reflective TFT substrate 2001c according to the third embodiment differs from the reflective TFT substrate 2001a according to the first embodiment in the following points. That is, the upper part of the glass substrate 2010 is covered almost entirely with the protective insulating film 2070c, and the protective insulating film 2070c has openings at positions corresponding to the source electrode 2063, the source wire 2065, the pixel electrode 2067, the drain wire pad 2068 and the gate wire pad 2025. The reflective TFT substrate 2001c of this embodiment differs from the reflective TFT substrate 2001a of the first embodiment in these points. Other configurations are almost similar to those of the reflective TFT substrate 2001a.

As is apparent from the above, the TFT substrate 2001c in this embodiment is provided with the protective insulating film 2070c. Therefore, it is possible to provide a reflective TFT substrate 2001c capable of producing readily a display means or an emitting means utilizing a liquid crystal, an organic EL material or the like.
In the meantime, the reflective TFT of the invention has a variety of application examples other than the above-mentioned embodiments. For example, a reflective TFT substrate 2001d shown in FIG. 64 (b) and FIG. 65 may have a configuration in which the metal layer-protecting oxide transparent conductor layer 2069 for protecting the reflective metal layer 2060a is provided on the reflective metal layer 2060a. Due to such a configuration, discoloration or other problems of the reflective metal layer 2060a can be prevented, and disadvantages such as a decrease in reflectance of the reflective metal layer 2060a can be prevented. In addition, since the metal layer-protecting oxide transparent conductor layer 2069 is rendered transparent, the amount of transmitted light is not decreased. As a result, a display apparatus improved in luminance can be provided.
Further, as one of the application examples, a reflective TFT substrate 2001e shown in FIG. 68(b) and FIG. 69 is provided with the oxide transparent conductor layer 2060 between the n-type oxide semiconductor layer 2040 and the reflective metal layer 2060a. Due to such a configuration, switching speed of a TFT can be increased, and durability of a TFT can be improved.

Hereinabove, the TFT substrate and the reflective TFT substrate of the invention, as well as the method for producing thereof are explained with reference to preferable embodiments. The TFT substrate and the reflective TFT substrate of the invention, as well as the method for producing thereof are not limited to those mentioned above, and it is needless to say that various modifications can be made within the scope of the invention.

### INDUSTRIAL APPLICABILITY

The TFT substrate, the reflective TFT substrate and the method for producing thereof of the invention are not limited to a TFT substrate and a reflective TFT substrate used in LCD (liquid display) apparatuses or organic EL display apparatuses and the method for producing thereof. The invention can also be applied to a TFT substrate and a reflective TFT substrate for display apparatuses other than LCD (liquid crystal display) apparatuses or organic EL display apparatuses and the method for producing thereof, or to a TFT substrate and a reflective TFT substrate for other applications, as well as the method for producing thereof.

## Claims

1. A TFT substrate comprising:
a substrate;
a gate electrode and a gate wire formed above the substrate and insulated by having their top surfaces covered with a gate insulating film and by having their side surfaces covered with an interlayer insulating film;
an oxide layer formed above the gate electrode and above the gate insulating film;
a conductor layer formed above the oxide layer with a channel part interposed therebetween; and
a channel guard formed above the channel part for protecting the channel part.

2. The TFT substrate according to claim 1, wherein the oxide layer is an n-type oxide semiconductor layer.

3. The TFT substrate according to claim 1 or 2, wherein the channel guard is composed of the interlayer insulating film and a drain electrode and a source electrode composed of the conductor layer are respectively formed in a pair of openings of the interlayer insulating film.

4. The TFT substrate according to any one of claims 1 to 3, wherein the conductor layer is an oxide conductor layer and/or a metal layer.

5. The TFT substrate according to any one of claims 1 to 4, wherein the conductor layer functions at least as a pixel electrode.

6. The TFT substrate according to any one of claims 1 to 5, wherein the oxide layer is formed at predetermined positions corresponding to the channel part, a source electrode and a drain electrode.

7. The TFT substrate according to any one of claims 1 to 6, wherein the upper part of the substrate is covered with a protective insulating film and the protective insulating film has openings at positions corresponding to a pixel electrode, a source/drain wire pad and a gate wire pad.

8. The TFT substrate according to any one of claims 1 to 7, wherein the TFT substrate comprises at least one of the gate electrode, the gate wire, a source wire, a drain wire, a source electrode, a drain electrode and a pixel electrode, and an auxiliary conductive layer is formed above at least one of the gate electrode, the gate wire, the source wire, the source electrode, the drain electrode and the pixel electrode.

9. The TFT substrate according to any one of claims 1 to 8, wherein the TFT substrate comprises a metal layer and comprises a metal layer-protecting oxide conductor layer for protecting the metal layer.

10. The TFT substrate according to any one of claims 1 to 9, wherein the TFT substrate comprises at least one of the gate electrode, the gate wire, a source wire, a drain wire, a source electrode, a drain electrode and a pixel electrode, and at least one of the gate electrode, the gate wire, the source wire, the drain wire, the source electrode, the drain electrode and the pixel electrode is formed of an oxide transparent conductor layer.

11. The TFT substrate according to any one of claims 1 to 10, wherein the energy gap of the oxide layer and/or the conductor layer is 3.0 eV or more.

12. The TFT substrate according to any one of claims 1 to 11, wherein the TFT substrate comprises a pixel electrode and part of the pixel electrode is covered with a reflective metal layer.

13. The TFT substrate according to claim 12, wherein the reflective metal layer functions as at least one of a source wire, a drain wire, a source electrode and a drain electrode.

14. The TFT substrate according to claim 12 or 13, wherein the reflective metal layer is formed of a thin film of aluminum, silver or gold or an alloy layer containing aluminum, silver or gold.

15. A reflective TFT substrate comprising:
a substrate;
a gate electrode and a gate wire formed above the substrate and insulated by having their top surfaces covered with a gate insulating film and by having their side surfaces covered with an interlayer insulating film;
an oxide layer formed above the gate electrode and above the gate insulating film;
a reflective metal layer formed above the oxide layer with a channel part interposed therebetween; and
a channel guard formed above the channel part for protecting the channel part.

16. The reflective TFT substrate according to claim 15, wherein the oxide layer is an n-type oxide semiconductor layer.

17. The reflective TFT substrate according to claim 15 or 16, wherein the channel guard is composed of the interlayer insulating film and a drain electrode and a source electrode are respectively formed in a pair of openings of the interlayer insulating film.

18. The reflective TFT substrate according to any one of claims 15 to 17, wherein the reflective metal layer functions at least as a pixel electrode.

19. The reflective TFT substrate according to any one of claims 15 to 18, wherein the oxide layer is formed at predetermined positions corresponding to the channel part, a source electrode and a drain electrode.

20. The reflective TFT substrate according to any one of claims 15 to 19, wherein the upper part of the substrate is covered with a protective insulating film and the protective insulating film has openings at positions corresponding to a pixel electrode, a source/drain wire pad and a gate wire pad.

21. The reflective TFT substrate according to any one of claims 15 to 20, wherein the reflective TFT substrate comprises a reflective metal layer and/or a metal thin film, and comprises a metal layer-protecting oxide transparent conductor layer for protecting the reflective metal layer and/or the metal thin film.

22. The reflective TFT substrate according to any one of claims 15 to 21, wherein the energy gap of the oxide layer is 3.0 eV or more.

23. The reflective TFT substrate according to any one of claims 15 to 22, wherein the reflective metal layer is formed from a thin film of aluminum, silver or gold or an alloy layer containing aluminum, silver or gold.

24. A method for producing a TFT substrate comprising the steps of:
stacking a thin film for a gate electrode/gate wire from which a gate electrode and a gate wire are formed, a gate insulating film, a first oxide layer and a first resist above a substrate;
forming the first resist into a predetermined shape by half-tone exposure by using a first half-tone mask;
patterning the thin film for a gate electrode/gate wire, the gate insulating film and the first oxide layer with an etching method to form the gate electrode and the gate wire;
reforming the first resist into a predetermined shape;
patterning the first oxide layer with an etching method to form a channel part;
stacking an interlayer insulating film and a second resist;
forming the second resist into a predetermined shape by using a second mask;
patterning the interlayer insulating film with an etching method to form openings at positions where a source electrode and a drain electrode are formed and patterning the interlayer insulating film and the gate insulting film with an etching method to form an opening for a gate wire pad at a position where a gate wire pad is formed;
stacking a second oxide layer and a third resist;
forming the third resist into a predetermined shape by using a third mask; and
patterning the second oxide layer with an etching method to form the source electrode, the drain electrode, a source wire, a drain wire, a pixel electrode and the gate wire pad.

25. A method for producing a TFT substrate comprising the steps of:
stacking a thin film for a gate electrode/gate wire from which a gate electrode and a gate wire are formed, a gate insulating film, a first oxide layer and a first resist above a substrate;
forming the first resist into a predetermined shape by half-tone exposure by using a first half-tone mask;
patterning the thin film for a gate electrode/gate wire, the gate insulating film and the first oxide layer with an etching method to form the gate electrode and the gate wire;
reforming the first resist into a predetermined shape;
patterning the first oxide layer with an etching method to form a channel part;
stacking an interlayer insulating film and a second resist;
forming the second resist into a predetermined shape by using a second mask;
patterning the interlayer insulating film with an etching method to form openings at positions where a source electrode and a drain electrode are formed and patterning the interlayer insulating film and the gate insulting film with an etching method to form an opening for a gate wire pad at a position where a gate wire pad is formed;
stacking a second oxide layer, a protective insulating film and a third resist;
forming the third resist into a predetermined shape by half-tone exposure by using a third mask;
patterning the second oxide layer and the protective insulating film with an etching method to form the source electrode, the drain electrode, a source wire, a drain wire, a pixel electrode and the gate wire pad;
reforming the third resist into a predetermined shape; and
patterning the protective insulating film with an etching method to expose a source/drain wire pad, the pixel electrode and the gate wire pad.

26. A method for producing a TFT substrate comprising the steps of:
stacking a thin film for a gate electrode/gate wire from which a gate electrode and a gate wire are formed, a gate insulating film, a first oxide layer and a first resist above a substrate;
forming the first resist into a predetermined shape by half-tone exposure by using a first half-tone mask;
patterning the thin film for a gate electrode/gate wire, the gate insulating film and the first oxide layer with an etching method to form the gate electrode and the gate wire;
reforming the first resist into a predetermined shape;
patterning the first oxide layer with an etching method to form a channel part;
stacking an interlayer insulating film and a second resist;
forming the second resist into a predetermined shape by using a second mask;
patterning the interlayer insulating film with an etching method to form openings at positions where a source electrode and a drain electrode are formed and patterning the interlayer insulating film and the gate insulting film with an etching method to form an opening for a gate wire pad at a position where a gate wire pad is formed;
stacking a second oxide layer and a third resist;
forming the third resist into a predetermined shape by using a third mask;
patterning the second oxide layer with an etching method to form the source electrode, the drain electrode, a source wire, a drain wire, a pixel electrode and the gate wire pad;
stacking a protective insulating film and a fourth resist;
forming the fourth resist into a predetermined shape; and
patterning the protective insulating film with an etching method to expose a source/drain wire pad, the pixel electrode and the gate wire pad.

27. A method for producing a TFT substrate comprising the steps of:
stacking a thin film for a gate electrode/gate wire from which a gate electrode and a gate wire are formed, a gate insulating film, a first oxide layer and a first resist above a substrate;
forming the first resist into a predetermined shape by half-tone exposure by using a first half-tone mask;
patterning with an etching method the thin film for a gate electrode/gate wire, the gate insulating film and the first oxide layer to form the gate electrode and the gate wire;
reforming the first resist into a predetermined shape;
patterning the first oxide layer with an etching method to form a channel part;
stacking an interlayer insulating film and a second resist;
forming the second resist into a predetermined shape by using a second mask;
patterning the interlayer insulating film with an etching method to form openings at positions where a source electrode and a drain electrode are formed and patterning the interlayer insulating film and the gate insulting film with an etching method to form an opening for a gate wire pad at a position where a gate wire pad is formed;
stacking a second oxide layer, an auxiliary conductive layer, a protective insulating film and a third resist;
forming the third resist into a predetermined shape by using a third half-tone mask by half-tone exposure;
patterning the second oxide layer, the auxiliary conductive layer and the protective insulating film with an etching method to form the source electrode, the drain electrode, a source wire, a drain wire, a pixel electrode and the gate wire pad;
reforming the third resist into a predetermined shape; and
patterning the auxiliary conductive layer and the protective insulating film with an etching method to expose a source/drain wire pad, the pixel electrode and the gate wire pad.

28. A method for producing a TFT substrate comprising the steps of:
stacking a thin film for a gate electrode/gate wire from which a gate electrode and gate wire are formed, a gate insulating film, a first oxide layer and a first resist above a substrate;
forming the first resist into a predetermined shape by half-tone exposure by using a first half-tone mask;
patterning the thin film for a gate electrode/gate wire, the gate insulating film and the first oxide layer with an etching method to form the gate electrode and the gate wire;
reforming the first resist into a predetermined shape;
patterning the first oxide layer with an etching method to form a channel part;
stacking an interlayer insulating film and a second resist;
forming the second resist into a predetermined shape by using a second mask;
patterning the interlayer insulating film with an etching method to form openings at positions where a source electrode and a drain electrode are formed and patterning the interlayer insulating film and the gate insulting film with an etching method to form an opening for a gate wire pad at a position where a gate wire pad is formed;
stacking a second oxide layer, an auxiliary conductive layer and a third resist;
forming the third resist into a predetermined shape by using a third mask; and
patterning the second oxide layer and the auxiliary conductive layer with an etching method to form a source electrode, a drain electrode, a source wire, a drain wire, a pixel electrode and the gate wire pad;
stacking a protective insulating film and a fourth resist;
forming the fourth resist into a predetermined shape; and
patterning the protective insulating film with an etching method to expose a source/drain wire pad, the pixel electrode and the gate wire pad.

29. A method for producing a TFT substrate comprising the steps of:
stacking a thin film for a gate electrode/gate wire from which a gate electrode and a gate wire are formed, a gate insulating film, a first oxide layer and a first resist above a substrate;
forming the first resist into a predetermined shape by half-tone exposure by using a first half-tone mask;
patterning the thin film for a gate electrode/gate wire, the gate insulating film and the first oxide layer with an etching method to form the gate electrode and the gate wire;
reforming the first resist into a predetermined shape;
patterning the first oxide layer with an etching method to form a channel part;
stacking an interlayer insulating film and a second resist;
forming the second resist into a predetermined shape by using a second mask;
patterning the interlayer insulating film with an etching method to form openings at positions where a source electrode and a drain electrode are formed and patterning the interlayer insulating film and the gate insulting film with an etching method to form an opening for a gate wire pad at a position where a gate wire pad is formed;
stacking a second oxide layer, a reflective metal layer and a third resist;
forming the third resist into a predetermined shape by half-tone exposure by using a third half-tone mask;
patterning the second oxide layer and the reflective metal layer with an etching method to form the source electrode, the drain electrode, a source wire, a drain wire, a pixel electrode and the gate wire pad;
reforming the third resist into a predetermined shape; and
patterning the reflective metal layer with an etching method to expose a source/drain wire pad, part of the pixel electrode and the gate wire pad and form a reflective metal part composed of the reflective metal layer.

30. A method for producing a TFT substrate comprising the steps of:
stacking a thin film for a gate electrode/gate wire from which a gate electrode and a gate wire are formed, a gate insulating film, a first oxide layer and a first resist above a substrate;
forming the first resist into a predetermined shape by half-tone exposure by using a first half-tone mask;
patterning the thin film for a gate electrode/gate wire, the gate insulating film and the first oxide layer with an etching method to form the gate electrode and the gate wire;
reforming the first resist into a predetermined shape;
patterning the first oxide layer with an etching method to form a channel part;
stacking an interlayer insulating film and a second resist;
forming the second resist into a predetermined shape by using a second mask;
patterning the interlayer insulating film with an etching method to form openings at positions where a source electrode and a drain electrode are formed and patterning the interlayer insulating film and the gate insulting film with an etching method to form an opening for a gate wire pad at a position where a gate wire pad is formed;
stacking a second oxide layer, a reflective metal layer, a protective insulating film and a third resist;
forming the third resist into a predetermined shape by half-tone exposure by using a third half-tone mask;
patterning the second oxide layer, the reflective metal layer and the protective insulating layer with an etching method to form the source electrode, the drain electrode, a source wire, a drain wire, a pixel electrode and the gate wire pad;
reforming the third resist into a predetermined shape; and
patterning the reflective metal layer and the protective insulating film with an etching method to expose a source/drain wire pad, part of the pixel electrode and the gate wire pad and form a reflective metal part composed of the reflective metal layer.

31. A method for producing a TFT substrate comprising the steps of:
stacking a thin film for a gate electrode/gate wire from which a gate electrode and a gate wire are formed, a gate insulating film, a first oxide layer and a first resist above a substrate;
forming the first resist into a predetermined shape by half-tone exposure by using a first half-tone mask;
patterning the thin film for a gate electrode/gate wire, the gate insulating film and the first oxide layer with an etching method to form the gate electrode and the gate wire;
reforming the first resist into a predetermined shape;
patterning the first oxide layer with an etching method to form a channel part;
stacking an interlayer insulating film and a second resist;
forming the second resist into a predetermined shape by using a second mask;
patterning the interlayer insulating film with an etching method to form openings at positions where a source electrode and a drain electrode are formed and patterning the interlayer insulating film and the gate insulting film with an etching method to form an opening for a gate wire pad at a position where a gate wire pad is formed;
stacking a second oxide layer, a reflective metal layer and a third resist;
forming the third resist into a predetermined shape by half-tone exposure by using a third half-tone mask;
patterning the second oxide layer and the reflective metal layer with an etching method to form the source electrode, the drain electrode, a source wire, a drain wire, a pixel electrode and the gate wire pad;
reforming the third resist into a predetermined shape;
patterning the reflective metal layer with an etching method to expose a source/drain wire pad, part of the pixel electrode and the gate wire pad and form a reflective metal part composed of the reflective metal layer;
stacking a protective insulating film and a fourth resist;
reforming the fourth resist into a predetermined shape; and
patterning the protective insulating film with an etching method to expose the source/drain wire pad, part of the pixel electrode and the gate wire pad.

32. The method for producing a TFT substrate according to any one of claims 29 to 31, wherein a metal layer-protecting oxide conductor layer for protecting the reflective metal layer is formed above the reflective metal layer.

33. The method for producing a TFT substrate according to any one of claims 24 to 32, wherein a thin film for a gate electrode/gate wire-protecting conductive layer for protecting the thin film for a gate electrode/gate wire is formed above the thin film for a gate electrode/gate wire.

34. A method for producing a TFT substrate comprising the steps of:
stacking a thin film for a gate electrode/gate wire from which a gate electrode and a gate wire are formed, a gate insulating film, an oxide layer and a first resist above a substrate;
forming the first resist into a predetermined shape by half-tone exposure by using a first half-tone mask;
patterning the thin film for a gate electrode/gate wire, the gate insulating film and the oxide layer with an etching method to form the gate electrode and the gate wire;
reforming the first resist into a predetermined shape;
patterning the oxide layer with an etching method to form a channel part;
stacking an interlayer insulating film and a second resist;
forming the second resist into a predetermined shape by using a second mask;
patterning the interlayer insulating film with an etching method to form an opening for a source electrode and an opening for a drain electrode at positions where a source electrode and a drain electrode are formed and patterning the interlayer insulating film and the gate insulting film with an etching method to form an opening for a gate wire pad at a position where a gate wire pad is formed;
stacking a conductor layer and a third resist;
forming the third resist into a predetermined shape by using a third mask; and
patterning the conductor layer with an etching method to form the source electrode, the drain electrode, a source wire, a drain wire, a pixel electrode and the gate wire pad.

35. A method for producing a TFT substrate comprising the steps of:
stacking a thin film for a gate electrode/gate wire from which a gate electrode and a gate wire are formed, a gate insulating film, an oxide layer and a first resist above a substrate;
forming the first resist into a predetermined shape by half-tone exposure by using a first half-tone mask;
patterning the thin film for a gate electrode/gate wire, the gate insulating film and the oxide layer with an etching method to form the gate electrode and the gate wire;
reforming the first resist into a predetermined shape;
patterning the oxide layer with an etching method to form a channel part;
stacking an interlayer insulating film and a second resist;
forming the second resist into a predetermined shape by using a second mask;
patterning the interlayer insulating film with an etching method to form an opening for a source electrode and an opening for a drain electrode at positions where a source electrode and a drain electrode are formed and patterning the interlayer insulating film and the gate insulting film with an etching method to form an opening for a gate wire pad at a position where a gate wire pad is formed;
stacking a conductor layer and a third resist;
forming the third resist into a predetermined shape by using a third mask;
patterning the conductor layer with an etching method to form the source electrode, the drain electrode, a source wire, a drain wire, a pixel electrode and the gate wire pad;
stacking a protective insulating film and a fourth resist;
forming the fourth resist into a predetermined shape; and
patterning the protective insulating film with an etching method to expose a source/drain wire pad, the pixel electrode and the gate wire pad.

36. A method for producing a reflective TFT substrate comprising the steps of:
stacking a thin film for a gate electrode/gate wire from which a gate electrode and a gate wire are formed, a gate insulating film, an oxide layer and a first resist above a substrate;
forming the first resist into a predetermined shape by half-tone exposure by using a first half-tone mask;
patterning the thin film for a gate electrode/gate wire, the gate insulating film and the oxide layer with an etching method to form the gate electrode and the gate wire;
reforming the first resist into a predetermined shape;
patterning the oxide layer with an etching method to form a channel part;
stacking an interlayer insulating film and a second resist;
forming the second resist into a predetermined shape by using a second mask;
patterning the interlayer insulating film with an etching method to form an opening for a source electrode and an opening for a drain electrode at positions where a source electrode and a drain electrode are formed and patterning the interlayer insulating film and the gate insulting film with an etching method to form an opening for a gate wire pad at a position where a gate wire pad is formed;
stacking a reflective metal layer and a third resist;
forming the third resist into a predetermined shape by using a third mask;
patterning the reflective metal layer with an etching method to form the source electrode, the drain electrode, a source wire, a drain wire, a pixel electrode and the gate wire pad.

37. A method for producing a reflective TFT substrate comprising the steps of:
stacking a thin film for a gate electrode/gate wire from which a gate electrode and a gate wire are formed, a gate insulating film, an oxide layer and a first resist above a substrate;
forming the first resist into a predetermined shape by half-tone exposure by using a first half-tone mask;
patterning the thin film for a gate electrode/gate wire, the gate insulating film and the oxide layer with an etching method to form the gate electrode and the gate wire;
reforming the first resist into a predetermined shape;
patterning the oxide layer with an etching method to form a channel part;
stacking an interlayer insulating film and a second resist;
forming the second resist into a predetermined shape by using a second mask;
patterning the interlayer insulating film with an etching method to form an opening for a source electrode and an opening for a drain electrode at positions where a source electrode and a drain electrode are formed and patterning the interlayer insulating film and the gate insulting film with an etching method to form an opening for a gate wire pad at a position where a gate wire pad is formed;
stacking a reflective metal layer, a protective insulating layer and a third resist;
forming the third resist into a predetermined shape by half-tone exposure by using a third half-tone mask;
patterning the reflective metal layer and the protective insulating film with an etching method to form the source electrode, the drain electrode, a source wire, a drain wire, a pixel electrode and the gate wire pad;
reforming the third resist into a predetermined shape; and
patterning the protective insulating film with an etching method to expose a source/drain wire pad, the pixel electrode and the gate wire pad.

38. A method for producing a reflective TFT substrate comprising the steps of:
stacking a thin film for a gate electrode/gate wire from which a gate electrode and a gate wire are formed, a gate insulating film, an oxide layer and a first resist above a substrate;
forming the first resist into a predetermined shape by half-tone exposure by using a first half-tone mask;
patterning the thin film for a gate electrode/gate wire, the gate insulating film and the oxide layer with an etching method to form the gate electrode and the gate wire;
reforming the first resist into a predetermined shape;
patterning the oxide layer with an etching method to form a channel part;
stacking an interlayer insulating film and a second resist;
forming the second resist into a predetermined shape by using a second mask;
patterning the interlayer insulating film with an etching method to form an opening for a source electrode and an opening for a drain electrode at positions where a source electrode and a drain electrode are formed and patterning the interlayer insulating film and the gate insulting film with an etching method to form an opening for a gate wire pad at a position where a gate wire pad is formed;
stacking a reflective metal layer and a third resist;
forming the third resist into a predetermined shape by using a third mask;
patterning the reflective metal layer with an etching method to form the source electrode, the drain electrode, a source wire, a drain wire, a pixel electrode and the gate wire pad;
stacking the protective insulting film and a fourth resist;
forming the fourth resist into a predetermined shape; and
patterning the protective insulating film with an etching method to expose a source/drain wire pad, the pixel electrode and the gate wire pad.

39. The method for producing a reflective TFT substrate according to any one of claims 36 to 38, wherein an oxide conductor layer is stacked between the oxide layer and the reflective metal layer.

40. The method for producing a reflective TFT substrate according to any one of claims 36 to 39, wherein a metal layer-protecting oxide transparent conductor layer is stacked above the reflective metal layer.

41. The method for producing a reflective TFT substrate according to any one of claims 36 to 40, wherein the thin film for a gate electrode/gate wire comprises a metal layer and a metal layer-protecting oxide transparent conductor layer is stacked above the metal layer.
